Europäisches Patentamt

European Patent Office

Office européen des brevets

(11) Veröffentlichungsnummer: **0 591 562 A1**

## (12) EUROPÄISCHE PATENTANMELDUNG

(21) Anmeldenummer: **92116755.7**

(22) Anmeldetag: **30.09.92**

(51) Int. Cl.5: **G06F 11/26**

(43) Veröffentlichungstag der Anmeldung:
**13.04.94 Patentblatt 94/15**

(84) Benannte Vertragsstaaten:
**DE FR GB**

(71) Anmelder: **INTERNATIONAL BUSINESS MACHINES CORPORATION**
**Old Orchard Road**
**Armonk, N.Y. 10504(US)**

(72) Erfinder: **Staiger, Dieter Ernst**
**Falkenstrasse 28**
**W-7039 Weil im Schönbuch(DE)**

(74) Vertreter: **Mönig, Anton, Dipl.-Ing.**
**IBM Deutschland Informationssysteme GmbH,**
**Patentwesen und Urheberrecht**
**D-70548 Stuttgart (DE)**

(54) **Programmgesteuerte Optimierung einer prozessorgesteuerten Schaltung zur Generierung einer algorithmisch erzeugbaren Ausgangs-Sequenz von Werten.**

(57) Computerprogrammgesteuerte(s) Verfahren/Anordnung zur automatischen Konfigurierung einer prozessorengesteuerten Schaltung zur Erzeugung einer Ausgangs-Sequenz von Werten. Diese Ausgangs-Sequenz kann vorzugsweise eine Adreßfolge darstellen, wie sie für die Adressierung auszutestender Speicherprodukte oder auszutestender logischer Schaltungen erforderlich ist. Diesem Verfahren liegt zugrunde, daß eine algorithmisch erzeugbare Ausgangs-Sequenz von Werten C1; C2; C3; C4; in gedachte p Teilfolgen (S1; S2; S3; ...) mit jeweils zugeordneten Algorithmen zerlegt wird.

Der Algorithmus A1; A2; A3; A4; etc. der Ausgangs-Sequenz weist eine Periode von P Werten auf. Die Teilfolgen (z. B. S1) sind aus ihrem Anfangswert und ihrem Algorithmus $as_{11}$; $as_{12}$; $as_{13}$; etc. erzeugbar. Alle Teilfolgen sind nach Multiplexart zur Ausgangs-Sequenz zusammenführbar.

Im Optimierungsfall bestehen alle Werte der Teilfolgen-Algorithmen aus einer einzigen Konstanten (oder einem einzigen mathematische beschreibbaren Term), was bei einer Schaltungs-Implementierung zu größten Vereinfachungen führt: Zur Erzeugung jeder Teilfolge ist wie üblich jeweils ein Prozessor jedoch nur ein einziger Programmspeicher für die Konstante (oder den mathematisch beschreibbaren Term) erforderlich. Jeder Prozessor erzeugt aus dieser Konstanten und dem Anfangswert der im zugeordneten Teilfolge diese Teilfolge; alle Teilfolgen werden über einen Multiplexer zur gewünschten Ausgangs-Sequenz zusammengeführt.

Bei der Bildung von weniger als p Teilfolgen erfordert das Verfahren weniger Prozessoren, dafür aber einen einzigen Programmspeicher (93) zur Vorgabe der Werte der Teilfolgen-Algorithmen-Periode, sofern diese Periode in allen Teilfolgen-Algorithmen die gleiche ist. Dieser Programmspeicher ist für positive oder negative Konstanten vorzugsweise eine Registerschaltung, die auch gegenseitige Verschiebungen der Periode in den Teilfolgen-Algorithmen berücksichtigt.

Das Verfahren ermöglicht u. a. das Austesten künftiger schneller Speicherprodukte etc. bzw. eine Aufwandvereinfachung bestehender Testsysteme.

Für eine Geschwindigkeitssteigerung der Ausgangs-Sequenz ist eine besondere Ausgestaltung der Prozessoren vorgesehen. Sie dient bei aufeinanderfolgenden arithmetischen Operationen der Eliminierung der bei Übertragsbildungen auftretenden Zeitverzögerungen.

AUSGANGS—
SEQUENZ

ALGORITHMUS

7   8   12   10   11   15   13   14   18

+1   ++   2   +1   +4   2   +1   +4   usw.

AUSGANGS—SEQUENZ

C1 C2 C3 C4 C5 C6 C7 C8 C9 ...
7   8   12  10  11  15  13  14  18

ALGORITHMUS

A1 A2 A3 A4 A5 A6 A7 ...
+1 +4 −2 +1 +4 −2 +1

PERIODIZITÄT (P) = 3

TEILFOLGEN

$S1 = s_{11}$   $s_{12}$   $s_{13}$...
         7        10       13

$S2 = s_{21}$   $s_{22}$   $s_{23}$...
         8        11       14

$S3 = s_{31}$   $s_{32}$   $s_{33}$...
         12       15       18

TEILFOLGEN-ALGORITHMEN

$as_{11}$   $as_{12}$   $as_{13}$...
   3           3           3

$as_{21}$   $as_{22}$   $as_{23}$...
   3           3           3

$as_{31}$   $as_{32}$   $as_{33}$...
   3           3           3

ZEITGEBER—SCHALTUNG                94

ANFANGS—
WERTE DER
UNTERFOLGEN

PROGRAMM—
SPEICHER
(+3)          93

$s_{11}=7$

90

PROZESSOR 1      S1
                 7;10;13;...

$s_{21}=8$        91

PROZESSOR 2      S2
                 8;11;14;...

$s_{31}=12$       92

PROZESSOR 3      S3
                 12;15;18;...

MULTI-
PLEXER         95

AUSGANGSSEQUENZ
7;8;12;10;11;...

FIG. 11

2

Die Erfindung betrifft ein computerprogrammgesteuertes Verfahren und eine computerprogrammgesteuerte Anordnung zur automatischen Optimierung einer prozessorgesteuerten Schaltung zur Generierung einer algorithmisch erzeugbaren Ausgangs-Sequenz von Werten.

Die Erfindung betrifft weiterhin mit Überträgen arbeitende Schaltungseinheiten.

Speicherprodukte und logische Schaltungen unterliegen einer ständigen Weiterentwicklung. Besonders offensichtlich ist der Trend zu immer höheren Speicherkapazitäten und schnelleren Taktzeiten für Speicher-Lese- und Schreiboperationen. (In diesem Zusammenhang wird von immer schnelleren Chips gesprochen.) Die Herstellung solcher Chips ist äußerst aufwendig und diffizil. Geringste Verunreinigungen und andere Einflüsse im Herstellungsprozeß können bedingen, daß der Chip später fehlerhaft ist oder gar nicht arbeitet.

Aus diesem Grunde werden die Chips nach ihrer Herstellung getestet, bevor sie ihrer eigentlichen Verwendung zugeführt werden. Solche Tests sehen vor, daß die einzelnen Speicherzellen des Chips in einer bestimmten Reihenfolge (nach entsprechenden Test-Adreß-Mustern) für Schreib- und Leseoperationen adressiert werden. Bei einer einwandfreien, fehlerfreien Arbeitsweise der Speicherzellen führt der Test zu den erwarteten Ergebnissen - weichen jedoch die Testergebnisse hiervon ab, so ist dies ein Hinweis auf das Vorliegen von Fehlern. Solche Fehler können natürlich analysiert werden, um Hinweise auf die Ursache der Fehler zu erlangen.

Zum Testen werden aufeinanderfolgende Impulsintervalle (mitunter unterschiedlicher Zeitdauer) vorgesehen, in denen Testpulse plaziert sind, mit denen die Speicher-Chip-Zellen beaufschlagt werden.

Welche Zellen in welcher Reihenfolge zu beaufschlagen sind, wird durch die bereits erwähnten Test-Adreß-Muster (Adreßfolgen, allgemein auch Ausgangs-Sequenzen genannt) vorgegeben. Bei schnellen Speicherprodukten sind die einzelnen Speicherzellen in schnellster (kürzester) Folge zu adressieren. Dies erfordert Testsysteme, die in der Lage sind, die Werte in den Adreßfolgen in kürzester Zeit aufeinander folgen zu lassen. Diesem Schnelligkeitserfordernis sind natürliche Grenzen gesetzt, die durch die Schaltungen selbst und die Schaltkreistechnologie bestimmt sind.

Die heute schnellste Schaltkreistechnologie bei integrierten Schaltungen basiert auf der Gallium-Arsenid-Technologie, die eine äußerst schnelle Ladungsträgerbewegung ermöglicht. Zusätzlich kann durch besondere schaltungstechnische Maßnahmen erreicht werden, daß "schnelle" Adreßfolgen überhaupt erzeugt werden können, was ohne solche Maßnahmen auch bei Verwendung schnellster Technologien nicht möglich wäre.

Eine solche schaltungstechnische Maßnahme ist z. B. durch den Begriff des "Interleaves" gekennzeichnet - ein aus dem englischen Sprachgebrauch stammender Terminus, der folgendes bedeutet: Anstelle der nicht zu realisierenden Erzeugung einer schnellen Ausgangs-Sequenz von (Adreß)-Werten:

C1 C2 C3 C4 C5 etc.

werden (nicht so "schnelle") Teilfolgen

C1　　C3　　C5 etc.

und

C2　　C4　　C6　　etc.

erzeugt, die dann in bekannter Art und Weise über einen Multiplexer zur geforderten Ausgangs-Sequenz zusammengeführt werden können:

C1; C2; C3; C4; C5; etc.

In diesem Zusammenhang sei bemerkt, daß der zeitliche Abstand der Werte in den Teilfolgen ein größerer als bei den Werten in der schnellen Ausgangs-Sequenz ist und daß Multiplexer eine "Schalt-Schnelligkeit" erbringen können, die andere Schaltungseinheiten, wie Prozessoren, nicht aufweisen.

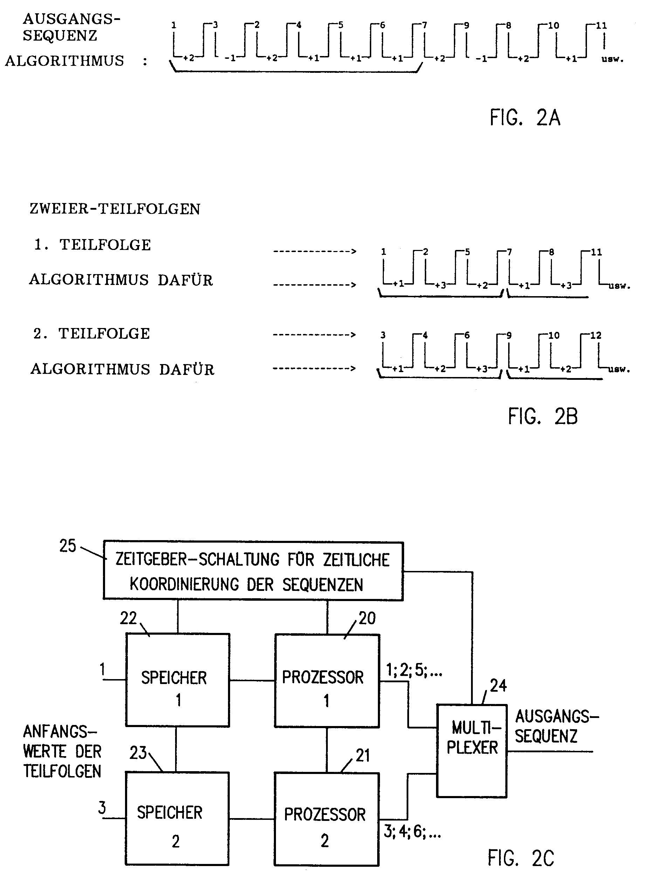

Die Interleave-Methode ist bei nach dem Stand der Technik bekannten Systemen (firmeninterner Stand der Technik) zur Erzeugung von Adreßfolgen (wie in Zusammenhang mit Fig. 2C noch erläutert wird) angewendet worden. Die schaltungstechnische Realisierung weist jedoch eine Reihe von Nachteilen auf. Notwendigerweise weist die Schaltung zwar so viele Prozessoren auf, wie Teilfolgen zu erzeugen sind, dennoch erfordert jeder Prozessor einen eigenen Programmspeicher, in welchem die (mehrere Werte) umfassende Teilfolgen-Algorithmus-Periode zur Erzeugung der Teilfolge aus ihrem Anfangswert gespeichert ist.

Auf die Zusammenhänge zwischen der Ausgangs-Sequenz und ihrem Algorithmus, auf die Zusammenhänge zwischen Teilfolgen und den Teilfolgen-Algorithmen und auf die Algorithmus-Perioden wird an späterer Stelle detailliert eingegangen.

Untersuchungen der Teilfolgen haben zu den Grundlagen des erfindungsgemäßen Verfahrens geführt:

Werden Ausgangs-Sequenzen, die eine Periodizität ihres Algorithmus aufweisen in

a) eine Anzahl P von Teilfolgen aufgeteilt, die der Anzahl der Werte in der Periode des Algorithmus der Ausgangs-Sequenz entspricht, so sind die Werte aller Algorithmen der Teilfolgen identisch und bilden in bestimmten Fällen eine Konstante, in anderen Fällen einen mathematisch beschreibbaren Term,

b) Teilfolgen aufgesplittet, deren Anzahl < P ist, so ergibt sich mindestens für einen Teilfolgensatz mit einer bestimmten Anzahl von Teilfolgen, daß deren Algorithmen jeweils die gleiche mehrere Werte umfassende Periode aufweisen.

Die Zusammenhänge einer Folge/Sequenz und deren Algorithmus ergeben sich wie folgt:

```
Folge/Sequenz      C1; C2; C3; C4; C5; ...
Algorithmus           A1; A2; A3; A4; A5; ...


                   C2 = C1 + A1
                   C3 = C2 + A2
                   C4 = C3 + A3
                          .
                          .
```

sofern es sich bei A1, A2, etc. um Summanden oder Subtrahenden handelt oder

```
         C2 = C1 in Verknüpfung mit A1
         C3 = C2 in Verknüpfung mit A2
         C4 = C3 in Verknüpfung mit A3
                     .
                     .
```

sofern es sich bei A1, A2, etc. um mathematische Verknüpfungen anderer Art (•, :, ln, etc.) handelt.

Auf diese Weise können die Werte einer Folge durch Addition des vorhergehenden Wertes zu dem zugehörigen Algorithmus-Wert gebildet werden.

Die unter a) und b) gemachten Feststellungen, die später noch in einer Vielzahl von Beispielen erläutert werden, führen zu überraschenden Schaltungsvereinfachungen im Vergleich zum Stande der Technik.

In diesen Schaltungen wird (wie auch nach dem Stand der Technik) jede Teil folge von einem Prozessor generiert; und anschließend werden alle Teilfolgen von einem Multiplexer zur gewünschten Ausgangs-Sequenz zusammengeführt.

Für den Fall a) erfordern alle Prozessoren nur einen einzigen, einfachen gemeinsamen Programmspeicher, der z. B. nur eine Konstante K (oder einen mathematisch beschreibbaren Term) bereitzustellen hat. (Zur der Erzeugung der Teilfolgen müssen deren Anfangswerte zur Verfügung gestellt werden.)

Für den Fall b) ist ebenfalls für alle Prozessoren ein einziger gemeinsamer Programmspeicher für die verschiedenen Werte der Teilfolgen-Algorithmen-Periode erforderlich. Ein solcher Speicher kann, wie in einem Ausführungsbeispiel später noch ausführlicher beschrieben, aus hintereinandergeschalteten Registern bestehen, in denen die gespeicherten Werte zyklisch umlaufen. Die die Teilfolgen erzeugenden Prozessoren sind derart mit den Registern verbunden, daß selbst eine gegenseitige Verschiebung der Teilfolgen-Algorithmen-Periode in den einzelnen Teilfolgen-Algorithmen berücksichtigt wird.

Der Kern der Erfindung liegt darin, daß aus einer algorithmisch bildbaren Ausgangs-Sequenz programmtechnisch

1) im Fall a)

die Algorithmus-Periode der Ausgangs-Sequenz, die Teilfolgen-Anfangswerte und die Teilfolgen-Algorithmus-Konstante bzw. ein mathematisch beschreibbarer Term bestimmt werden und daß aus diesen Werten programmgesteuert eine prozessorengesteuerte Schaltung konfiguriert wird. Sie dient der Erzeugung der Teilfolgen mit nachfolgender Zusammenfassung dieser Teilfolgen zur gewünschten Ausgangs-Sequenz,

2) im Fall b)

die Anfangswerte jener Teilfolgen mit einem gemeinsamen Teilfolgen-Algorithmus ermittelt werden und daß aus diesen Anfangswerten und den Werten des Teilfolgen-Algorithmus programmgesteuert eine prozessorgesteuerte Schaltung zur Erzeugung der Ausgangs-Sequenz konfiguriert wird. Hierbei spielt in bestimmten Fällen auch die Konfigurierung eines als Register-Schaltung ausgebildeten Programmspeichers für die Teilfolgen-Algorithmus-Periode eine besondere Rolle.

Mit anderen Worten, die Erfindung ermöglicht es letztlich, daß unter programmgesteuerter Vorgabe einer algorithmisch bildbaren Ausgangs-Sequenz, Parameter zur programmgesteuerten Konfiguration einer zu optimierenden Schaltung zur Erzeugung der Ausgangs-Sequenz bestimmt werden.

Ein entsprechend prozessorgesteuerter Chip könnte also ohne weiteres Zutun jede nur gewünschte Ausgangs-Sequenz liefern.

Solche Ausgangs-Sequenzen haben z. B. folgende Anwendungsbereiche:

für das Austesten von Speicherprodukten oder logischen Schaltungen sind Ausgangs-Sequenzen als Adreßfolgen (Adreßmuster) erforderlich, die der Adressierung der zu testenden Produkte dienen,

für Signalgeneratoren in der Meß- und Prüftechnik,

für das automatische Konfigurieren von Multi-Prozessor-Computersystemen im Rahmen einer geschwindigkeitoptimierten Reihenentwicklung und im Rahmen periodisch/algorithmischer Prozesse,

für neue Vektor-Rahmen Architekturen.

Aus diesem Grunde ist es Aufgabe der Erfindung, ein Verfahren und eine Anordnung vorzusehen für eine programmgesteuerte Optimierung (optimierende Konfiguration) einer prozessorgesteuerten Schaltung zur Generierung einer algorithmisch erzeugbaren Ausgangs-Sequenz von Werten.

Dieses Verfahren und diese Anordnung soll höchsten Geschwindigkeitsanforderungen genügen, einen geringen schaltungstechnischen Aufwand erfordern und automatisch durchführbar sein im Sinne einer programmtechnisch realisierbaren Konfiguration einer zur Verfügung stehenden noch nicht spezifizierten Schaltung.

Diese Aufgaben der Erfindung werden in vorteilhafter Weise durch die in den Hauptansprüchen 1, 3, 6, 9 und 10 angegebenen Merkmale gelöst. Vorteilhafte Weiterbildungen der Erfindung sind den Unteransprüchen zu entnehmen.

Es ist weiterhin Aufgabe der Erfindung, insbesondere für die Durchführung der vorstehenden Aufgabe, zur Geschwindigkeitssteigerung dienende, schaltungstechnische Verbesserungen in Schaltungseinheiten vorzunehmen, welche mit Überträgen arbeiten.

Diese Aufgabe der Erfindung wird in vorteilhafter Weise durch die in den Hauptansprüchen 12 und 13 angegebenen Merkmale gelöst. Sie beziehen sich auf schaltungstechnische Verbesserungen in aritmetisch-logischen Einheiten und in Zählern.

Ausführungsbeispiele der Erfindung sind in den Zeichnungen dargestellt und werden im folgenden näher beschrieben.

Es zeigen:

Fig. 1A    eine graphische Darstellung eines Beispiels einer einfachen Ausgangs-Sequenz in Verbindung mit einem periodisch wirkenden Algorithmus;

Fig. 1B    eine vereinfachte Darstellung gemäß Fig. 1A;

Fig. 1C    eine Darstellung von sechs Teilfolgen in Zuordnung zu sechs Prozessoren für eine bestimmte Periodizität 6 des Algorithmus' der Ausgangs-Sequenz gemäß Fig. 1A;

Fig. 1D    ein vereinfachtes Blockschaltbild von sechs Prozessoren zur Erzeugung der sechs Teilfolgen gemäß Fig. 1C mit einem einzigen Programmspeicher;

Fig. 2A    eine graphische Darstellung der Ausgangs-Sequenz gemäß Fig. 1A in Verbindung mit dem periodisch wirkenden Algorithmus;

Fig. 2B    eine graphische Darstellung von aus der Ausgangs-Sequenz gemäß Fig. 2A abgeleiteten Zweier-Teilfolgen in Verbindung mit den Algorithmen für diese Teilfolgen;

Fig. 2C    ein vereinfachtes Blockschaltbild einer Schaltung nach dem Stand der Technik zur Erzeugung zweier Teilfolgen mit zwei Prozessoren mit jeweils einem Programmspeicher für den Algorithmus einer Teilfolge;

Fig. 3A    eine graphische Darstellung eines Beispiels I für eine Testadreßfolge;

Fig. 3B    eine Testadreßfolge gemäß Fig. 3A in sequentieller Darstellung in Verbindung mit einem periodisch wirkenden Algorithmus;

Fig. 3C    eine Darstellung von Zweier-Teilfolgen und den zugehörigen Algorithmen für die Testadreßfolge gemäß Figur 3B;

Fig. 3D    eine Darstellung von Dreier-Teilfolgen und den zugehörigen Algorithmen für die Testadreßfolge gemäß Figur 3B;

Fig. 3E    eine Darstellung von Vierer-Teilfolgen und den zugehörigen Algorithmen für die Testadreßfolge gemäß Figur 3B;

Fig. 3F    eine Darstellung von Fünfer-Teilfolgen und den zugehörigen Algorithmen für die Testadreßfolge gemäß Figur 3B;

Fig. 3G    eine Darstellung von Sechser-Teilfolgen und den zugehörigen Algorithmen für die Testadreßfolge gemäß Figur 3B;

Fig. 3H    eine Darstellung von Siebener-Teilfolgen und den zugehörigen Algorithmen für die Testadreßfolge gemäß Figur 3B;

Fig. 3I    eine Darstellung von Achter-Teilfolgen und den zugehörigen Algorithmen für die Testadreßfolge gemäß Figur 3B;

Fig. 3J    eine Darstellung von Neuner-Teilfolgen und den zugehörigen Algorithmen für die Testadreßfolge gemäß Figur 3B;

Fig. 3K    eine Darstellung von Zehner-Teilfolgen und den zugehörigen Algorithmen für die Testadreßfolge gemäß Figur 3B;

Fig. 4A    eine graphische Darstellung eines Beispiels II einer Testadreßfolge;

Fig. 4B    eine Testadreßfolge gemäß Fig. 4A in sequentieller Darstellung in Verbindung mit einem periodisch wirkenden Algorithmus;

Fig. 4C    eine Darstellung von Zweier-Teilfolgen und den zugehörigen Algorithmen für die Testadreßfolge gemäß Figur 4B;

Fig. 4D    eine Darstellung von Dreier-Teilfolgen und den zugehörigen Algorithmen für die Testadreßfolge gemäß Figur 4B;

Fig. 4E    eine Darstellung von Vierer-Teilfolgen und den zugehörigen Algorithmen für die Testadreßfolge gemäß Figur 4B;

Fig. 4F    eine Darstellung von Fünfer-Teilfolgen und den zugehörigen Algorithmen für die Testadreßfolge gemäß Figur 4B;

Fig. 4G    eine Darstellung von Sechser-Teilfolgen und den zugehörigen Algorithmen für die Testadreßfolge gemäß Figur 4B;

Fig. 4H    eine Darstellung von Siebener-Teilfolgen und den zugehörigen Algorithmen für die Testadreßfolge gemäß Figur 4B;

Fig. 4I    eine Darstellung von Achter-Teilfolgen und den zugehörigen Algorithmen für die Testadreßfolge gemäß Figur 4B;

Fig. 4J    eine Darstellung von Neuner-Teilfolgen und den zugehörigen Algorithmen für die Testadreßfolge gemäß Figur 4B;

Fig. 4K    eine Darstellung von Zehner-Teilfolgen und den zugehörigen Algorithmen für die Testadreßfolge gemäß Figur 4B;

Fig. 5A    eine Darstellung der Ausgangs-Sequenz gemäß Fig. 4B in Verbindung mit einem periodisch wirkenden Algorithmus und eine Darstellung der aus der Ausgangs-Sequenz abgeleiteten Dreier-Teilfolgen (Fig. 4D) mit dazugehörigen Algorithmen;

Fig. 5B    ein Blockschaltbild einer prozessorgesteuerten Schaltung mit mehreren Arithmetik-Logik-Einheiten (ALUs) zur Generierung der Dreier-Teilfolgen gemäß Fig. 5A;

Fig. 5C    eine schematische Darstellung des Programms zur Erzeugung der Dreier-Teilfolgen in der Schaltung gemäß Fig. 5B;

Fig. 6A    eine Darstellung der Ausgangs-Sequenz gemäß Fig. 4B in Verbindung mit einem periodisch wirkenden Algorithmus und eine Darstellung der aus der Ausgangs-Sequenz abgeleiteten Zehner-Teilfolgen (Fig. 4K) mit dazugehörigen Algorithmen;

Fig. 6B    ein Blockschaltbild einer prozessorgesteuerten Schaltung mit mehreren Arithmetik-Logik-Einheiten (ALUs) zur Generierung der Zehner-Teilfolgen gemäß Fig. 6A;

Fig. 6C    eine schematische Darstellung des Programms zur Erzeugung der Zehner-Teilfolgen in der Schaltung gemäß Fig. 6B;

Fig. 7    eine Darstellung einer Ausgangs-Sequenz mit einem periodisch wirkenden Algorithmus, dessen Werte Faktoren oder Divisoren darstellen und eine Aufgliederung der Ausgangs-Sequenz in Dreier-Teilfolgen mit zugehörigen Dreier-Teilfolgen-Algorithmen;

Fig. 8    eine Darstellung einer Ausgangs-Sequenz mit einem periodisch wirkenden Algorithmus, dessen Werte komplexe (unterprogramm-ähnliche) arithmetische Operationen darstellen, und eine Aufgliederung der Ausgangs-Sequenz in Dreier-Teilfolgen mit zugehörigen Dreier-Teilfolgen-Algorithmen;

Fig. 9    eine schematische Darstellung einer auf der üblichen Binärstufenbasis aufgebauten arithmetisch-logischen Einheit (ALU) in Verbindung mit einem Additionsvorgang;

Fig. 10 eine schematische Darstellung einer in Sub-ALUs aufgegliederten ALU mit diesen Sub-ALUs vor- und nachgeschalteten Registern;

Fig. 11 eine vereinfachte Darstellung eines weiteren Ausgangs-Sequenz-Beispiels mit einer Algorithmusperiode von drei Werten in Verbindung mit drei Teilfolgen mit einer Algorithmus-Konstanten K = 3 und eine Darstellung einer drei Prozessoren umfassenden Schaltung zur Erzeugung der drei Teilfolgen und der Ausgangs-Sequenz mit im Anspruch 1 und in der Zusammenfassung gewählten Bezeichnungen.

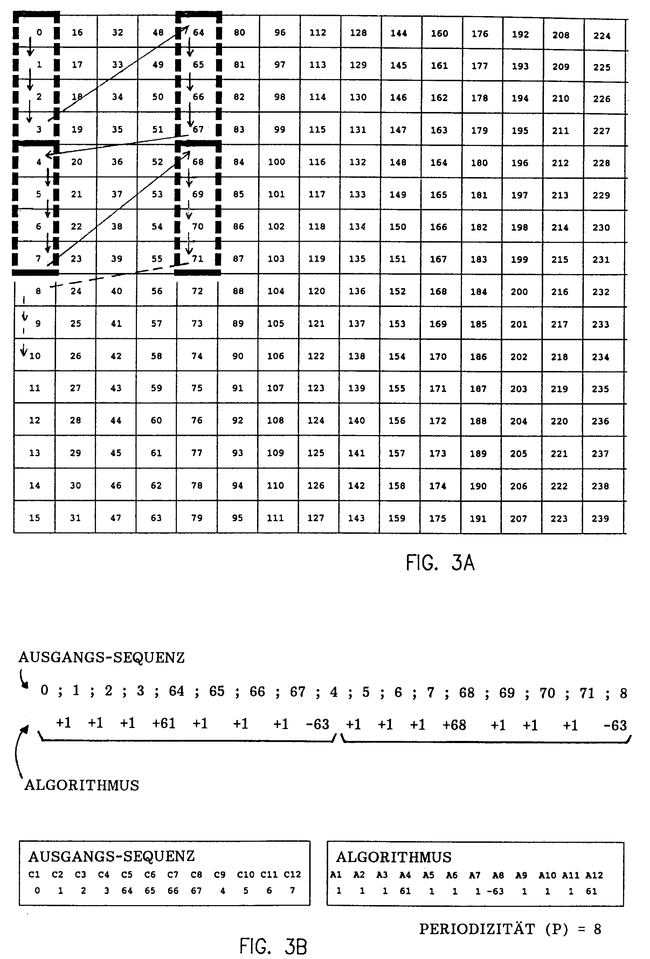

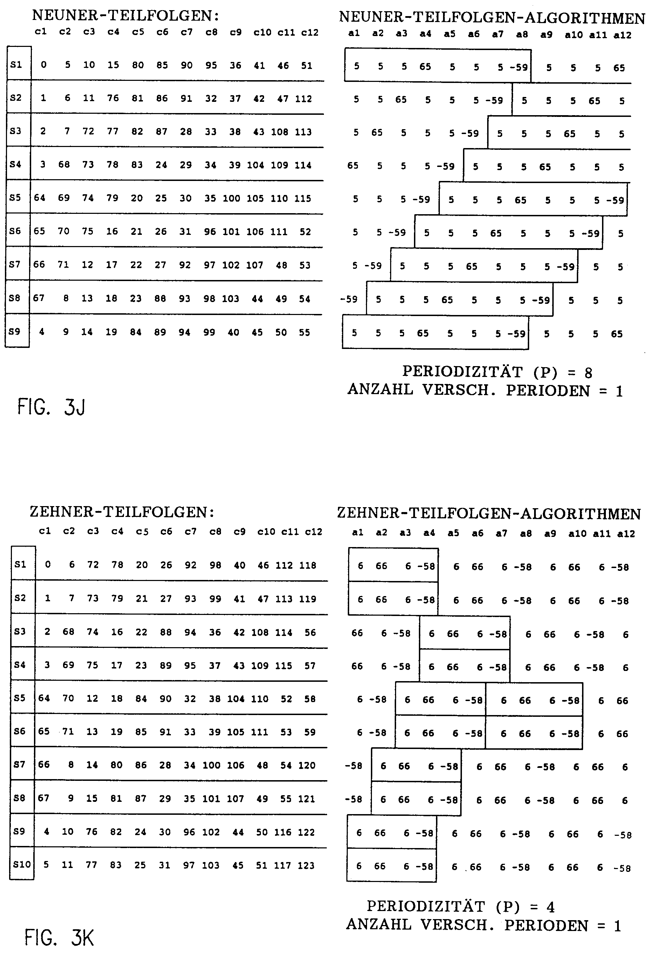

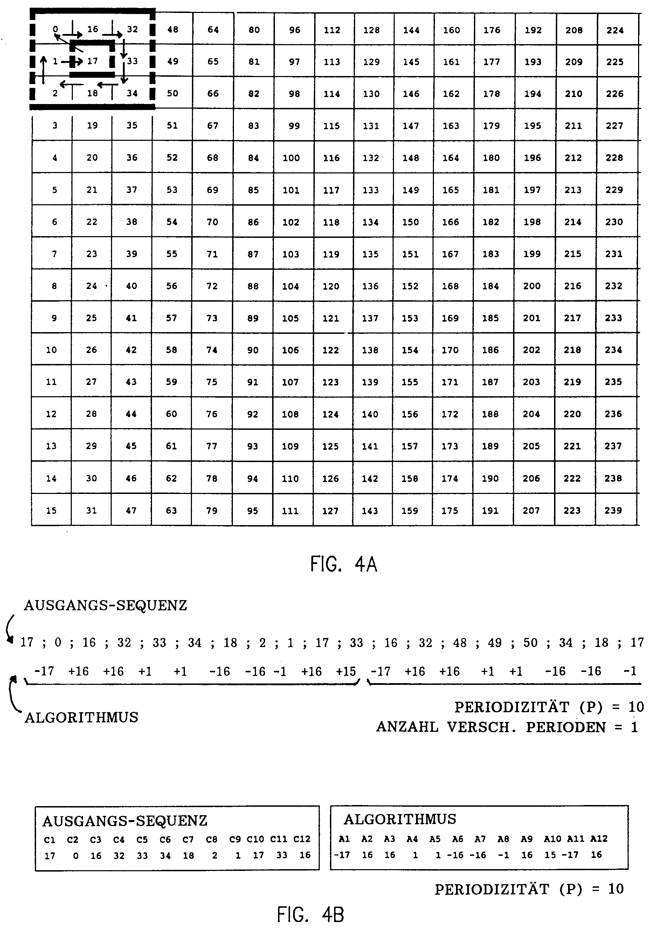

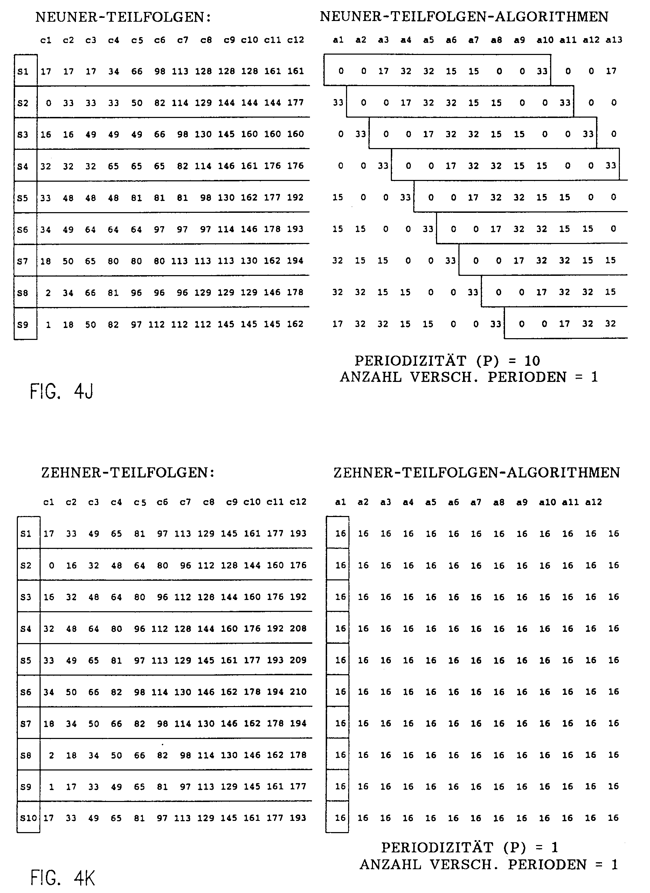

Bei zu testenden Speicherchips werden die Speicherzellen in einer vorgegebenen Adreßfolge adressiert und mit entsprechenden Pulsen beaufschlagt. Die vorgegebene Adreßfolge für das Austesten von Speicherchips basiert auf bestimmten Testmustern, wie manche von ihnen an späterer Stelle, z. B. in Zusammenhang mit Fig. 3A und Fig. 4A, detailliert beschrieben werden. Die Generierung einer solchen Adreßfolge kann mit Hilfe eines Algorithmus erfolgen. Wenn auch verschiedene nachfolgende Beispiele für Testzwecke Anwendung finden, so sei aber ausdrücklich betont, daß die Werte in einer solchen "Adreßfolge" auch andere Angaben als Adressen bedeuten können, für die andere Anwendungen denkbar sind. Allgemein kann deshalb anstelle von Adreßfolgen auch von Ausgangs-Sequenzen gesprochen werden, in denen die Werte Adressen oder andere Angaben darstellen können.

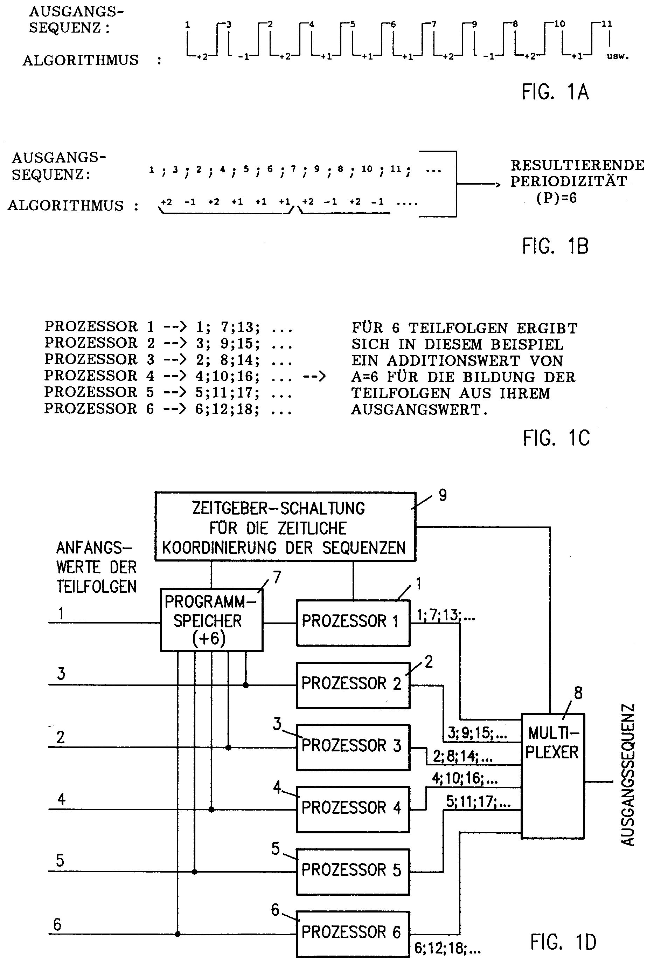

Fig. 1A zeigt eine graphische Darstellung eines Beispiels einer einfachen Ausgangs-Sequenz in Verbindung mit einem periodisch wirkenden Algorithmus. Im oberen Teil der Darstellung sind die aufeinanderfolgenden Werte der Ausgangs-Sequenz angegeben:

1; 3; 2; 4; 5; 6; 7; 9; 8; 10; 11, etc.

Mit Hilfe des Algorithmus

+2; -1; +2; +1; +1; +1; +2; -1; +2; +1; etc.

kann aus einem Wert der Ausgangs-Sequenz der nachfolgende Wert ermittelt werden. Im vorliegenden Beispiel wird der zweite Wert 3 durch Addition von +2 (erster Wert des Algorithmus) zum ersten Wert 1 gebildet. Der dritte Wert 2 der Ausgangs-Sequenz wird durch Addition von -1 (zweiter Wert des Algorithmus) zum vorhergehenden Wert 3 der Ausgangs-Sequenz gebildet.

Auf diese Art und Weise können durch Vorgabe des Algorithmus und des Anfangswerts 1 der Ausgangs-Sequenz die einzelnen Werte der Ausgangs-Sequenz bestimmt werden.

In der Darstellung gemäß Fig. 1A sind die in ihrer Gesamtheit den Algorithmus ausmachenden Additionswerte jeweils auf Lücke unter den entsprechenden Ausgangs-Sequenzwerten angegeben. Die Verknüpfung der Ausgangs-Sequenzwerte mit den algorithmischen Werten ist durch ausgezogene Linien angedeutet: zu einem Ausgangs-Sequenzwert wird der zugehörige algorithmische Wert addiert, wobei das Ergebnis dieser Addition den neuen nachfolgenden Ausgangs-Sequenzwert ergibt.

Fig. 1B zeigt eine vereinfachte Darstellung von Fig. 1A. Die Werte der Ausgangs-Sequenz sind aufeinanderfolgend durch Semikolon getrennt wiedergegeben; darunter ist der Algorithmus angegeben, dessen Werte jeweils auf Lücke zu den darüberstehenden zugehörigen Ausgangs-Sequenzwerten angeordnet sind.

Es fällt auf, daß sich eine bestimmte Folge von Algorithmuswerten, hier

+2; -1; +2; +1; +1; +1

periodisch wiederholt. Es ergibt sich eine mit (P) = 6 bezeichnete Periodizität des Algorithmus, wobei die sechs bedeutet, daß die Periode sechs Werte umfaßt. Diese "Algorithmusperiode" ist mit einer horizontal verlaufenden Klammer markiert.

Fig. 1C zeigt eine Darstellung der aus der Ausgangs-Sequenz (Fig. 1A) abgeleiteten sechs Teilfolgen in Zuordnung zu den Prozessoren 1 bis 6. Die Zahl sechs entspricht der Periodizität (P) = 6 des Algorithmus der Ausgangs-Sequenz.

Die Teilfolgen verstehen sich als Untermengen der Ausgangs-Sequenz, aus denen die Ausgangs-Sequenz wieder zusammengesetzt werden kann. Im englischen Sprachgebrauch wird hierfür der z. T. schon eingedeutschte Begriff des Interleaves verwendet, was nichts anderes als die alternierende Zerlegung der Ausgangs-Sequenz in Teilfolgen (Interleave-Sequenzen) bedeutet. Angenommen, aus der Ausgangs-Sequenz seien sechs Teilfolgen zu bilden, so würde die erste Teilfolge aus dem

1., 7., 13., 19., ...ten Wert

der Ausgangs-Sequenz,

die zweite Teilfolge aus dem

2., 8., 14., 20., ...ten Wert

der Ausgangs-Sequenz usw.

und die sechste Teilfolge aus dem

6., 12., 18., 24., ...ten Wert

der Ausgangs-Sequenz gebildet werden.

Es bedarf keiner besonderen Hinweise, daß aus den sechs Teilfolgen wieder die Ausgangs-Sequenz in der Folge

```
1. Wert der 1. Teilfolge

1. Wert der 2. Teilfolge

1. Wert der 3. Teilfolge

              .

            etc.

              .

1. Wert der 6. Teilfolge

2. Wert der 1. Teilfolge

2. Wert der 2. Teilfolge

2. Wert der 3. Teilfolge

            etc.
```

gebildet werden kann.

Bei einer in Fig. 1B aufgezeigten Periodizität (P) = 6 des Algorithmus der Ausgangs-Sequenz ergibt sich für sechs Teilfolgen (sechsfaches Interleave) die überraschende Feststellung, daß sich die Werte für die Teilfolgen durch aufeinanderfolgende Addition des Wertes A = 6 zu dem Anfangswert der Teilfolgen bilden lassen.

Auf diese Art und Weise soll jeder der Prozessoren 1 bis 6 die im zugeordnete Teilfolge erzeugen:

1 (1.Wert d. 1.Teilfolge) + 6 = 7 (2.Wert d. 1.Teilfolge)

7 (2.Wert d. 1.Teilfolge) + 6 = 13 (3.Wert d. 1.Teilfolge)

etc.

3 (1.Wert d. 2.Teilfolge) + 6 = 9 (2.Wert d. 2.Teilfolge)

9 (2.Wert d. 2.Teilfolge) + 6 = 15 (3.Wert d. 2.Teilfolge)

etc.

So erzeugt

der Prozessor 1 die 1. Teilfolge 1; 7; 13; ...

der Prozessor 2 die 2. Teilfolge 3; 9; 15; ...

der Prozessor 3 die 3. Teilfolge 2; 8; 14; ...

der Prozessor 4 die 4. Teilfolge 4; 10; 16; ...

der Prozessor 5 die 5. Teilfolge 5; 11; 17; ...

der Prozessor 6 die 6. Teilfolge 6; 12; 18; ...

Fig. 1D zeigt ein vereinfachtes Blockschaltbild von sechs Prozessoren 1 - 6 zur Erzeugung der sechs Teilfolgen gemäß Fig. 1C mit einem einzigen Programmspeicher 7.

Die Aufgabe der Prozessoren 1 bis 6, die Erzeugung der ihnen jeweils zugeordneten ersten bis sechsten Teilfolge, wurde vorstehend im Zusammenhang mit Fig. 1C beschrieben.

Jedem Prozessor wird der Anfangswert der ihm zugeordneten Teilfolge zugeführt; dieser Wert erscheint am Ausgang des Prozessors zu Beginn der zu erzeugenden Teilfolge. In einem zweiten Schritt wird zu diesem Wert der im Programmspeicher 7 gespeicherte Wert A = +6 addiert; auf diese Weise wird der jeweils zweite Wert der Teilfolgen gebildet. In dem darauffolgenden Schritt wird zu dem zuvor gebildeten zweiten Wert der Teilfolgen wiederum A = +6 addiert und somit der dritte Wert der Teilfolgen gebildet etc. Die vom Prozessor 1 gebildete Teilfolge

1: 7; 13; ...

wird mit den von den Prozessoren 2, 3, ... 6 gebildeten Teilfolgen

(3: 9; 15; ... / 2; 8; 14; ... / 4; 10; 16; ... / 5; 11; 17; ... / 6; 12; 18; ...)

in der vorstehend erwähnten Art und Weise vom Multiplexer 8 zu der geforderten Ausgangs-Sequenz zusammengeführt:

1; 3; 2; 4; 5; 6; 7; 9; 8; 10; 11; ...

Die zeitliche Koordinierung der Sequenzen erfolgt über die mit dem Programmspeicher 7, den Prozessoren 1 bis 6 und dem Multiplexer 8 verbundene Zeitgeber-Schaltung 9.

In den Figuren 1A, 1B, 1C und 1D ist ein wesentliches Ausführungsbeispiel der Erfindung beschrieben. Eine geforderte Ausgangs-Sequenz mit einem entsprechenden Algorithmus einer bestimmten Periodizität, hier (P) = 6, wird in eine dieser Periodizitätszahl entsprechende Anzahl von Teilfolgen zerlegt. Für einen solchen Fall, Periodizitätszahl = Anzahl der Teilfolgen, kann aus den Anfangswerten der Teilfolgen durch kumulatives Addieren einer Konstanten, in diesem Falle A + 6, jede der Teilfolgen erzeugt werden. Hierfür ist neben einer der Periodizitätszahl entsprechenden Anzahl von Prozessoren nur ein einziger Programmspeicher (für die Speicherung des Wertes A = +6) erforderlich, zu dem alle Prozessoren Zugriff haben. Prozessorspezifische Programmspeicher, wie sie beim Stand der Technik üblich und erforderlich sind (siehe Fig. 2C), können hierbei entfallen. Über einen Multiplexer 8 werden die einzelnen von den Prozessoren erzeugten Teilfolgen zu der geforderten Ausgangs-Sequenz vereinigt.

Durch Zerlegen der geforderten Ausgangs-Sequenz in eine bestimmte Anzahl von zu erzeugenden Teilfolgen, die der Periodizitätszahl des Algorithmus der Ausgangs-Sequenz entspricht, ergibt sich eine äußerst einfache und effektive Schaltung (Fig. 1D) mit nur einem einzigen Programmspeicher.

In den Figuren 2A, 2B und 2C ist ein Beispiel zur Erläuterung des Standes der Technik gezeigt: Eine geforderte Ausgangs-Sequenz (Fig. 2A)

1; 3; 2; 4; 5; 6; 7; 9; 8; 10; 11; etc.

mit dem zugehörigen Algorithmus

+2; -1; +2; +1; +1; +1; +2; -1; +2; +1; etc.

wird in zwei Teilfolgen aufgeteilt. Damit ergibt sich, wie in Fig. 2B gezeigt, als erste Teilfolge

1; 2; 5; 7; 8; 11; etc.

mit dem zugehörigen Algorithmus

+1; +3; +2; +1; +3; etc.

Als zweite Teilfolge ergibt sich

3; 4; 6; 9; 10; 12; etc.

mit dem zugehörigen Algorithmus

+1; +2; +3; +1; +2; etc.

Wie aus Fig. 2A zu erkennen ist, umfaßt die Algorithmus-Periode für die Ausgangs-Sequenz sechs Werte, entsprechend den in der ausgezogenen Klammer erscheinenden Anzahl von Werten. Wenn bei einer Periodizität von (P) = 6, nicht wie im Beispiel der Figuren 1 sechs Teilfolgen, sondern z. B. nur zwei gebildet werden, ergeben sich für die einzelnen Teilfolgen unterschiedliche Algorithmen.

In Fig. 2C ist eine vereinfachtes Blockschaltbild einer Schaltung gezeigt, die der Erzeugung der beiden Teilfolgen dienen soll. Die erste Teilfolge wird über den Prozessor 1 (20), die zweite über den Prozessor 2 (21), erzeugt. Für die Erzeugung jeder Teilfolge wird deren Ausgangswert und die in jeweils einem Programmspeicher 22, 23 gespeicherte Periode des Algorithmus der Teilfolge vorgegeben.

So enthält der Programmspeicher 1 (22) die Algorithmus-Periode "(+1); ((+3)); (((+2)))" (entsprechend der in Fig. 2B horizontal verlaufenden Klammer) der ersten Teilfolge. Analoges gilt für die im Programmspeicher 2 (21) gespeicherte Algorithmus-Periode "+1; +2; +3" der zweiten Teilfolge.

Zur Erzeugung der ersten Teilfolge durch den Prozessor 1 (20) werden, wie bereits aus vorstehenden Beispielen ersichtlich, folgende Operationen ausgeführt:

1 = 1 (Anfangswert)

1 + (+1) = 2

2 + ((+3)) = 5

3 + (((+2))) = 7

7 + (+1) = 8

etc.

Die Erzeugung der zweiten Teilfolge durch den Prozessor 2 (21) ergibt sich analog. Jeder Wert der Teilfolge wird durch Addition des vorhergehenden zu dem zyklisch fortschreitenden Wert des Teilfolgen-Algorithmus gebildet.

Am Ausgang des Prozessors 1 (20) und des Prozessors 2 (21) stehen die erste bzw. die zweite Teilfolge zur Verfügung, die über den Multiplexer 24 zur geforderten Ausgangs-Sequenz zusammengefügt werden. Die zeitliche Koordinierung der Sequenzen erfolgt durch die Zeitgeberschaltung 25, welche mit den Programmspeichern 22, 23, den Prozessoren 20, 21 und dem Multiplexer 24 verbunden ist.

Aus diesem Beispiel (Fig. 2C) ist zur ersehen, daß die Schaltung zur Erzeugung der geforderten Ausgangs-Sequenz aufwendiger ist als im Falle der Fig. 1D. Es sind mehrere Programmspeicher (für jeden Prozessor einer) erforderlich. In jeden Programmspeicher ist nicht nur ein einziger Wert, sondern jeweils eine Folge von Werten (die Teilfolgen-Algorithmus-Periode) gespeichert. Im Vergleich zur Schaltung gemäß 1D ist zwar die Zahl der Prozessoren geringer, was sich aber nicht als resultierender Vorteil herausstellt, da nur Prozessoren in einfachster Ausgestaltung als arithmetisch-logische Einheit (ALU) erforderlich sind und

EP 0 591 562 A1

der Nachteil mehrerer komplexer Programmspeicher nicht durch weniger erforderliche einfache ALUs aufgewogen wird.

Fig. 3A zeigt ein Adreßmuster eines Chips. Aufgrund eines vorgegebenen Testmusters (stark ausgezogene Bereiche in Verbindung mit den Pfeilfolgen) soll eine bestimmte Ausgangs-Sequenz von Adressen erzeugt werden. In Fig. 3A sind die Chip-Adressen spaltenweise aufeinanderfolgend angeordnet: 0; 1; 2; 3; etc. Das anzuwendende Testmuster (es gibt verschiedene Muster) soll in diesem Fall der Adreßfolge

0; 1; 2; 3; 64; 65; 66; 67

genügen, die nach Verschiebung des Musters in einem nächsten Schritt um insgesamt vier Stellen weiter nach unten, mit

4; 5; 6; 7; 68; 69; 70; 71; etc.

fortsetzt. Die Pfeilfolge in dem Testmuster deutet die Adreßfolge an.

Sobald die erste Spalte (Adresse 0 bis 15) mit dem Testmuster "abgearbeitet" ist, wird das Testmuster auf den Beginn der zweiten Spalte verschoben usw. Auf diese Art und Weise ergibt sich die in Fig. 3B angegebene Ausgangs-Sequenz mit dem zugehörigen Algorithmus mit einer Periodizität von (P) = 8 (siehe horizontal verlaufende Klammer). Die Ausgangs-Sequenzwerte sind im umrandeten Teil der Darstellung allgemein noch mit C1 bis C12, die Algorithmuswerte für die Ausgangs-Sequenz zusätzlich noch mit A1 bis A12 bezeichnet. Die Folge der C- und A-Werte setzt sich selbstverständlich fort. Die Ausgangs-Sequenz mit dem zugehörigen Algorithmus wird in den nachfolgenden Darstellungen (Fig. 1C bis Fig. 3K) in verschieden viele Teilfolgen mit den dazugehörigen Teilfolge-Algorithmen aufgegliedert.

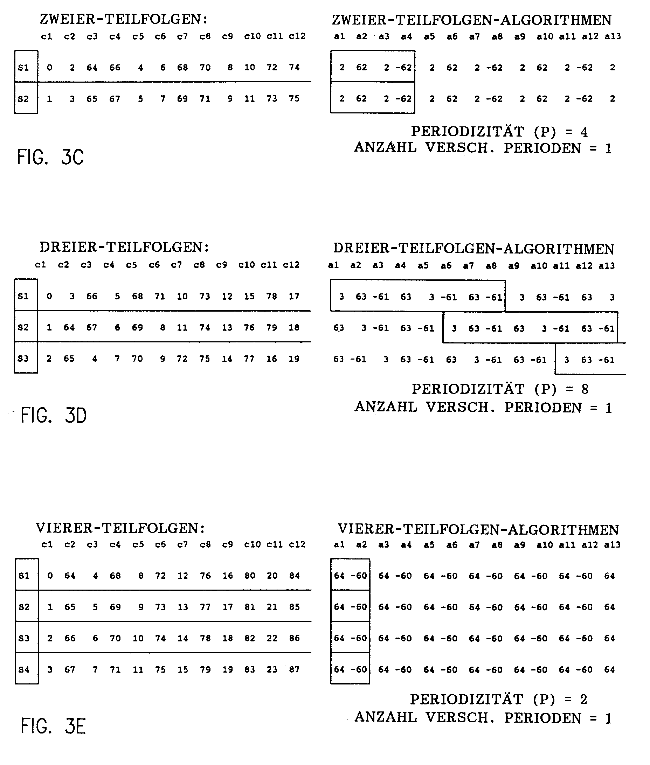

So zeigt Fig. 3C eine Aufgliederung in Zweier-Teilfolgen S1 und S2, deren Werte jeweils allgemein noch mit c1 bis c12 bezeichnet sind. Die dazugehörigen Werte der Zweier-Teilfolge-Algorithmen sind zusätzlich noch mit a1 bis a13 bezeichnet. Die Folge der c- und a-Werte setzt sich selbstverständlich auch fort. Dies gilt analog für alle nachfolgenden Darstellungen. Die Zusammenhänge zwischen den Zweier-Teilfolgen und den Zweier-Teilfolgen-Algorithmen sind wie folgt zu verstehen: Für S1 und den dazugehörigen Algorithmus bzw. für S2 und den dazugehörigen Algorithmus gilt:

$c_1 + a_1 = c_2$

$c_2 + a_2 = c_3$

$c_3 + a_3 = c_4$

etc.

Diese Zusammenhänge gelten analog für alle nachfolgenden Darstellungen.

So wird aus einem Wert der Teilfolge der Nachfolgewert durch Addition des zugehörigen Algorithmuswertes gebildet.

Bei den Zweier-Teilfolgen-Algorithmen tritt eine Periodizität der Wertfolge

2; 62; 2; -62 (umrandet)

auf. Das bedeutet, daß die Zweier-Teilfolgen unter Vorgabe ihres Anfangswertes mit Hilfe dieser Periodizitätswerte des Teilfolgen-Algorithmus gebildet werden können. In der Darstellung von Fig. 3C ist die Periodizität für die Teilfolgen mit (P) = 4 vermerkt; d. h., die Periode besteht aus vier Werten. Die Anzahl aller verschiedenen Perioden ist mit 1 angegeben, d. h., daß es nur eine einzige Algorithmus-Periode für die Teilfolgen S1 und S2 gibt, nämlich

2; 62; 2; -62.

In Fig. 3D ist eine Aufgliederung der Ausgangs-Sequenz gemäß Fig. 3B in Dreier-Teilfolgen S1, S2, S3 mit den zugehörigen Dreier-Teilfolgen-Algorithmen gezeigt. Bei diesen Dreier-Teilfolgen-Algorithmen ergibt sich eine Periodizität von (P) = 8, wobei die Periodenwerte in jedem der Algorithmen umrandet sind. Die Periodenwerte in den einzelnen Teilfolgen-Algorithmen sind gegeneinander um fünf Stellen verschoben. Da die Periode in allen drei Teilfolgen-Algorithmen dieselbe ist, ist für die Anzahl verschiedener Perioden wieder 1 angegeben.

In Fig. 3E ist die Aufgliederung der Ausgangs-Sequenz gemäß Fig. 3B in Vierer-Teilfolgen S1, S2, S3, S4 mit den zugehörigen Vierer-Teilfolgen-Algorithmen gezeigt. Die Betrachtung dieser Algorithmen führt zu einer Periodizität (P) = 2 für die jeweils umrandeten Werte 64 und -60. Diese Periode 64 und -60 tritt in allen vier Teilfolgen-Algorithmen ohne gegenseitige Verschiebung auf. Die Anzahl verschiedener Perioden ist wieder 1.

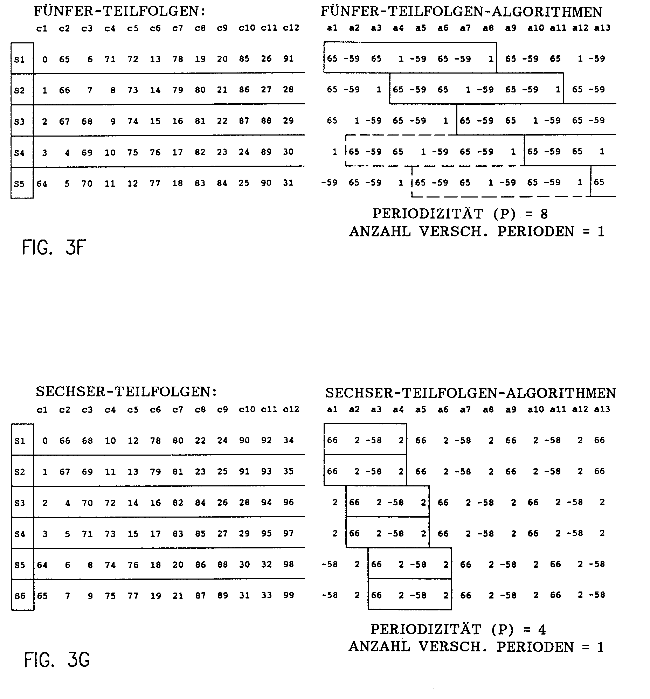

Fig. 3F zeigt die Aufgliederung der Ausgangs-Sequenz gemäß Fig. 3B in Fünfer-Teilfolgen S1 bis S5 mit den zugehörigen Fünfer-Teilfolgen-Algorithmen. Die einzelnen Algorithmen sind durch die gleiche Periodenfolge

65; -59; 65; 1; -59; 65; -59; 1 (umrandet)

gekennzeichnet. Diese Periodenfolge ist von Algorithmus zu Algorithmus um jeweils drei Stellen verschoben. Entsprechend der acht Werte umfassenden Periode ist die Periodizität (P) = 8. Wegen der gleichen Periode in allen Algorithmen ist die Anzahl verschiedener Perioden wieder 1.

10

Fig. 3G zeigt die Aufgliederung der Ausgangssequenz gemäß Fig. 3B in Sechser-Teilfolgen S1 bis S6 und die zugehörigen Sechser-Teilfolgen-Algorithmen. Die Algorithmen-Periode ist jeweils umrandet hervorgehoben. Die Periodizität ergibt sich zu (P) = 4 und die Anzahl verschiedener Perioden mit 1.

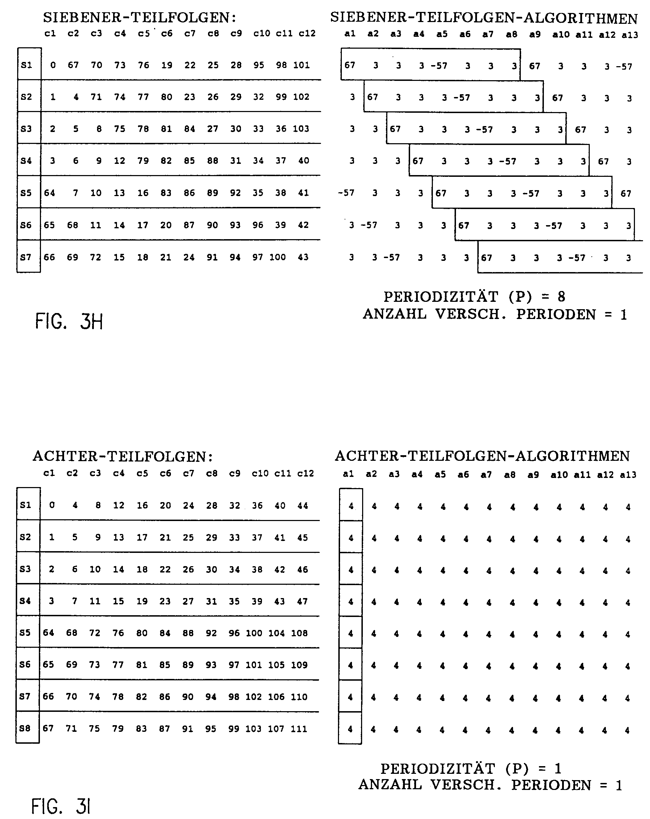

Fig. 3H zeigt die Aufgliederung der Ausgangs-Sequenz gemäß Fig. 3B in Siebener-Teilfolgen S1 bis S7 mit den dazugehörigen Siebener-Teilfolgen-Algorithmen. Wie aus Fig. 3A zu erkennen ist, tritt in allen diesen Siebener-Teilfolgen-Algorithmen die gleiche, jeweils acht Werte umfassende Periode (umrandet) auf, die von Algorithmus zu Algorithmus um jeweils eine Stelle verschoben ist. Es ergeben sich: Periodizität (P) = 8 und Anzahl verschiedener Perioden = 1.

In Fig. 3I ist die Aufgliederung der Ausgangs-Sequenz gemäß Fig. 3B mit der Periodizität (P) = 8 in Achter-Teilfolgen S1 bis S8 dargestellt. Aus dieser Darstellung ist die Besonderheit zu erkennen, die bei einer Aufgliederung auftritt, bei der die Anzahl der Teilfolgen der Periodizitätszahl der Ausgangs-Sequenz entspricht (hier = 8). Diese Besonderheit liegt, wie bereits erwähnt, darin, daß die Periode aller Teilfolgen-Algorithmen aus einem einzigen Wert besteht (Periodizität (P) = 1) und daß dieser Wert von einer Konstanten (hier = 4) gebildet wird. Diese Besonderheit führt zu den im Zusammenhang mit Fig. 1C und 1C beschriebenen schaltungstechnischen Vereinfachungen.

In Fig. 3J wird die Untersuchung der Aufgliederung der Ausgangssequenz in eine höhere Zahl von Teilfolgen fortgeführt. Fig. 3J zeigt die Aufgliederung in Neuner-Teilfolgen S1 bis S9 mit den dazugehörigen Neuner-Teilfolgen-Algorithmen. Für diese Algorithmen ergeben sich: Periodizität (P) = 8 und eine Anzahl verschiedener Perioden = 1.

In Fig. 3K ist die Aufgliederung der Ausgangs-Sequenz gemäß Fig. 3B in Zehner-Teilfolgen S1 bis S10 mit den dazugehörigen Zehner-Teilfolgen-Algorithmen gezeigt. Die Perioden der Algoritnmen umfassen die Werte: 6; 66; 6; -58 (umrandet). Es ergeben sich: Periodizität (P) = 4 und Anzahl verschiedener Perioden = 1. Aus der Darstellung geht die gegenseitige Verschiebung der Periode in den Algorithmen der einzelnen Teilfolgen hervor.

Die in den Figuren 3C bis 3K unter den Teilfolgen-Algorithmen gemachten Angaben:

Periodizität (P) und Anzahl verschiedener

Perioden

geben Hinweise auf den Aufwand der Schaltung zur Erzeugung der Ausgangs-Sequenz aus den durch Prozessoren zu generierenden Teilfolgen. Grundsätzlich kann gesagt werden, daß die Anzahl der Teilfolgen die Anzahl der erforderlichen Prozessoren bestimmt, und daß die Anzahl verschiedener Perioden (dies geht z. B. aus Fig. 2 hervor) die Anzahl der erforderlichen Programmspeicher bestimmt, wobei die Periodizitätszahl die Komplexität der Programmspeicher bestimmt.

Sofern die Periodizität (P) = 1 zutrifft, d. h. die Periode weist nur einen Wert und keine Folge von mehreren Werten auf, ergibt sich eine wesentliche Vereinfachung des Programmspeichers, der dann nur noch einen einzigen Wert (eine Konstante) zur Verfügung stellen muß, damit aus den Ausgangs-Werten der einzelnen Teilfolgen und dieser Konstanten über Prozessoren die Teilfolgen generiert werden können.

Die in Fig. 3I auftretende Konstante 4 für die Werte aller Achter-Teilfolgen-Algorithmen läßt sich einfach auch dadurch bestimmen, daß sämtliche positiven bzw. negativen Werte der Ausgangs-Sequenz-Algorithmus-Periode (+1; +1; +1; +61; +1; +1; +1; -63) summiert werden.

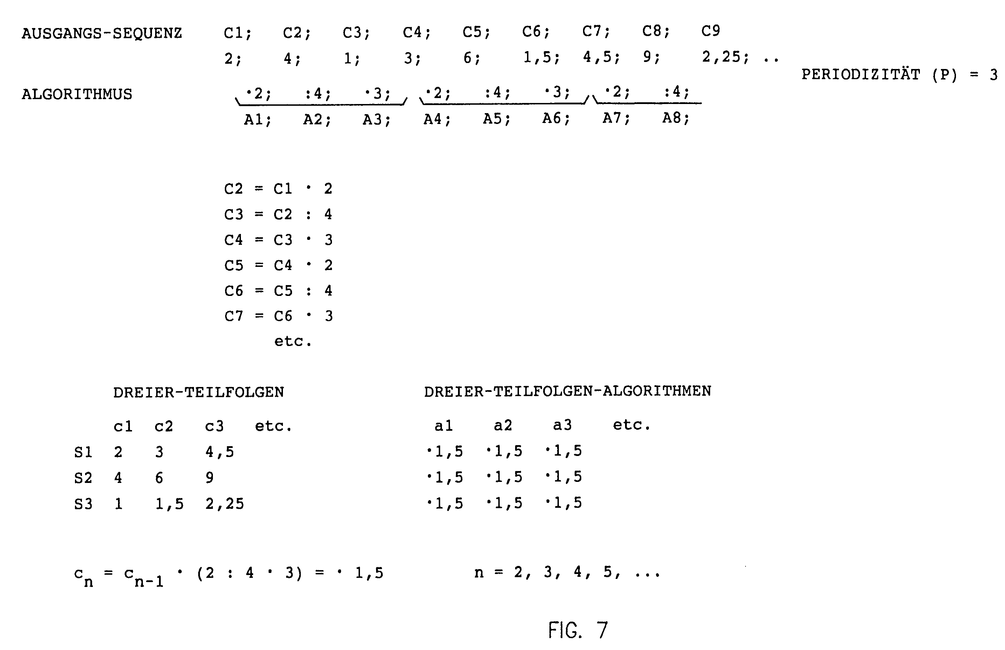

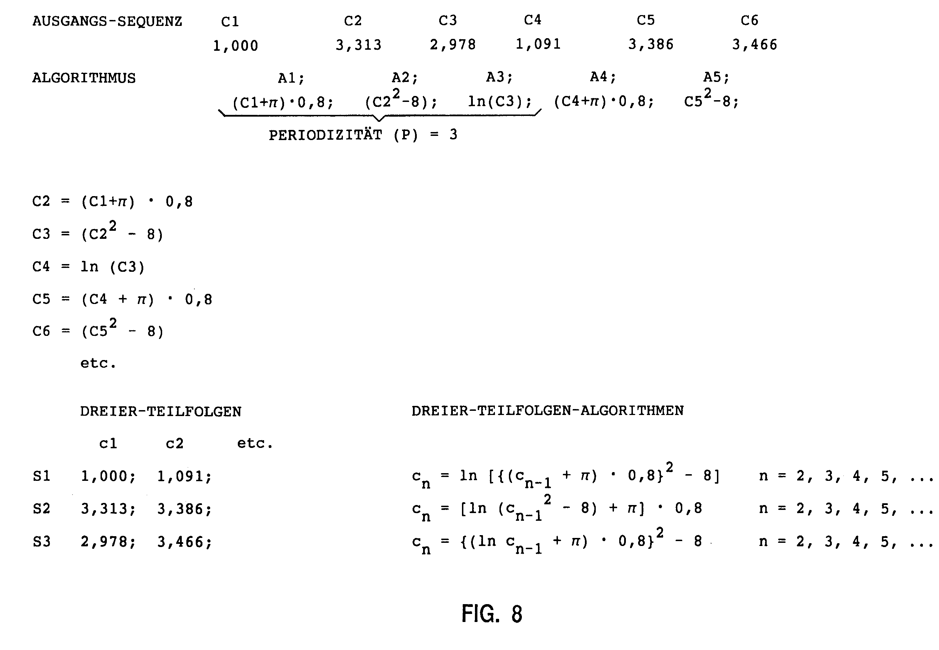

Diese Gesetzmäßigkeit findet sich analog auch später (im Zusammenhang mit Figuren 7 und 8) wieder, wenn die Werte der Ausgangs-Sequenz-Algorithmus-Periode nicht mehr einfache positive oder negative Zahlen darstellen, sondern komplexe arithmetische Ausdrücke.

Fig. 4A zeigt eine graphische Darstellung eines anderen Beispiels für ein Chip-Adreß-Testmuster. Die Chip-Adressen sind spaltenweise aufeinanderfolgend angeordnet. Die Pfeilfolge im Testmuster deutet die Adreßfolge an:

17; 0; 16; 32; 33; 34; 18; 2; 1; 17.

In einem nächsten Schritt wird das Testmuster um einen Schritt weiter nach rechts verschoben, so daß sich die Adreßfolge mit

33; 16; 32; 48; 49; 50; 34; 18; 17; ...

fortsetzt etc. gefolgt von weiterer zeilenweiser Anwendung des Testmusters auf die Chip-Adressen.

Die sich aus der Anwendung des Testmusters ergebende Adreßfolge ist in der Fig. 4B mit Ausgangs-Sequenz bezeichnet und sequentiell dargestellt. Darunter ist der Algorithmus für die Ausgangs-Sequenz angegeben. Die einzelnen Algorithmuswerte sind auf Lücke nach unten versetzt zwischen den Werten der Ausgangs-Sequenz angeordnet. Analog zu den vorhergehenden Betrachtungen läßt sich aus dem Anfangswert der Ausgangs-Sequenz und den Algorithmuswerten die Ausgangs-Sequenz ableiten. Der Algorithmus weist eine durch horizontal verlaufende Klammer gekennzeichnete Periodizität (P) = 10 auf. Da es für die Ausgangs-Sequenz nur eine und nicht verschiedene Perioden gibt, lautet die Angabe Anzahl verschiedener Perioden = 1. Im unteren Teil der Darstellung von Fig. 4B ist die Ausgangs-Sequenz und der Algorithmus in einer anderen Darstellung wiedergegeben, wobei die Werte der Ausgangs-Sequenz noch zusätzlich mit C1 bis C12 und die Werte des Algorithmus zusätzlich mit A1 bis A12 gekennzeichnet sind. Diese Darstellung der Ausgangs-Sequenz und des Algorithmus sind umrandet; beide Darstellungen sind nicht aufeinander ausgerichtet.

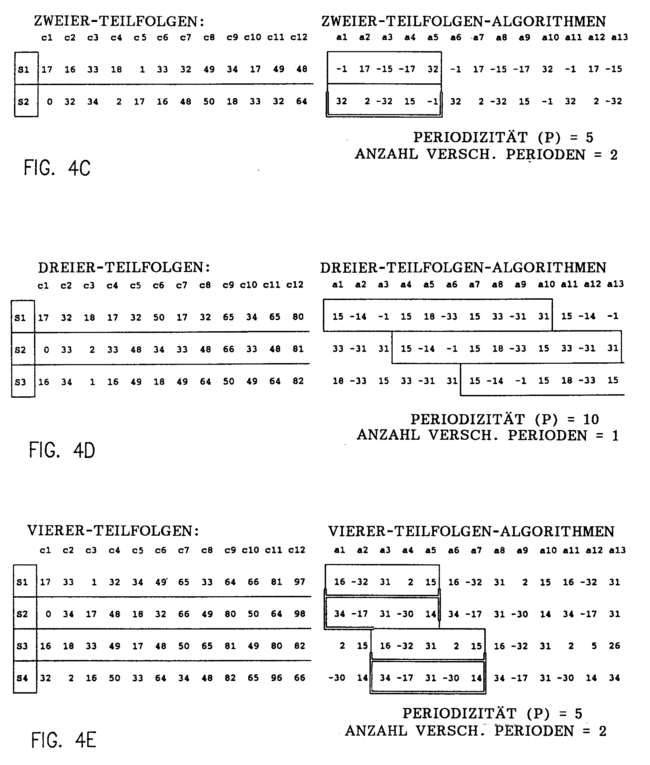

Die Darstellung 4C zeigt eine Aufgliederung der Ausgangs-Sequenz gemäß Fig. 4B in Zweier-Teilfolgen S1 und S2 mit den zugehörigen Zweier-Teilfolgen-Algorithmen. Die Teilfolgen-Algorithmen in Fig. 4C weisen, gemäß dem umrandeten Teil, jeweils fünf Werte umfassende Perioden auf: (P) = 5. Da die Perioden in beiden Teilfolgen-Algorithmen unterschiedlich sind, lautet die Eintragung: Anzahl verschiedener Perioden = 2.

Fig. 4D zeigt eine Aufgliederung der Ausgangs-Sequenz gemäß Fig. 4B in Dreier-Teilfolgen mit den dazugehörigen Dreier-Teilfolgen-Algorithmen. Die Perioden dieser Algorithmen sind, wenn auch gegeneinander verschoben, identisch. Sie weisen eine Periodizität (P) = 10 auf. Wegen der Identität der Perioden ist die Anzahl verschiedener Perioden = 1.

Fig. 4E zeigt eine Aufgliederung der Ausgangs-Sequenz gemäß Fig. 4B in Vierer-Teilfolgen mit dazugehörigen Vierer-Teilfolgen-Algorithmen. Insgesamt gibt es zwei verschiedene Algorithmen-Perioden mit der Periodizität (P) = 5). Die Anzahl verschiedener Perioden ist 2.

In Fig. 4F wird eine Aufgliederung der Ausgangs-Sequenz gemäß Fig. 4B in Fünfer-Teilfolgen mit dazugehörigen Fünfer-Teilfolgen-Algorithmen gezeigt. Eine Betrachtung dieser Algorithmen zeigt, daß insgesamt fünf verschiedene Perioden auftreten (Anzahl verschiedener Perioden = fünf) und daß die Algorithmen jeweils durch eine zwei Werte umfassende Periode (Periodizität (P) = 2) gekennzeichnet sind.

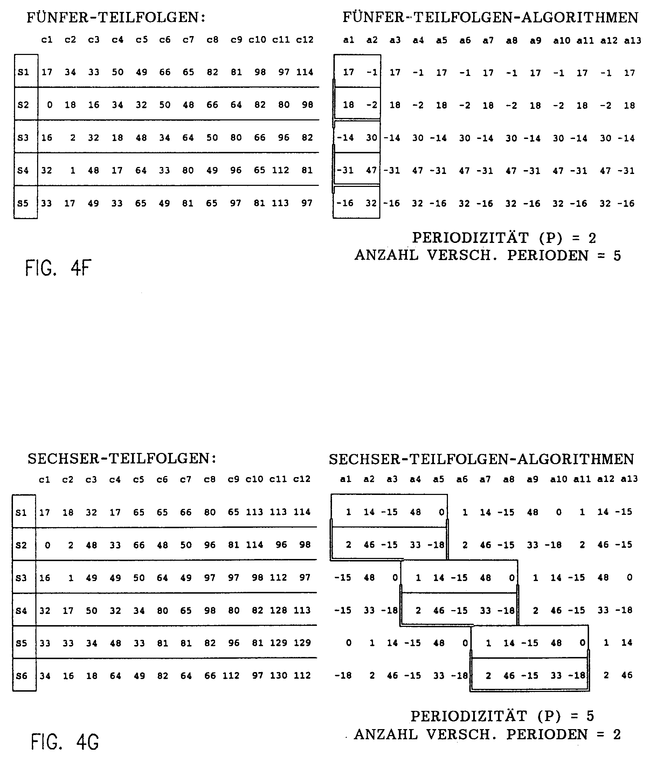

In Fig. 4G ist eine Aufgliederung der in Fig. 4B dargestellten Ausgangs-Sequenz in Sechser-Teilfolgen mit dazugehörigen Sechser-Teilfolgen-Algorithmen gezeigt. Eine Betrachtung der Algorithmen zeigt, daß insgesamt zwei verschiedene, wenn auch in den Teilfolgen mitunter gegeneinander verschobene Perioden (umrandet) auftreten und daß jede Periode jeweils fünf Werte umfaßt (Periodizität (P) = 5).

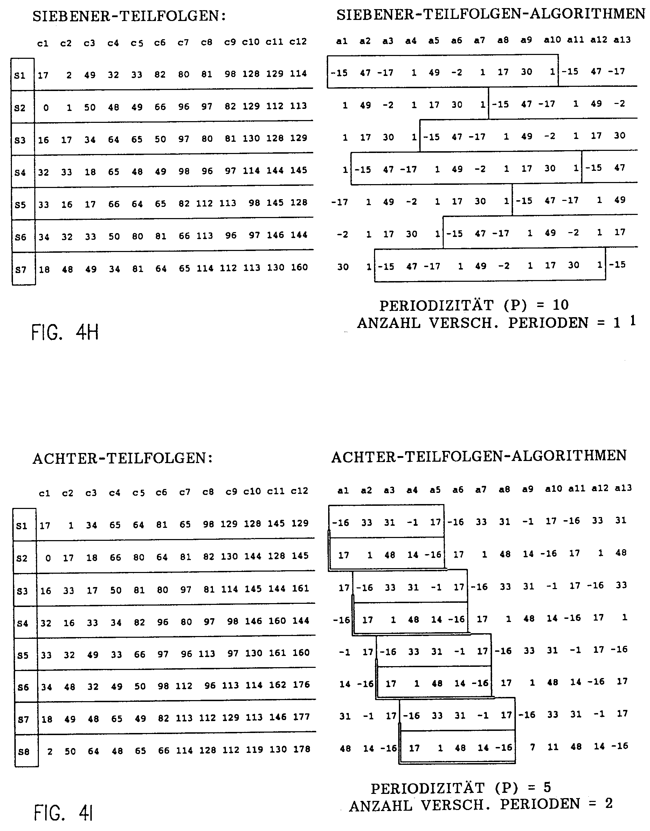

In Fig. 4H ist eine Aufgliederung der Ausgangs-Sequenz gemäß Fig. 4B in Siebener-Teilfolgen mit dazugehörigen Siebener-Teilfolgen-Algorithmen gezeigt. Die Perioden der Algorithmen sind, wenn auch gegeneinander verschoben, identisch (Anzahl verschiedener Perioden = 1). Sie weisen eine, wie aus der jeweils umrandeten Darstellung hervorgeht, jeweils zehn Werte umfassende Periodizität auf (Periodizität (P) = 10).

In Fig. 4I ist eine Aufgliederung der in Fig. 4B dargestellten Ausgangs-Sequenz in Achter-Teilfolgen S1 bis S8 mit dazugehörigen Achter-Teilfolgen-Algorithmen gezeigt. Eine Betrachtung der Algorithmen zeigt, daß insgesamt zwei verschiedene, wenn auch gegeneinander verschobene, Perioden auftreten (Anzahl verschiedener Perioden = 2), und daß gemäß dem umrandeten Teil der Darstellung eine Periode fünf Werte umfaßt (Periodizität (P) = 5).

Fig. 4J zeigt eine Aufgliederung der Ausgangs-Sequenz gemäß Fig. 4B in Neuner-Teilfolgen S1 bis S9 mit dazugehörigen Neuner-Teilfolgen-Algorithmen. Die Perioden der Algorithmen sind jeweils gleich, wenn auch gegeneinander verschoben (Anzahl verschiedener Perioden = 1). Die Perioden (umrandet) umfassen jeweils zehn Werte (Periodizität (P) = 10).

Fig. 4K zeigt eine Aufgliederung der Ausgangs-Sequenz gemäß Fig. 4B in Zehner-Teilfolgen S1 bis S10 mit dazugehörigen Zehner-Teilfolgen-Algorithmen. In dieser Darstellung, bei der die Anzahl der Teilfolgen der Periodizität (P) = 10 des Algorithmus der Ausgangs-Sequenz gemäß Fig. 4B entspricht, tritt die im Zusammenhang mit Fig. 1C betonte Besonderheit auf, daß die Periode der Zehner-Teilfolgen aus ein und dem gleichen Wert (hier 16) bestehen. Damit ist die Anzahl verschiedener Perioden = 1 und die Periodizität (P) = 1.

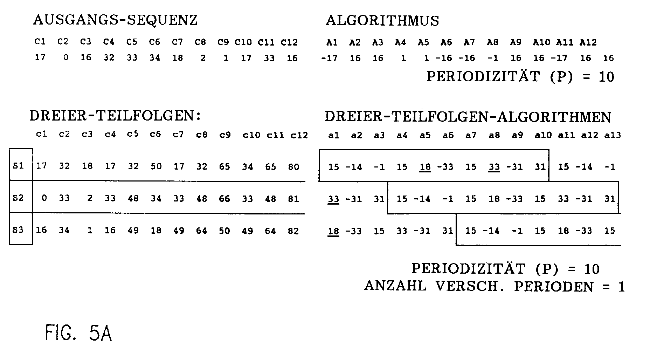

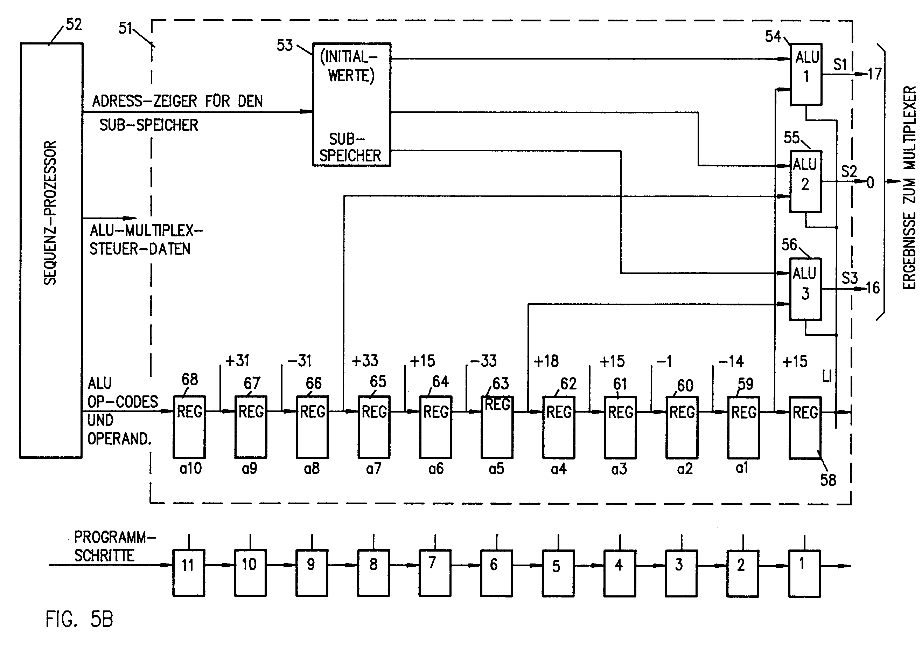

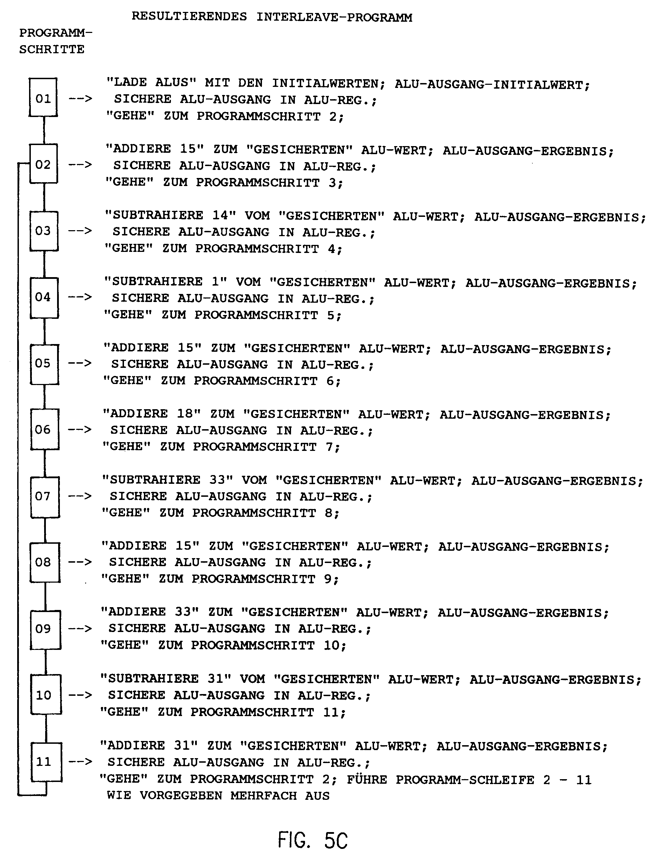

Die Figuren 5A, 5B und 5C zeigen anhand eines Beispieles, der in Fig. 4B wiedergegebenen Ausgangs-Sequenz in Verbindung mit der in Fig. 4D gezeigten Aufgliederung in Dreier-Teilfolgen, wie mit Hilfe eines Prozessors 51 (Fig. 5B) mit mehreren Arithmetik-Logik-Einheiten (ALUs) und einem einzigen Programmspeicher 59 - 68 die Dreier-Teilfolgen erzeugt werden können.

Wie in Fig. 5A angegeben, lautet die Ausgangs-Sequenz

17; 0; 16; 32; 33; 34; 18; 2; 1; 17; 33; 16; ...

Die einzelnen Werte sind mit C1 bis C12 bezeichnet.

Der Algorithmus für die Ausgangs-Sequenz lautet:

-17; 16; 16; 1; 1; -16; -16; -1; 16; 16; -17; 16; 16; ...

Diese Werte sind mit A1 bis A13 bezeichnet.

In Fig. 5A ist weiterhin die Aufteilung der Ausgangs-Sequenz in Dreier-Teilfolgen S1, S2, S3 mit den zugehörigen Dreier-Teilfolgen-Algorithmen gezeigt. Innerhalb einer jeden Teilfolge sind die Werte mit c1 bis c12 bezeichnet. Die Werte der Dreier-Teilfolgen-Algorithmen sind jeweils noch mit a1 bis a13 gekennzeichnet.

Die in den Teilfolgen-Algorithmen auftretende Periode

15; -14; ... 31

ist umrandet. Aus der Darstellung geht hervor, daß alle Dreier-Teilfolgen-Algorithmen die gleiche Periode aufweisen, wobei die Perioden in den Algorithmen für S1, S2 und S3 um jeweils drei Stellen gegeneinander verschoben sind. Die Periodizität (P) für die Dreier-Teilfolgen-Algorithmen beträgt (P) = 10.

In diesem Beispiel ist die Anzahl der verschiedenen Perioden = 1.

Fig. 5B zeigt ein vereinfachtes Blockschaltbild einer prozessorgesteuerten Schaltung, mit deren Hilfe unter Kenntnis der Dreier-Teilfolgen-Algorithmus-Periode und der gegenseitigen Verschiebung dieser Periode in den Algorithmen der Teilfolgen, sowie unter Kenntnis der Anfangswerte für die einzelnen Teilfolgen die Dreier-Teilfolgen erzeugt und über einen nicht dargestellten Multiplexer zur gewünschten Ausgangs-Sequenz zusammengefügt werden können.

Die Schaltung besteht im wesentlichen aus drei Teilen: einem Sequenz-Prozessor 52, einem Multi-ALU-Prozessor 51 (ALU = arithmisch-logische Einheit) und dem nicht dargestellten Multiplexer. Aufgabe des Sequenz-Prozessors 52 ist es, Anfangswerte für die Dreier-Teilfolgen zu adressieren, Steuerdaten für den Multi-ALU-Prozessor 51 und den nicht dargestellten Multiplexer zur Verfügung zu stellen.

Der Multi-ALU-Prozessor 51 enthält so viele ALUs (arithmetisch-logische Einheiten) 54, 55, 56, wie es Teilfolgen gibt. In diesem Beispiel gibt es drei Teilfolgen S1, S2, S3; somit sind drei ALUs vorgesehen, die in verschiedenen "Ebenen" arbeiten. Die ALU1 54 dient der Erzeugung der ersten Dreier-Teilfolge S1, die ALU2 55 der Erzeugung der zweiten Dreier-Teilfolge S2 und die ALU3 56 der Erzeugung der dritten Dreier-Teilfolge S3. Zu Beginn erhält jede ALU durch entsprechende Adressierung eines Sub-Speichers 53, welche vom Sequenz-Prozessor 52 aus erfolgt, den Anfangswert der Teilfolge: so wird für die ALU1 54 der Anfangswert 17 für S1 vorgegeben, für die ALU2 55 der Anfangswert 0 für S2 und für die ALU3 56 der Anfangswert 16 für S3. Diese Werte werden auf den ALU-Ausgang durchgestellt und jeweils in einem nicht dargestellten ALU-Register für nachfolgende Rechenvorgänge gesichert (zwischengespeichert). Für das Durchstellen der Anfangswerte ist in einem Register 58 ein entsprechender Operationscode vorgesehen. Dieses Register ist über die Leitung LI mit dem ALUs verbunden. Neben dem Sub-Speicher 53, den verschiedenen ALUs 54, 55, 56 und dem Register 58 enthält der Multi-ALU-Prozessor 51 noch eine Reihe von hintereinandergeschalteter Registern 59 bis 68, in welche vom Sequenz-Prozessor 52 die einzelnen Werte für die Teilfolgen-Algorithmus-Periode übertragen werden, sie schließen die + oder - Operationscodes der Periodenwerte, also deren Vorzeichen, wie auch den absoluten Wert dieser Werte als Operanden ein. So enthält das Register 59 zunächst den Wert a1 = +15, das Register 60 den Wert a2 = -14 etc. und das Register 68 den Wert a10 = +31.

Das Register 59 ist mit der ALU1 54, das Register 63 mit der ALU2 55 und das Register 66 mit der ALU3 54 verbunden.

Nach dem bereits erwähnten Durchschalten der Anfangswerte der Teilfolgen auf die ALU-Ausgänge wird in einem nachfolgenden Programmschritt in jeder ALU folgende Operation ausgeführt: Addition des im ALU-Register zwischengespeicherten (gesicherten) Werts des vorausgehenden Programmschrittes zu dem Wert, der in dem mit der jeweiligen ALU verbundenen Register steht. Auf diese Weise führt die ALU1 54 die Operation

17 + (+15) = 32,

die ALU2 55 die Operation

0 + (+33) = 33

und die ALU3 56 die Operation

16 + (+18) = 34

aus. Die Ergebnisse erscheinen jeweils an den ALU-Ausgängen als zweiter Wert c2 der zu erzeugenden Teilfolge und werden für den nächsten Programmschritt zwischengespeichert.

Vor Ausführung des nachfolgenden Programmschritts wird der Inhalt der Register 59 bis 68 zyklisch in Pfeilrichtung um eine Stufe verschoben. Jetzt enthält Register 59 den Wert -14, Register 60 den Wert -1, etc. und Register 68 den Wert +15 (aus Register 59). Sodann führt die ALU1 54 die Operation

32 + (-14) = 18,

die ALU2 55 die Operation

33 + (-31) = 2

und die ALU3 56 die Operation

34 + (-33) = 1

zur Bildung des dritten Wertes c3 der Teilfolgen S1, S2 und S3 aus. Unter ständiger Zwischenspeicherung der Ergebnisse und zyklischer Verschiebung der Register-Werte 59 bis 68 erscheinen an den ALU-Ausgängen die Teilfolgen S1, S2 bzw. S3, welche über den nicht dargestellten Multiplexer zu der geforderten Ausgangs-Sequenz zusammengeführt werden.

Die in Fig. 5B dargestellte Schaltung zeigt im Vergleich zum Stand der Technik (Fig. 2C), daß bei Zerlegung einer Ausgangs-Sequenz in (hier) drei Teilfolgen mit einer einzigen Teilfolgen-Algorithmus-Periode nur ein einziger Programmspeicher in Form der Register 58 bis 68 und der Sub-Speicher 53 erforderlich ist. Die gegenseitige Verschiebung der Perioden in den Teilfolgen-Algorithmen wird durch entsprechende Verbindung der ALUs mit den Registern berücksichtigt. Das Charakteristische an dem Multi-ALU-Prozessor 51 sind die zeitgleich arbeitenden ALUs.

Im unteren Teil der Fig. 5B sind schematisch einzelne Programmschritte 0, 1, 2, ... 11 für die Erzeugung der Teilfolgen durch die ALUs angegeben. Einzelheiten hierzu finden sich in Fig. 5C.

Die Funktion der einzelnen Programmschritte ist dort selbsterklärend angegeben. Die Schritte 01 bis 03 wurden bereits im Zusammenhang mit Fig. 5B beschrieben.

Nach Abschluß des Programmschrittes 11 verzweigt das Programm wieder zum Programmschritt 02 und bildet so eine Schleife. Diese Schleife, Schritte 02, 03, 04 bis 11 umfassend, wird so oft durchlaufen, wie es von der Anforderung her vorgegeben ist, d. h. so oft die Teilfolgen-Periode durchlaufen werden soll.

Je nach Anzahl der Teilfolgen muß bei einer allen Teilfolgen-Algorithmen gemeinsamen gleichen Periode ein programmierbarer Multi-ALU-Prozessor eine entsprechende Anzahl von ALUs bereitstellen, die der Anzahl der Teilfolgen entspricht.

Je nach der Periodizität der Teilfolgen-Algorithmen muß dieser Multi-ALU-Prozessor 51 auch eine entsprechende Anzahl von Registern zur Verfügung stellen, welche mit den Werten für die Teilfolgen-Algorithmus-Periode zu laden sind. Außerdem muß die gegenseitige Verschiebung der Teilfolgen-Algorithmen-Periode in den Teilfolgen-Algorithmen durch entsprechend programmierbare Verbindungen einzelner Register zu den zugehörigen ALUs berücksichtigt werden. Mit anderen Worten: Es ist möglich, programmgesteuert eine Schaltung (Multi-ALU-Prozessor) so zu konfigurieren, daß sie über die Bildung der Teilfolgen der Erzeugung der gewünschten Ausgangs-Sequenz dient.

Die Voraussetzungen dafür wurden bereits erläutert: Eine gedachte Ausgangs-Sequenz kann programmgesteuert (automatisch) dahingehend untersucht werden, wieviel Teilfolgen Teilfolgen-Algorithmen mit einer gemeinsamen Periode bedingen, die mehr als einen Wert aufweist.

Alle derart erlangten Parameter (Anzahl der Teilfolgen, Werte der Teilfolgen-Algorithmen-Periode und Verschiebewerte dieser Periode in den Teilfolgen-Algorithmen) können dazu herangezogen werden, einen Multi-ALU-Prozessor 51 per Programm so zu konfigurieren, daß er automatisch die gewünschten Teilfolgen erzeugt, welche über einen Multiplexer zur gewünschten Ausgangs-Sequenz zusammengeführt werden.

Auf diese Art und Weise kann z. B. für ein Testsystem unter Kennzeichnung eines Adreß-Testmusters die Adreßfolge automatisch über eine programmtechnisch gesteuerte Konfiguration eines Multi-ALU-Prozessors erzeugt werden.

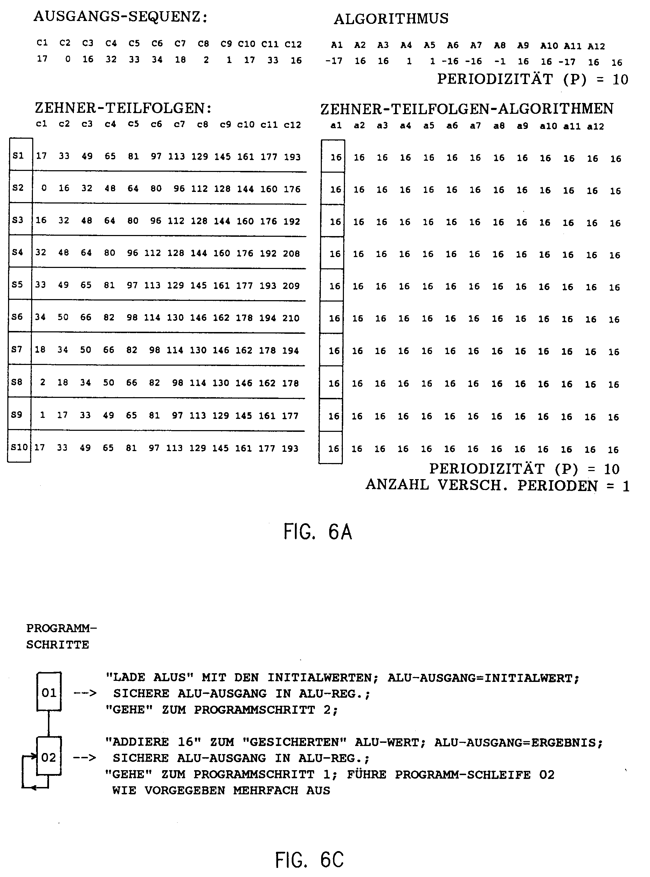

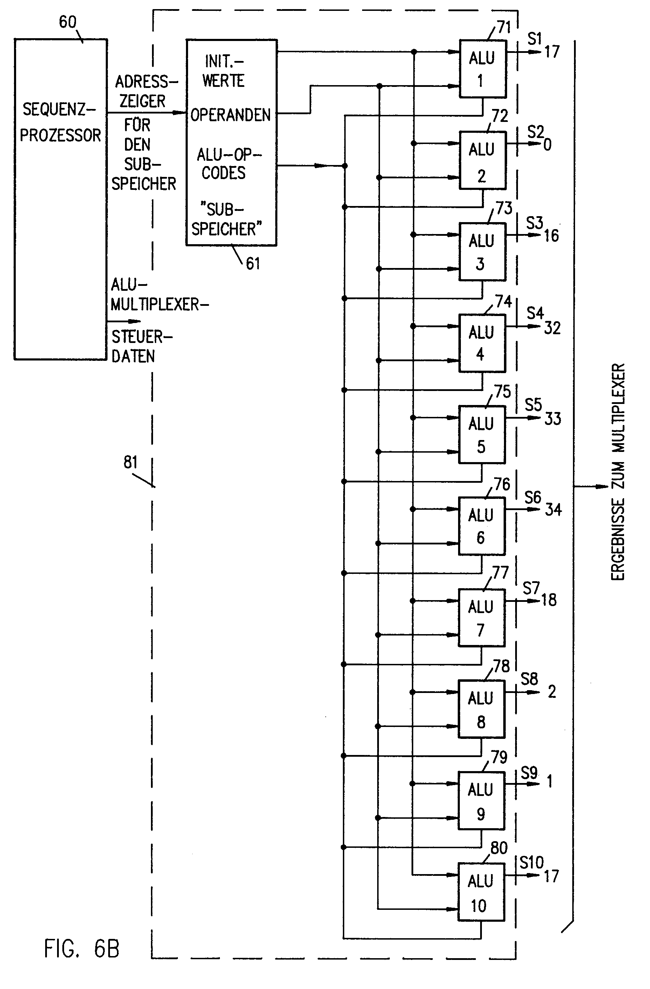

Es sei bemerkt, daß es im Sonderfall, wenn die allen Teilfolgen-Algorithmen gemeinsame Periode nur aus einem einzigen Wert, einer Konstanten, besteht, zu weiteren optimierenden Schaltungsvereinfachungen kommt. Ein solches Beispiel wird in Zusammenhang mit den Figuren 6 beschrieben.

In Fig. 6A ist eine Ausgangs-Sequenz (Fig. 4B) mit einer Algorithmus-Periodizität von (P) = 10, und die Aufteilung dieser Sequenz in Zehner-Teilfolgen (Fig. 4K) mit dazugehörigen Zehner-Teilfolgen-Algorithmen wiedergegeben.

Fig. 6B zeigt eine Schaltung zur Erzeugung der Teilfolgen gemäß Fig. 6A, aus denen die gewünschte Ausgangs-Sequenz gebildet wird.

Für Fig. 6A gelten die gleichen Aussagen wie sie im Zusammenhang mit den Figuren 4B und 4K gemacht wurden.

Bei einer Periodizität (P) = 10 der Ausgangs-Sequenz ergibt sich für die Werte der Zehner-Teilfolgen-Algorithmen jeweils die Konstante 16. Dies deutet bereits darauf hin, daß sich im Vergleich zu dem in Fig. 5B dargestellten Schaltungsbeispiel mit mehreren Registern (diese waren erforderlich, weil die Teilfolgen-Algorithmen-Periode mehrere Werte umfaßte) eine weitere Schaltungsvereinfachung ergibt. Diese ist dadurch begründet, daß die Anzahl verschiedener Perioden für die Teilfolgen-Algorithmen in Fig. 6A nur 1 beträgt; d. h., es wäre allenfalls nur ein einziges Register erforderlich, daß in Fig. 6B in den Sub-Speicher 61 verlegt wird.

Entsprechend der Periodizität (P) = 10 der Ausgangs-Sequenz sind zehn verschiedene Prozessoren (ALUs) 71, 72, ... 80 vorgesehen. Die ALU 1 (71) dient der Erzeugung der ersten Teilfolge S1, die ALU 2 (72) der Erzeugung der zweiten Teilfolge S2 etc., die ALU 10 der Erzeugung der zehnten Teilfolge S10. Alle Teilfolgen werden über einen nicht dargestellten Multiplexer zur gewünschten Ausgangs-Sequenz zusammengeführt.

In einem Sub-Speicher 61 sind die Anfangswerte (Init-Werte) der einzelnen Teilfolgen durch ihre Operanden (Absolutwerte) und ihre Vorzeichen + oder - (ALU-Operationscodes = ALU-Op-Codes) gespeichert; außerdem enthält er die gespeicherte Konstante 16.

14

Der Sub-Speicher 61 wird von dem Sequenz-Prozessor 60 adressiert, der auch die Steuerung des die ALUs und den Sub-Speicher 61 umfassenden Multi-ALU-Prozessors 81 und des nicht dargestellten Multiplexer ausübt.

In einem ersten Programmschritt (siehe auch Fig. 6C) erhalten die einzelnen ALUs den Anfangswert der ihnen zugeordneten Teilfolgen aus dem Sub-Speicher 61. Dieser Anfangswert wird auf den Ausgang der ALUs durchgestellt: Am Ausgang der ALU 1 (71) erscheint somit der Wert 17, etc., am Ausgang der ALU 10 (80) der Wert 16. Diese Ausgangswerte werden (wie auch alle nachfolgenden) in einem nicht dargestellten Register der jeweiligen ALU für den nachfolgenden Programmschritt zwischengespeichert (gesichert).

Im zweiten Programmschritt 02 (siehe auch Fig. 6C) wird zu dem im jeweiligen ALU-Register zwischengespeicherten Wert in jeder ALU die aus dem Sub-Speicher 61 stammende Konstante 16 addiert. Das Additionsergebnis erscheint am jeweiligen ALU-Ausgang als zweiter Wert der entsprechenden Teilfolge. Dieses Ergebnis wird wiederum im ALU-Register zwischengespeichert für die im nächsten Programmschritt erfolgende Addition dieses Ergebnisses zur Konstanten 16 usw.

In Fig. 6C sind die Programmschritte 01 und 02 in einem schematischen Programm-Ablaufplan wiedergegeben. Der Programmschritt 02 wird so oft wiederholt, wie es der Vorgabe (zur Länge der Teilfolgen) entspricht.

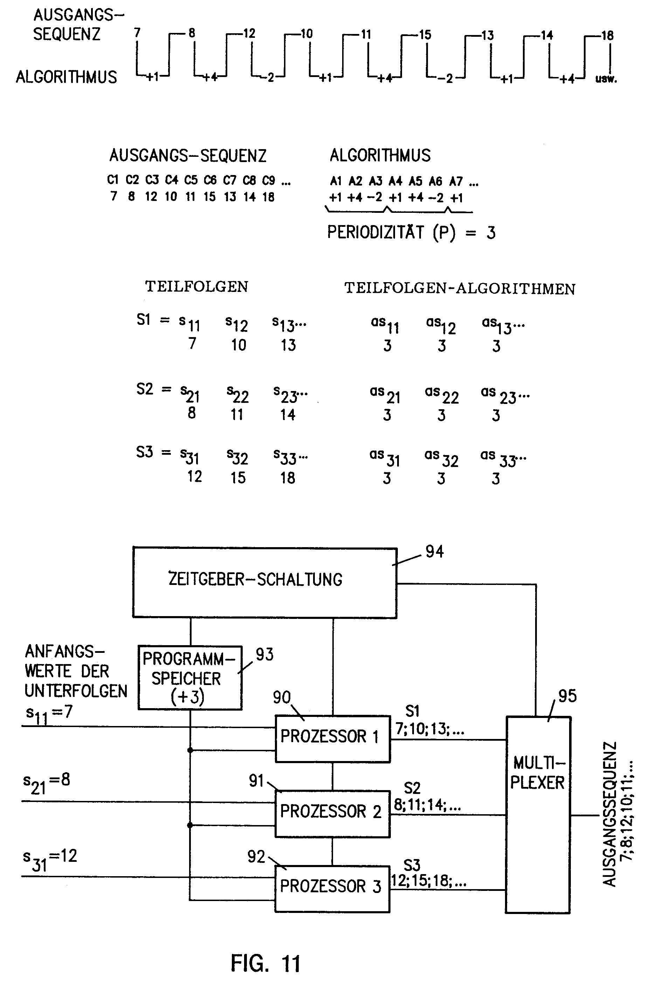

Während die Werte der Algorithmen der Ausgangs-Sequenz in den Figuren 1A, 1B; 3A, 3B; 4A, 4B und in Fig. 11 von Summanden bzw. Subtrahenden gebildet werden, wird in Fig. 7 ein Beispiel gezeigt, bei dem die Werte des Algorithmus der Ausgangs-Sequenz aus Faktoren bzw. Divisoren bestehen.

Die Werte der Ausgangs-Sequenz

2; 4; 1; 3; 6; 1,5; 4,5; 9; 2,25; ..

sind allgemein noch mit

C1; C2; C3; C4; C5; C6; C7; C8; C9; ...

die Werte (sie schließen sowohl Operanden wie ein Multiplikationszeichen und den Operandenwert selbst ein) des Algorithmus

•2; :4; •3; •2; :4; •3; •2; :4; ...

sind im allgemeinen noch mit

A1; A2; A3; A4; A5; A6; A7; A8; ...

bezeichnet.

Die Ausgangs-Sequenz wird in Analogie zu dem z. B. in Fig. 3 angegebenen Beispiel dadurch gebildet, daß sich ein nachfolgender Wert in der Ausgangs-Sequenz durch Verknüpfung des Vorgänger-Wertes mit dem zugehörigen Algorithmuswert ergibt.

C1 Anfangswert
C2 = C1 in Verknüpfung mit A1
C3 = C2 in Verknüpfung mit A2
C4 = C3 in Verknüpfung mit A3
C5 = C4 in Verknüpfung mit A4
C6 = C5 in Verknüpfung mit A5
etc.

Unter Berücksichtigung der aktuellen A-Werte ergeben sich

C1 Anfangswert (= 2)
C2 = C1 • 2
C3 = C2 : 4
C4 = C3 • 3
C5 = C4 • 2
C6 = C5 : 4
etc.

Wie aus dem oberen Teil der Darstellung in Fig. 7 zu erkennen ist, weist der Algorithmus der Ausgangs-Sequenz eine Periodizität von (P) = 3 auf: Die Periode besteht aus drei Werten, nämlich •2; :4; •3. Wird die Ausgangs-Sequenz entsprechend (P) = 3 in Dreier-Teilfolgen S1, S2 und S3 mit zugehörigen Dreier-Teilfolgen-Algorithmen aufgegliedert, ergibt sich in Analogie zu den in den Figuren 3I, 4K und 11 gezeigten Beispielen, daß die Werte der Dreier-Teilfolgen- Algorithmen für alle Dreier-Teilfolgen gleich sind und aus dem Multiplikator "•1,5" bestehen.

Der allgemeine und spezielle Zusammenhang zwischen der ersten Dreier-Teilfolge S1 mit den allgemein bezeichneten Werten c1, c2, c3, etc. und den Werten a1, a2, a3, ... des zugehörigen Dreier-Teilfolgen-Algorithmus ist wie folgt:

c1 Anfangswert
c2 = c1 in Verknüpfung mit a1

c3 = c2 in Verknüpfung mit a2

etc.

das heißt im Speziellen:

c1 = 2

c2 = 2 • 1,5

c3 = c2 • 1,5

etc.

Auf eine ausführliche Darstellung der Aufgliederung der in Fig. 7 gezeigten Ausgangs-Sequenz in Zweier-, Dreier-Vierer-Teilfolgen etc. ist verzichtet worden, da das Prinzip solcher Aufgliederungen bereits im Zusammenhang mit den Figuren 3 und 4 beschrieben wurde.

Interessant ist jedoch wiederum, auf welche verhältnismäßig einfache Art und Weise der Teilfolgen-Algorithmus-Wert für den Fall bestimmt werden kann, in dem die Periodizitätszahl (hier = 3) mit der Anzahl der Teilfolgen übereinstimmt.

Der Teilfolgen-Algorithmus-Wert (hier Multiplikator "• 1,5") ergibt sich ganz einfach aus der Verknüpfung der Werte der Ausgangs-Sequenz-Algorithmus-Periode zu

•2 :4 •3 = •1,5.

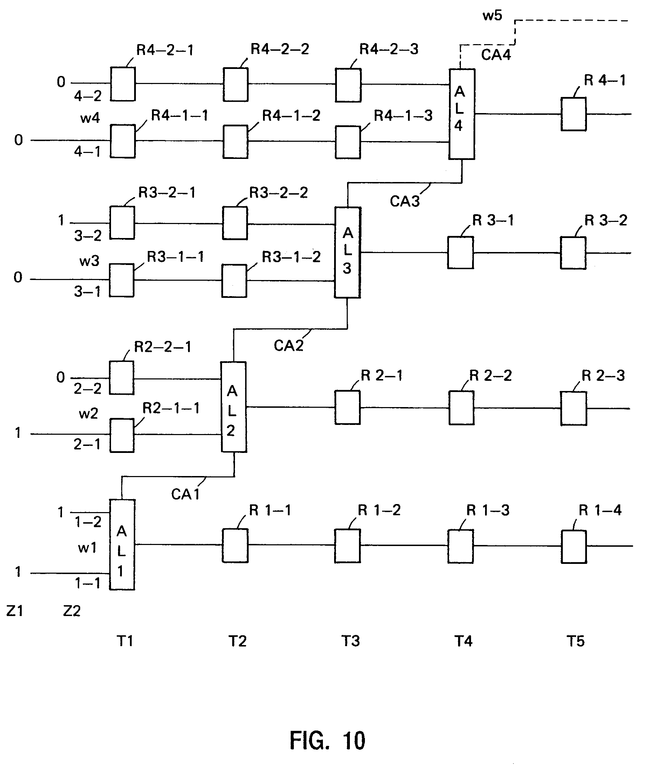

Auch für dieses Beispiel ergeben sich bei einer programmtechnisch gesteuerten Konfiguration einer prozessorgesteuerten Schaltung die im Zusammenhang mit den Figuren 10 und 11 aufgezeigten Vorteile: Zur Generierung der Ausgangs-Sequenz sind (hier) nur drei Prozessoren und ein einziger Programmspeicher (für den Teilfolgen-Algorithmus-Wert "•1,5"; abgesehen von den Anfangswerten der Teilfolgen) zur Erzeugung der Teilfolgen erforderlich.

In Fig. 8 ist die Darstellung einer Ausgangs-Sequenz mit einem periodisch wirkenden Algorithmus gezeigt, dessen Werte komplexe, unterprogramm-ähnliche, arithmetische Operationen darstellen. Außerdem ist eine Aufgliederung der Ausgangs-Sequenz in Dreier-Teilfolgen mit zugehörigen Dreier-Teilfolgen-Algorithmen gezeigt.

Die Ausgangs-Sequenz

C1; C2; C3; C4; C5; C6; ...

hat die Werte

1,000; 3,313; 2,978; 1,091; 3,386; 3,466; ...

Der Algorithmus der Ausgangs-Sequenz

A1; A2; A4; A4; A5; A6; ...

hat die Werte (diese schließen wieder die Operatoren und die Operanden mit ein)

$$\underline{(C1+\pi)\cdot 0,8;\ (C2^2-8);\ \ln(C3);}\ \underline{(C4+\pi)\cdot 0,8;\ C5^2-8),\ \ln(C6),}$$

Die Werte der Ausgangs-Sequenz werden wie folgt gebildet:

C1 Anfangswert

$C2 = (C1 + \pi) \cdot 0,8$

$C3 = (C2^2 - 8)$

$C4 = \ln(C3)$

$C5 = (C4 + \pi) \cdot 0,8$

$C6 = (C5^2 - 8)$

$C7 = \ln(C6)$

etc.

Der Algorithmus der Ausgangs-Sequenz hat eine Periodizität von (P) = 3 entsprechend den drei in der horizontal verlaufenden Klammer stehenden Werte.

Entsprechend dieser Periodizitätszahl 3 erfolgt eine Aufgliederung in Dreier-Teilfolgen S1, S2, und S3 mit den jeweiligen Werten c1, c2, c3 etc.

In Analogie zu der bereits erwähnten Gesetzmäßigkeit wird der Teilfolgen-Algorithmen-Wert aus der Verknüpfung von A1, A2 und A3 (Werte der Ausgangs- Sequenz-Algorithmen-Periode) gebildet:

$$\ln\left[\{(C1 + \pi) \cdot 0,8)\}^2 - 8\right].$$

C1 muß in Anwendung auf die Teilfolgen durch c1 ersetzt werden. c1 ist wegen steigender c-Werte in den Teilfolgen (hier S1) allgemein zu formulieren als:

16

EP 0 591 562 A1

$$c_n = \ln [\{(c_{n-1} + \pi) \cdot 0{,}8\}^2 - 8] \qquad n = 2, 3, 4, 5, \ldots$$

Dieser vorstehende Teilfolgen-Algorithmen-Wert mit den komplexen arithmetischen Verknüpfungen hat die Besonderheit, daß die Abfolge der arithmetischen Verknüpfungen entsprechend zu berücksichtigen ist. Da die Teilfolge S2 mit C2 (= c1 in S2) beginnt, ist hier der Teilfolgen-Algorithmus-Wert (gemäß der jetzt mit A2 beginnenden Verknüpfung A2 / A3 / A1)

$$c_n = [\ln (c_{n-1}^2 - 8) + \pi] \cdot 0{,}8 \qquad n = 2, 3, 4, 5, \ldots$$

Analog gilt für den Teilfolgen-Algorithmus-Wert für die Teilfolge S3 (unter Berücksichtigung der Verknüpfungsfolge A3 / A1 / A2

$$cn = \{(\ln c_{n-1} + \pi) \cdot 0{,}8\}^2 - 8 \qquad n = 2, 3, 4, 5, \ldots$$

Auch in diesem Beispiel ergibt sich für eine programmtechnisch vollzogene Konfiguration einer prozessorgesteuerten Schaltung, daß zur Erzeugung der drei Teilfolgen neben drei Prozessoren nur ein einziger Programmspeicher zur Speicherung des (in diesem Beispiel sehr komplexen) Teilfolgen-Algorithmus-Werts erforderlich ist. Diesmal muß jedoch dieser Teilfolgen-Algorithmus-Wert teilfolgen-spezifisch angewendet werden, d. h. unter Berücksichtigung der Abfolge der aus den Werten der Ausgangs-Sequenz-Algorithmus-Periode abgeleiteten Verknüpfungen.

Dieses in Fig. 8 gezeigte Beispiel kann dahingehend verallgemeinert werden, daß die Werte von Ausgangs-Sequenzen-Algorithmen auch sehr komplexe arithmetische Verknüpfungen (unter Einbeziehung aller arithmetischer Operationen, wie Addieren, Subtrahieren, Multiplizieren, Dividieren, Logarithmieren) sein können. Solche komplexen Verknüpfungen können letztlich ganze Unterprogramme darstellen.

Bei Anwendungen, in denen Ausgangs-Sequenzen mit Hilfe solcher periodisch wirkender algorithmischen Verknüpfungen gebildet werden, läßt sich für den Fall der Bildung von x Teilfolgen (x = Anzahl der Werte in der Ausgangs-Sequenz-Algorithmus-Periode) eine prozessorgesteuerte Schaltung programmgesteuert optimal konfigurieren, durch welche letztlich die Ausgangs-Sequenz erzeugt wird.

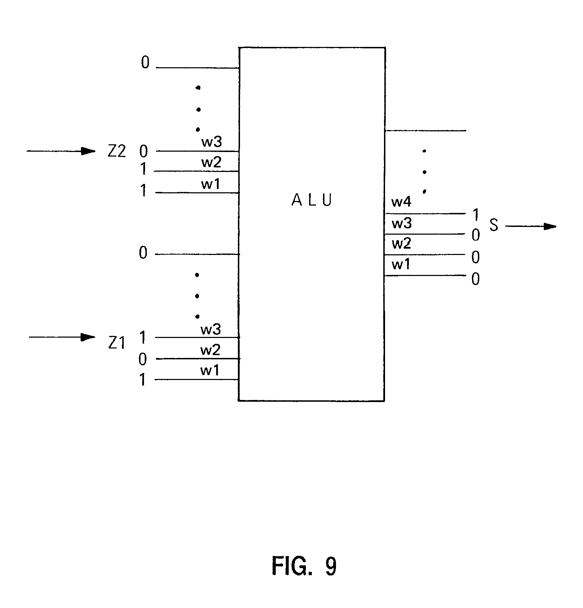

Fig. 9 zeigt die schematische Darstellung einer arithmetisch-logischen Einheit (ALU) zur Verknüpfung zweier in Binärdarstellung vorliegenden Zahlen Z1 0101 und Z2 0011. Die Binärwertstufen für die einzelnen Zahlen sind aufsteigend mit w1, w2, w3 etc. bezeichnet.

Das Ergebnis S 1000 der Verknüpfung (in diesem Beispiel soll es sich um eine Addition handeln) steht auf den ALU-Ausgangsleitungen mit den Binärwertstufen w1, w2, w3 etc. zur Verfügung.

In ALUs nach dem Stand der Technik beginnt die Verknüpfung zweier Zahlen auf deren unterster Wertstufe w1 unter Bildung eines möglichen Übertrages, der dann bei der nachfolgenden Verknüpfung der Werte für die nächsthöhere Wertstufe w2 mit zu berücksichtigen ist.

Auf diese Art und Weise entstehen bei der Verknüpfung von viele Binärstellen umfassenden Zahlen große zeitliche Verzögerungen. Sie sind dadurch bedingt, daß die Verknüpfung in einer höheren Wertstufe unter Einschluß eines eventuellen Übertrags erst erfolgen kann, wenn die Verknüpfung der niedrigeren Wertstufe abgeschlossen ist.

Nach dem Stand der Technik sind Lösungen (sogenannte Carry-Look-Ahead-Schaltungen) bekannt, die diese großen zeitlichen Verzögerungen einschränken. Eine solche Lösung ist im "MOTOROLA MECL Integrated Circuits", Series F 1989 auf den Seiten 2-77 und 2-81 wiedergegeben - sie beinhaltet nicht zeittaktgesteuerte Boolsche Verknüpfungen und bringt nur geringe Verkürzungen der zeitlichen Verzögerungen.

Bei der erfindungsgemäßen Schaltungstechnischen Ausgestaltung von arithmetisch-logischen Einheiten (ALUs) sorgen neue, vorteilhafte Verbesserungen für eine Verkürzung der Rechenzeit. Der Grund hierfür liegt in der Einsparung der Zeitverzögerunge, die sich bei üblichen ALUs durch Berücksichtigung der Überträge ergeben.

Fig. 10 zeigt eine schematische Darstellung einer in Sub-ALUs (AL1, AL2, AL3, AL4) aufgegliederten ALU. Jeder Sub-ALU ist eine Binärstelle der Zahl zugeordnet. Im Dualsystem hat die niedrigste Binärwertstelle den Wert $w1 = 2^0 = 1$; die nächsthöhere Binärwertstelle $w2 = 2^1 = 2$, gefolgt von $w3 = 2^2 = 4$, $w4 = 2^3 = 8$ etc.

Der Additionsvorgang für Z1 und Z2 beginnt mit der Addition in der Stelle niedrigster Wertigkeit w1. Ein dabei eventuell auftretender Übertrag wird im nachfolgenden Additionsvorgang für die Stelle mit der nächsthöheren Wertigkeit w2 berücksichtigt. Ein sich hier ergebender Übertrag wird wiederum bei der nächsten Addition für die dritte Stufe mit der Wertigkeit w3 berücksichtigt usw.

17

Hierdurch sind natürlich auch Wartezeiten bedingt, die aber mit Ausnahme einer Anlaufphase durch die in Fig. 10 gezeigte Schaltung vermieden werden.

Der AL2-Additionsvorgang erfolgt erst nach Abschluß des vorhergehenden AL1-Additionsvorgangs für die Operanden-Eingänge 1-1 und 1-2 der AL1 (Binär-Operanden "1" von Z1 und "0" von Z2). Ein dabei gegebenenfalls auftretender Übertrag wird auf der Leitung CA1 beim nachfolgenden AL2-Addditionsvorgang berücksichtigt.

Analoge Betrachtungen gelten für die Additionsvorgänge in den nachfolgenden Stufen steigender Wertigkeit.

Bei den einzelnen Sub-ALUs sind je nach Zuordnung zur Wertigkeit w1, w2, w2, w3 etc. den Operanden-Eingängen Register vorgeschaltet; je höher die Wertigkeit, je mehr Register. Andererseits sind den Ausgängen der Sub-ALUs je nach Zuordnung zur Wertigkeit Register nachgeschaltet; je niedriger die Wertigkeit, je mehr Register.

Diese Register sind für Additionsvorgänge aufeinanderfolgender Zahlen von besonderer Bedeutung, das heißt, wenn nach der Addition von Z1 und Z2 Additionen weiterer Zahlen (nicht dargestellt) folgen.

Für das in Fig. 10 wiedergegebene Beispiel sollen die aus <u>vier</u> Binärstellen bestehenden Zahlen

Z1 0 0 1 1 und

Z2 0 1 0 1

miteinander addiert werden.

Die Zahl vier bestimmt die Zahl der Sub-ALUs (AL1, AL2, AL3, AL4, also auch vier).

Die Sub-ALU AL1 hat

zwei Operanden-Eingänge: 1-2 für den Binärwert "1" der niedrigsten Wertstufe w1 der Zahl Z1 und 1-2 für den Binärwert 1 der niedrigsten Wertstufe w1 der Zahl Z2,

einen (zur Sub-ALU AL2 führenden) Übertragsausgang CA1 und

am Sub-ALU-Ausgang seriell nachgeschaltete Register R1-1, R1-2, R1-3 und R1-4 (die Zahl dieser Register entspricht wiederum der Anzahl der vier Binärstellen).

Den Operanden-Eingängen der Sub-ALU AL2 sind jeweils ein Register vorgeschaltet:

dem Operanden-Eingang für die Wertstufe w2 der Zahl Z1 ist dies das Register R2-1-1, für die Wertstufe w2 der Zahl Z2 ist dies das Register R2-2-1. Diesem Register R2-2-1 wird der Binärwert "0" der Wertstufe w2 der Zahl Z2 auf Leitung 2-2 zugeführt, während das Register R2-1-1 auf der Leitung 2-1 den Binärwert "1" der Zahl Z2 erhält. Die Übertragsleitung des Registers AL2 ist mit AL3 verbunden. Dem AL2-Ausgang sind die Register R2-1, R2-2 und R2-3 nachgeschaltet.

Für die der dritten Wertstufe w2 zugeordnet Sub-ALU AL3 sind dem AL3-Operanden-Eingang für die w3 Wertstufe von Z1 die Register R3-1-1 und R3-1-2 und von Z2 die Register R3-2-1 und R3-2-2 vorgeschaltet. Auf der Leitung 3-1 zu R3-1-1 liegt der Binärwert "0" von Z1, auf der Leitung 3-2 zu R3-2-1 liegt der Wert "1" von Z2 an. Die AL3-Übertragsleitung CA3 ist mit AL4 verbunden. Dem AL3-Ausgang sind die Register R3-1 und R3-2 nachgeschaltet.

Den Operanden-Eingängen von AL4 sind jeweils drei Register vorgeschaltet:

So wird der Binärwert "0" der w4-Wertstufe von Z1 auf der Leitung 4-1 über die Register R4-1-1, R4-1-2 und R4-1-3 dem einen Operanden-Eingang von AL4 zugeführt, während der Wert "0" der w4-Wertstufe von Z2 auf der Leitung 4-2 über die Register R4-2-1, R4-2-2 und R4-2-3 dem zweiten AL4-Operanden-Eingang zugeführt wird. Die Übertragsleitung von AL4 ist mit CA4 gekennzeichnet. Dem AL4-Ausgang ist das Register R4-1 nachgeschaltet.

Aus Übersichtsgründen wurde auf die Darstellung der Operationsleitung für die Art der Rechenvorgänge (Addieren, Subtrahieren, Multiplizieren, Dividieren etc.) verzichtet.

Die Register in Fig. 10 werden von links nach rechts zentral taktgesteuert, ebenso die Sub-ALUs in der Rechenfolge AL1, AL2, AL3, AL4. Dabei wird berücksichtigt, daß z. B. die AL2 erst dann eine Operation ausführt, wenn die der AL1 einschließlich der Übertragsbildung abgeschlossen ist. Analoge Betrachtungen gelten für AL3 bezüglich AL2 und AL4 bezüglich AL3.

Nachfolgend wird beschrieben, wie die Addition von Z1 und Z2 in den einzelnen Sub-ALU-Ebenen vollzogen wird:

Zu einem Startzeitpunkt stehen an den Leitungen 1-1, 2-1, 3-1 und 4-1 die Binärwert 1, 1, 0 , 0 von Z1 an und an den Leitungen 1-2, 2-2, 3-2 und 4-2 die Binärwerte 1, 0, 1, 0 von Z2.

In einem ersten Takt T1 wird

in der w1-Ebene von AL1 die Addition von "1" und "1" vollzogen,

in der w2-Ebene der Binärwert "1" ins Register R2-1-1 und der Binärwert "0" ins Register R2-2-1 gestellt,

in der w3-Ebene der Binärwert "0" ins Register R3-1-1 und der Binärwert 1 ins Register R3-2-1 gestellt,

in der w4-Ebene der Binärwert "0" ins Register R4-1-1 und der Binärwert "0" ins Register R4-2-1 gestellt.

Im nachfolgenden zweiten Takt T2 wird:

das vorhergehende AL1-Additionsergebnis ins Register R1-1 gestellt,

die Addition von "1" und "0" (diese Werte standen bis jetzt in R2-1-1 und R2-2-1) von AL2 vollzogen,

der Wert ("1") aus R3-1-1 ins Register R3-1-2 und der Wert ("1") aus Register R3-2-1 ins Register R3-2-2 gestellt,

der Wert ("0") aus R4-1-1 ins Register R4-1-2 und der Wert ("0") aus R4-2-1 ins Register R4-2-2 gestellt.

Während des Taktes T3 ergibt sich analog zum Vorhergehenden:

eine Verschiebung des Registerinhalts von R1-1 nach R1-2

eine Verschiebung des AL2-Additionsergebnisses in Register R2-1,

eine AL3-Addition der zuvor in den Registern R3-1-2 und R3-2-2 gespeicherten Werte, natürlich wie in anderen Ebenen unter Berücksichtigung eines eventuellen Übertrages aus der vorhergehenden Addition in der nächstniedrigeren Ebene, und eine Verschiebung des Registerinhalts von R4-1-2 nach R4-1-3 und von R4-2-3 nach R4-2-3 etc.

Nach dem fünften Takt T5 steht das Additionsergebnis von Z1 und Z2 entsprechend den Wertstufen w1, w2, w3, w4 und w5 in den Registern R1-4, R2-3, R3-2, R4-1 und (vereinfacht gesehen) auf der Leitung CA4 zur Verfügung. Auf dieses Ergebnis kann zeitparallel zugegriffen werden.

Die Vorteile der in Fig. 9 gezeigten Schaltung werden erst nach einer "Anlaufphase" z. B. für aufeinanderfolgende Additionen von Zahlen Z1 + Z2, Z3 + Z4, Z5 + Z6 etc. offenbar:

Mit jedem Takt werden in den w1, w2, w3 und w4-Ebenen die Binärwerte zweier Zahlen in den Registern verschoben bzw. miteinander verknüpft. Mit jedem Nachfolge-Takt folgen die Binärwerte nachfolgender Zahlen.

Da alle Sub-ALUs zeitgleich arbeiten, stehen nach jedem Zeittakt die Additionsergebnisse zeitparallel in den Registern R1-4, R2-3, R3-2 und R4-1 zur Verfügung.

Die Zeittakte können dabei so schnell aufeinander folgen, wie es die Verschiebung des Inhalts von einem Register ins andere bzw. die Übertragsbildung in einer Sub-ALU gestattet. Diese Taktfolge ist ungleich schneller als es bei üblichen arithmetisch-logischen Einheiten der Fall ist, bei denen es die Ergebnisbildung erfordert, nacheinander alle Übertragsbildungen von der niedrigsten bis zur höchsten Binärwertstufe abwarten zu müssen.

Auch diesbezügliche Verbesserungen, die bereits erwähnten Carry-Look-Ahead-Schaltungen sind nicht ausreichend, wenn es um höchste Geschwindigkeitsanforderungen an Prozessoren geht.

Die im Zusammenhang mit der Aufspaltung einer ALU gemachten Überlegungen lassen sich im übertragenen Sinne auch auf Binärzähler anwenden. Nach dem allgemein bekannten Stand der Technik treten auch hier Wartezeiten auf. Sie sind dadurch bedingt, daß das Ergebnis in einer nächsthöheren Wertstufe erst gebildet werden kann, wenn das Ergebnis der nächstniedrigeren, einschließlich eines eventuellen Übertragswerts, vorliegt.

Bei solchen Zählern läßt sich durch eine Aufspaltung in einzelne Sub-Zähler mit entsprechenden (Fig. 10) vor- und nachgeschalteten Registern für aufeinanderfolgende Zählvorgänge eine hohe Geschwindigkeitssteigerung erreichen.

Fig. 11 zeigt eine vereinfachte Darstellung eines Beispiels für eine Ausgangs-Sequenz mit einer Algorithmus-Periode von drei Werten in Verbindung mit drei Teilfolgen mit einer Teilfolgen-Algorithmus-Konstanten K = 3 sowie eine Darstellung einer drei Prozessoren umfassenden Schaltung zur Erzeugung der drei Unterfolgen für die Bildung der Ausgangs-Sequenz mit in den Ansprüchen 1 und in der Zusammenfassung gewählten Bezeichnungen.

Im oberen Teil der Darstellung ist die Ausgangs-Sequenz mit den Werten

7; 8; 12; 10; 11, 15; 13; 14; 18; ...

angegeben. Darunter (auf Lücke zwischen den Werten der Ausgangs-Sequenz) erscheinen die Werte des Algorithmus der Ausgangs-Sequenz

+1; +4; -2; -1; 4; -2; 1; 4; ...

Die ausgezogenen Linien zwischen den Werten der Ausgangs-Sequenz und dem Algorithmus deuten an, daß sich durch Addition eines Wertes der Ausgangs-Sequenz zum dazugehörigen Wert des Algorithmus der nächste Wert der Ausgangs-Sequenz ergibt, z. B.

7 + 1 = 8

8 + 4 = 12, etc.

Im darunterliegenden Teil der Darstellung sind links die Ausgangs-Sequenz-Werte

7; 8; 12; ... 18; ...

in Zuordnung zu den allgemeinen Bezeichnungen

C1; C2; C3; ... C18; ...

aufgeführt, während rechts die Werte des Algorithmus der Ausgangs-Sequenz mit

1; 4; -2; 1; 4; -2; 1; ...

in Zuordnung zu den allgemeinen Bezeichnungen

A1; A2; A3; A4; A5; ... A7; ..

angegeben sind.

Die Periodizität des Algorithmus ist durch die ausgezogene Klammer und die Angabe (P) = 3 gekennzeichnet. (P) = 3 bedeutet, daß die Periode drei Werte (hier 1; 4; -2) umfaßt.

Im mittleren Teil der Darstellung gemäß Fig. 7 ist die Aufteilung der Ausgangs-Sequenz in drei Teilfolgen

$S_1$ = 7; 10; 13; ...

$S_2$ = 8; 11; 14; ...

$S_3$ = 12; 15; 18; ...

mit den dazugehörigen Teilfolgen-Algorithmen

für S1 3; 3; 3; ...

für S2 3; 3; 3; ...

für S3 3; 3; 3; ...

gezeigt. Den Werten der Teilfolgen sind die allgemeinen Bezeichnungen

S1 = $s_{11}$; $s_{12}$; $s_{13}$; ...

S2 = $s_{21}$; $s_{22}$; $s_{23}$; ...

S3 = $s_{31}$; $s_{32}$; $s_{33}$; ...

und den Werten der zugehörigen Teilfolgen-Algorithmen sind die allgemeinen Bezeichnungen

für S1 $as_{11}$; $as_{12}$; $as_{13}$; ...

für S2 $as_{21}$; $as_{22}$; $as_{23}$; ...

für S3 $as_{31}$; $as_{32}$; $as_{33}$; ...

zugeordnet.

Im unteren Teil der Darstellung ist das Blockschaltbild einer Schaltung zur Erzeugung der Ausgangs-Sequenz aus den Anfangswerten der Teilfolgen und der Konstanten K = 3 als Wert aller Teilfolgen-Algorithmen gezeigt. Entsprechend (P) = 3 sind drei Prozessoren PROZ. 1 (90), PROZ. 2 (91) und PROZ. 3 (92) vorgesehen. Jedem Prozessor ist eine Teilfolge zugeordnet: dem Prozessor 1 die Teilfolge S1; dem Prozessor 2 die Teilfolge S2 und dem Prozessor 3 die Teilfolge S3. Jeder Prozessor bildet aus dem Anfangswert der ihm zugeordneten Teilfolge und aus der in einem Programmspeicher 93 gespeicherten Konstanten (K = 3) durch aufeinanderfolgende Additionen, gemäß

$$s_{12} + K = s_{13}$$
$$s_{13} + K = s_{14}$$
$$\cdot$$
$$\text{etc.}$$
$$s_{22} + K = s_{23}$$
$$s_{23} + K = s_{24}$$
$$\cdot$$
$$\text{etc.}$$
$$\text{und}$$
$$s_{32} + K = s_{33}$$
$$s_{33} + K = s_{34}$$
$$\cdot$$
$$\text{etc.}$$

die Teilfolgen S1, S2 und S3, welche über den Multiplexer 95 zur gewünschten Ausgangs-Sequenz zusammengeführt werden.

Zur zeitlichen Steuerung der Vorgänge ist eine mit dem Programmspeicher 93, den Prozessoren 90, 91 und 92 und dem Multiplexer 95 verbundene Zeitgeber-Schaltung 94 vorgesehen.

20

**Patentansprüche**

1. Computerprogrammgesteuertes Verfahren zur automatischen Optimierung einer prozessorgesteuerten Schaltung zur Generierung einer algorithmisch erzeugbaren Ausgangs-Sequenz von Werten

$$C1; C2; C3; C4; C5; C6; C7; C8; \ldots$$

dadurch gekennzeichnet,

daß für die Ausgangs-Sequenz ein Ausgangs-Sequenz-Algorithmus

$$A1; A2; A3; A4; A5; A6; A7; A8; \ldots$$

als eine Folge von Werten derart vorgegeben ist, daß die Ausgangs-Sequenz aus ihrem Anfangswert C1 und dem Ausgangs-Sequenz-Algorithmus gemäß

$$C2 = C1 + A1$$
$$C3 = C2 + A2$$
$$C4 = C3 + A3$$
$$C5 = C4 + A4$$

etc.

erzeugbar ist,

daß in dem Ausgangs-Sequenz-Algorithmus die Periode wiederkehrender Werte und daraus die Anzahl P der in dieser Periode auftretenden Werte bestimmt wird,

daß aus der Ausgangs-Sequenz P Teilfolgen

$$S_1 = s_{11}; \ s_{12}; \ s_{13}; \ s_{14}; \ \cdots$$
$$S_2 = s_{21}; \ s_{22}; \ s_{23}; \ s_{24}: \ \cdots$$
$$\vdots$$
$$S_p = s_{p1}; \ s_{p2}; \ s_{p3}; \ s_{p4}: \ \cdots$$

erzeugt werden, wobei die Werte der f-ten (f = 1, 2, 3, ... p) Teilfolge den jeweils (n • p + f)-ten Wert (n = 0, 1, 2, 3, ...) der Ausgangs-Sequenz darstellen, und daß für jede Teilfolge ein Teilfolgen-Algorithmus als eine Folge von Werten

$$as_{11}; \ as_{12}; \ as_{13}; \ as_{14}; \ \cdots$$
$$as_{21}; \ as_{22}; \ as_{23}; \ as_{24}; \ \cdots$$
$$\vdots$$
$$as_{p1}; \ as_{p2}; \ as_{p3}; \ as_{p4}; \ \cdots$$

derart gebildet wird, daß die Werte der Teilfolge aus deren Anfangswert und dem Teilfolgen-Algorithmus gemäß

$$s_{12} = s_{11} + as_{11} \qquad\qquad s_{p2} = s_{p1} + as_{p1}$$
$$s_{13} = s_{12} + as_{12} \quad \cdots \quad s_{p3} = s_{p2} + as_{p2}$$
$$s_{14} = s_{13} + as_{13} \qquad\qquad s_{p4} = s_{p3} + as_{p3}$$

erzeugbar sind, wobei die Werte aller Teilfolgen-Algorithmen für die P Teilfolgen denselben Wert als Konstante K aufweisen,

und daß

aus den programmgesteuert ermittelten Werten

P (Anzahl der in der Ausgangs-Sequenz-Algorithmus-Periode auftretenden Werte),

der Konstanten K,

und aus den programmgesteuert bestimmten Anfangswerten ($S_{11}$; $S_{21}$; ... $S_{p1}$) der Teilfolgen ($S_1$; $S_2$; ... $S_p$)

eine Multi-Prozessoren-Schaltung programmgesteuert derart konfiguriert wird,

daß eine der Zahl P entsprechende Anzahl von Prozessoren (90, 91, 92) aktiviert wird, von denen jeder eine von ihm zu erzeugenden Teilfolge (S1, S2, S3) zugeordnet ist und

von denen jeder unter anfänglicher Vorgabe des Anfangswerts ($s_{11}$, $s_{21}$, $s_{31}$) der ihm zugeordneten Teilfolge (S1, S2, S3) und unter Vorgabe der in einem allen Prozessoren gemeinsamen Programmspeicher (93) enthaltenen Konstante K durch aufeinanderfolgendes Aufaddieren von K zu dem vorhergehenden Wert der Teilfolge diese Teilfolge (S1, S2, S3) erzeugt, und daß

alle Teilfolgen über eine Multiplex-Schaltung (95) zu der Ausgangs-Sequenz (C1, C2, C3, ...) zusammengeführt werden.

**2.** Verfahren nach Anspruch 1, dadurch gekennzeichnet,

daß die Konstante K durch Summierung der positiven bzw. negativen Werte der Ausgangs-Sequenz-Algorithmus-Periode gebildet wird.

**3.** Computerprogrammgesteuertes Verfahren zur automatischen Optimierung einer prozessorgesteuerten Schaltung zur Generierung einer algorithmisch erzeugbaren Ausgangs-Sequenz von Werten

C1; C2; C3; C4; C5; C6; C7; C8; ...

dadurch gekennzeichnet,

daß für die Ausgangs-Sequenz ein Ausgangs-Sequenz-Algorithmus

A1; A2; A3; A4; A5; A6; A7; A8; ...

als eine Folge von Werten derart vorgegeben ist, daß die Ausgangs-Sequenz aus ihrem Anfangswert C1 und dem Ausgangs-Sequenz-Algorithmus gemäß

C2 = C1 + A1
C3 = C2 + A2
C4 = C3 + A3
C5 = C4 + A4
etc.

erzeugbar ist,

daß in dem Ausgangs-Sequenz-Algorithmus die Periode wiederkehrender Werte und daraus die Anzahl P der in dieser Periode auftretenden Werte bestimmt wird,

daß aus der Ausgangs-Sequenz r Teilfolgen (r < p)

$$S_1 = s_{11}; \ s_{12}; \ s_{13}; \ s_{14}; \ \cdots$$
$$S_2 = s_{21}; \ s_{22}; \ s_{23}; \ s_{24}; \ \cdots$$
$$\cdot$$
$$\cdot$$
$$\cdot$$
$$S_r = s_{r1}; \ s_{r2}; \ s_{r3}; \ s_{r4}; \ \cdots$$

erzeugt werden, wobei die Werte der v-ten (v = 1, 2, 3, ... r) Teilfolge den jeweils (n • r + v)-ten Wert (n = 0, 1, 2, 3, ...) der Ausgangs-Sequenz darstellen,

und daß für jede dieser Teilfolgen ein Teilfolgen-Algorithmus als eine Folge von Werten

$$as_{11}; \ as_{12}; \ as_{13}; \ as_{14}; \ \cdots$$
$$as_{21}; \ as_{22}; \ as_{23}; \ as_{24}; \ \cdots$$
$$\cdot$$
$$\cdot$$
$$\cdot$$
$$as_{r1}; \ as_{r2}; \ as_{r3}; \ as_{r4}; \ \cdots$$

derart gebildet wird, daß die Werte der Teilfolge aus deren Anfangswert und dem Teilfolge-Algorithmus gemäß

$$s_{12} = s_{11} + as_{11} \qquad\qquad s_{r2} = s_{r1} + as_{r1}$$
$$s_{13} = s_{12} + as_{12} \quad \cdots \quad s_{r3} = s_{r2} + as_{r2}$$
$$s_{14} = s_{13} + as_{13} \qquad\qquad s_{r4} = s_{r3} + as_{r3}$$

erzeugbar sind,

und daß für jeden Teilfolgen-Algorithmus die Periode wiederkehrender Werte bestimmt wird, und für den Fall, daß die Perioden in allen Teilfolgen-Algorithmen identisch sind und mehr als einen Wert umfassen, aus den programmgesteuert bestimmten Anfangswerten ($s_{11}$; $s_{21}$; ... $s_{r1}$) der Teilfolgen ($S_1$; $S_2$; ... $S_r$), der Anzahl der Teilfolgen, den Werten der Teilfolgen-Algorithmus-Periode und der Position der Teilfolgen-Periode in der Teilfolge eine Multi-Prozessoren-Schaltung programmgesteuert derart konfiguriert wird,

daß eine der Zahl r entsprechende Anzahl von Prozessoren aktiviert wird, von denen jeder einer von ihm zu erzeugenden Teilfolge zugeordnet ist, und daß allen Prozessoren ein gemeinsamer Programmspeicher zugeordnet ist zur Speicherung der Werte der Periode des Teilfolgen-Algorithmus und der Anfangswerte der Teilfolgen,

und daß jeder Prozessor aus dem Anfangswert der ihm zugeordneten Teilfolge und aus den Teilfolgen-Algorithmus-Perioden-Werten die Teilfolge generiert, und

daß alle Teilfolgen über eine Multiplex-Schaltung zu der Ausgangs-Sequenz zusammengeführt werden.

**4.** Verfahren nach Anspruch 3, dadurch gekennzeichnet, daß

der gemeinsame Programmspeicher für die Periodenwerte aus einer Reihe miteinander verbundener Register (59 bis 68) besteht, deren Anzahl mindestens aus der Anzahl der in der Periode enthaltenen Werte besteht,

daß in jedem Register ein Wert der Periode gespeichert ist, und

daß jeder Prozessor (54; 55; 56) mit einer Registerstufe verbunden ist und die in den Registerstufen gespeicherten Werte bei der Erzeugung der Teilfolgen in den Registerstufen zyklisch umlaufen.

**5.** Verfahren nach Anspruch 4, dadurch gekennzeichnet, daß

bei einer gegenseitigen Verschiebung der Teilfolgen-Algorithmen-Periode in den Teilfolgen-Algorithmen die den Teilfolgen zugeordneten Prozessoren (54; 55; 56) mit einer anderen Registerstufe (59; 66; 63) zur Berücksichtigung dieser Verschiebung bei der Erzeugung der Teilfolgen verbunden sind.

**6.** Computerprogrammgesteuertes Verfahren zur automatischen Optimierung einer prozessorgesteuerten Schaltung zur Generierung einer algorithmisch erzeugbaren Ausgangs-Sequenz von Werten

C1; C2; C3; C4; C5; C6; C7; C8; ...

dadurch gekennzeichnet,

daß für die Ausgangs-Sequenz ein Ausgangs-Sequenz-Algorithmus

A1; A2; A3; A4; A5; A6; A7; A8; ...

als eine Folge von Termen beliebiger arithmetischer Verknüpfung (Verkn.) derart vorgegeben ist, daß die Ausgangs-Sequenz aus ihrem Anfangswert C1 und den Termen des Ausgangs-Sequenz-Algorithmus gemäß

C2 = C1 in Verknüpfung mit A1
C3 = C2 in Verknüpfung mit A2
C4 = C3 in Verknüpfung mit A3
C5 = C4 in Verknüpfung mit A4
etc.

erzeugbar ist,

daß in dem Ausgangs-Sequenz-Algorithmus die Periode wiederkehrender Termen und daraus die Anzahl P der in dieser Periode auftretenden Termen bestimmt wird,

daß aus der Ausgangs-Sequenz P Teilfolgen

$$S_1 = s_{11}; \; s_{12}; \; s_{13}; \; s_{14}; \; \cdots$$
$$S_2 = s_{21}; \; s_{22}; \; s_{23}; \; s_{24}: \; \cdots$$
$$\cdot$$
$$\cdot$$
$$\cdot$$
$$S_p = s_{p1}; \; s_{p2}; \; s_{p3}; \; s_{p4}: \; \cdots$$

erzeugt werden, wobei die Werte der f-ten (f = 1, 2, 3, ... p) Teilfolge den jeweils (n • p + f)-ten Wert (n = 0, 1, 2, 3, ...) der Ausgangs-Sequenz darstellen,

und daß für jede Teilfolge ein Teilfolgen-Algorithmus als eine Folge von Termen

$$as_{11}; \; as_{12}; \; as_{13}; \; as_{14}; \; \cdots$$
$$as_{21}; \; as_{22}; \; as_{23}; \; as_{24}; \; \cdots$$
$$\cdot$$
$$\cdot$$
$$\cdot$$
$$as_{p1}; \; as_{p2}; \; as_{p3}; \; as_{p4}; \; \cdots$$

derart gebildet wird, daß die Werte der Teilfolge aus deren Anfangswert und dem Teilfolgen-Algorithmus gemäß

$$s_{12} = s_{11} \text{ in Verkn. mit } as_{11} \qquad s_{p2} = s_{p1} \text{ in Verkn. mit } as_{p1}$$
$$s_{13} = s_{12} \text{ in Verkn. mit } as_{12} \quad \cdots \quad s_{p3} = s_{p2} \text{ in Verkn. mit } as_{p2}$$
$$s_{14} = s_{13} \text{ in Verkn. mit } as_{13} \qquad s_{p4} = s_{p3} \text{ in Verkn. mit } as_{p3}$$

erzeugbar sind, wobei die Termen aller Teilfolgen-Algorithmen für die P Teilfolgen gleich sind oder wobei die Termen T eines Teilfolgen-Algorithmus gleich sind und der Term jedes Teilfolgen-Algorithmus aus dem Term des Teilfolgen-Algorithmus T ableitbar ist,

und daß aus den programmgesteuert ermittelten Werten

P (Anzahl der im Ausgangs-Sequenz-Algorithmus auftretenden Termen),

dem Teilfolgen-Algorithmus-Term,

und aus den programmgesteuert bestimmten Anfangswerten ($s_{11}$; $s_{21}$; ... $s_{p1}$) der Teilfolgen ($S_1$; $S_2$; ... $S_p$)

eine Multi-Prozessoren-Schaltung programmgesteuert derart konfiguriert wird,

daß eine der Zahl P entsprechende Anzahl von Prozessoren (90, 91, 92) aktiviert wird, von denen jeder eine von ihm zu erzeugenden Teilfolge (S1, S2, S3) zugeordnet ist und

von denen jeder unter anfänglicher Vorgabe des Anfangswerts ($s_{11}$, $s_{21}$, $s_{31}$) der ihm zugeordneten Teilfolge (S1, S2, S3) und unter Vorgabe der in einem allen Prozessoren gemeinsamen Programmspeicher (93) enthaltenen Teilfolgen-Algorithmus-Term in Verknüpfung mit dem vorhergehenden Wert der Teilfolge diese Teilfolge (S1, S2, S3) erzeugt, und daß

alle Teilfolgen über eine Multiplex-Schaltung (95) zu der Ausgangs-Sequenz (C1, C2, C3, ...) zusammengeführt werden.

7. Verfahren nach Anspruch 6, dadurch gekennzeichnet,

daß der allen Teilfolgen-Algorithmen gemeinsame Term durch Verknüpfung der Terme der Ausgangs-Sequenz-Algorithmus-Periode gebildet wird.

**8.** Verfahren nach einem der Ansprüche 1, 3 oder 6, dadurch gekennzeichnet, daß
die als arithmetisch-logische Einheiten (ALU) ausgebildeten Prozessoren einen Zwischenspeicher für
das Ergebnis aufweisen.

**9.** Anordnung zur programmgesteuerten Konfigurierung einer prozessorgesteuerten Schaltung zur Erzeugung einer periodisch algorithmisch bildbaren Ausgangs-Sequenz von Werten
C1; C2; C3; C4; C5; C6; etc. ...
gekennzeichnet durch
eine Anzahl p von zu aktivierenden Prozessoren (90, 91, 92) und
durch einen allen Prozessoren gemeinsamen Programmspeicher (93) zur Speicherung einer Konstanten
oder eines mathematisch beschreibbaren Terms
und durch eine Multiplex-Schaltung (95) wobei
jeder Prozessor (9) einer aus der Konstanten bzw. dem mathematisch beschreibbaren Term und dem
Anfangswert ($s_{11}$, $s_{21}$, $s_{31}$) einer Teilfolge (S1, S2, S3) zu bildenden Teilfolge von Werten zugeordnet
ist,
alle Teilfolgen über die Multiplex-Schaltung (95) zur Ausgangs-Sequenz zusammenführbar sind und
p die Anzahl der Werte in der Algorithmus-Periode der Ausgangs-Sequenz ist.

**10.** Anordnung zur programmgesteuerten Konfiguration einer prozessorgesteuerten Schaltung zur Erzeugung einer periodisch-algorithmisch erzeugbaren Ausgangs-Sequenz von Werten
C1; C2; C3; C4; C5; C6; etc.
gekennzeichnet durch
eine Anzahl von r zu aktivierenden Prozessoren und durch einen allen Prozessoren gemeinsamen
Programmspeicher zur Speicherung der Werte einer Teilfolgen-Algorithmus-Periode und einer Multiplex-Schaltung, wobei
jeder Prozessor einer aus einer Teilfolgen-Algorithmus-Periode und dem Anfangswert einer Teil folge
zu bildenden Teilfolge zugeordnet ist, alle Teilfolgen über die Multilex-Schaltung zur Ausgangs-
Sequenz zusammenführbar sind und
r die Anzahl der aus der Ausgangs-Sequenz bildbaren Teilfolgen mit einer allen Teilfolgen gemeinsamen mehrere Werte umfassenden Teilfolgen-Algorithmus-Periode ist.

**11.** Anordnung nach Anspruch 10, dadurch gekennzeichnet,
daß der gemeinsame Programmspeicher aus in Reihe geschalteten Registern (59 bis 68) zur Aufnahme
und zum zyklischen Umlauf der Werte der Teilfolgen-Algorithmus-Periode besteht und daß jeder
Prozessor (54, 55, 56) mit einem Register verbunden ist.

**12.** Arithmetisch-logische Einheit (ALU) zur Durchführung von arithmetischen Operationen für in K Stellen
(K = 1, 2, 3, 4, ...) in Binärwerten vorliegenden Zahlen (Operanden), gekennzeichnet durch Aufspaltung
der ALU in K Sub-ALUs (AL1, AL2, AL3, AL4), von denen jede einer Binärwertstelle der Zahlen in der
Reihenfolge aufsteigender Stellenwertigkeit (w1, w2, w3, w4) zugeordnet ist,
daß den Operanden-Eingängen jeder n-ten Sub-ALU (n = 1, 2, 3, ..., K) (n - 1) Register (z. B. R3-2-1,
R3-2-2) vor- und dem Ausgang jeder n-ten Sub-ALU (K - (n - 1)) Register (z. B. R3-1, R3-2)
nachgeschaltet sind,
daß der Übertrags-Ausgang (z. B. CA3) der n-ten Sub-ALU (z. B. AL3) mit einem Übertrags-Eingang der
(N + 1)-ten Sub-ALU (z. B. AL4) verbunden ist.

**13.** Binärzähler mit Binärstufen, gekennzeichnet durch
Aufspaltung in K Sub-Stufen, von denen jede einer Binärwertstelle in der Reihenfolge aufsteigender
Stellenwertigkeit zugeordnet ist,
daß dem Operanden-Eingang jeder n-ten Sub-Stufe (n = 1, 2, 3, ..., K) (n - 1) Register vor- und dem
Ausgang jeder n-ten Sub-Stufe (K - (n - 1)) Register nachgeschaltet sind,
daß der Übertrags-Ausgang der n-ten Sub-Stufe mit einem Übertrags-Eingang der (N + 1)-ten Sub-
Stufe verbunden ist.

**14.** Verfahren nach einem der Ansprüche 1 bis 8, gekennzeichnet durch
seine Anwendung zur Erzeugung von Adreßfolgen zum Austesten von Speicherprodukten und logischen Schaltungen.

AUSGANGS-
SEQUENZ :

ALGORITHMUS :

**FIG. 1A**

AUSGANGS-
SEQUENZ:       1 ; 3 ; 2 ; 4 ; 5 ; 6 ; 7 ; 9 ; 8 ; 10 ; 11 ;   ...

ALGORITHMUS :    +2  -1  +2  +1  +1  +1   +2  -1  +2  -1  ....

RESULTIERENDE
PERIODIZITÄT
(P)=6

**FIG. 1B**

PROZESSOR 1 --> 1; 7;13; ...        FÜR 6 TEILFOLGEN ERGIBT
PROZESSOR 2 --> 3; 9;15; ...        SICH IN DIESEM BEISPIEL
PROZESSOR 3 --> 2; 8;14; ...        EIN ADDITIONSWERT VON
PROZESSOR 4 --> 4;10;16; ... -->    A=6 FÜR DIE BILDUNG DER
PROZESSOR 5 --> 5;11;17; ...        TEILFOLGEN AUS IHREM
PROZESSOR 6 --> 6;12;18; ...        AUSGANGSWERT.

**FIG. 1C**

**FIG. 1D**

26

AUSGANGS-
SEQUENZ

ALGORITHMUS :

FIG. 2A

ZWEIER-TEILFOLGEN

1. TEILFOLGE　　　　-------------->

ALGORITHMUS DAFÜR　-------------->

2. TEILFOLGE　　　　-------------->

ALGORITHMUS DAFÜR　-------------->

FIG. 2B

25 — ZEITGEBER—SCHALTUNG FÜR ZEITLICHE
KOORDINIERUNG DER SEQUENZEN

22　　　　　　　　　20

1 — SPEICHER 1　　PROZESSOR 1　　1; 2; 5; ...

ANFANGS-
WERTE DER
TEILFOLGEN

23　　　　　　　　　21

3 — SPEICHER 2　　PROZESSOR 2　　3; 4; 6; ...

24

MULTI-
PLEXER　　AUSGANGS-
SEQUENZ

FIG. 2C

27

| 0 | 16 | 32 | 48 | 64 | 80 | 96 | 112 | 128 | 144 | 160 | 176 | 192 | 208 | 224 |
|---|----|----|----|----|----|----|-----|-----|-----|-----|-----|-----|-----|-----|
| 1 | 17 | 33 | 49 | 65 | 81 | 97 | 113 | 129 | 145 | 161 | 177 | 193 | 209 | 225 |
| 2 | 18 | 34 | 50 | 66 | 82 | 98 | 114 | 130 | 146 | 162 | 178 | 194 | 210 | 226 |
| 3 | 19 | 35 | 51 | 67 | 83 | 99 | 115 | 131 | 147 | 163 | 179 | 195 | 211 | 227 |
| 4 | 20 | 36 | 52 | 68 | 84 | 100 | 116 | 132 | 148 | 164 | 180 | 196 | 212 | 228 |
| 5 | 21 | 37 | 53 | 69 | 85 | 101 | 117 | 133 | 149 | 165 | 181 | 197 | 213 | 229 |
| 6 | 22 | 38 | 54 | 70 | 86 | 102 | 118 | 134 | 150 | 166 | 182 | 198 | 214 | 230 |
| 7 | 23 | 39 | 55 | 71 | 87 | 103 | 119 | 135 | 151 | 167 | 183 | 199 | 215 | 231 |
| 8 | 24 | 40 | 56 | 72 | 88 | 104 | 120 | 136 | 152 | 168 | 184 | 200 | 216 | 232 |
| 9 | 25 | 41 | 57 | 73 | 89 | 105 | 121 | 137 | 153 | 169 | 185 | 201 | 217 | 233 |
| 10 | 26 | 42 | 58 | 74 | 90 | 106 | 122 | 138 | 154 | 170 | 186 | 202 | 218 | 234 |
| 11 | 27 | 43 | 59 | 75 | 91 | 107 | 123 | 139 | 155 | 171 | 187 | 203 | 219 | 235 |
| 12 | 28 | 44 | 60 | 76 | 92 | 108 | 124 | 140 | 156 | 172 | 188 | 204 | 220 | 236 |
| 13 | 29 | 45 | 61 | 77 | 93 | 109 | 125 | 141 | 157 | 173 | 189 | 205 | 221 | 237 |
| 14 | 30 | 46 | 62 | 78 | 94 | 110 | 126 | 142 | 158 | 174 | 190 | 206 | 222 | 238 |
| 15 | 31 | 47 | 63 | 79 | 95 | 111 | 127 | 143 | 159 | 175 | 191 | 207 | 223 | 239 |

FIG. 3A

AUSGANGS-SEQUENZ

0 ; 1 ; 2 ; 3 ; 64 ; 65 ; 66 ; 67 ; 4 ; 5 ; 6 ; 7 ; 68 ; 69 ; 70 ; 71 ; 8

+1 +1 +1 +61 +1 +1 +1 -63 +1 +1 +1 +68 +1 +1 +1 -63

ALGORITHMUS

| AUSGANGS-SEQUENZ | | | | | | | | | | | |
|----|----|----|----|----|----|----|----|----|-----|-----|-----|
| C1 | C2 | C3 | C4 | C5 | C6 | C7 | C8 | C9 | C10 | C11 | C12 |
| 0 | 1 | 2 | 3 | 64 | 65 | 66 | 67 | 4 | 5 | 6 | 7 |

| ALGORITHMUS | | | | | | | | | | | |
|----|----|----|----|----|----|----|-----|----|-----|-----|-----|
| A1 | A2 | A3 | A4 | A5 | A6 | A7 | A8 | A9 | A10 | A11 | A12 |
| 1 | 1 | 1 | 61 | 1 | 1 | 1 | -63 | 1 | 1 | 1 | 61 |

PERIODIZITÄT (P) = 8

FIG. 3B

ZWEIER-TEILFOLGEN:

| | c1 | c2 | c3 | c4 | c5 | c6 | c7 | c8 | c9 | c10 | c11 | c12 |
|----|----|----|----|----|----|----|----|----|----|-----|-----|-----|
| S1 | 0 | 2 | 64 | 66 | 4 | 6 | 68 | 70 | 8 | 10 | 72 | 74 |
| S2 | 1 | 3 | 65 | 67 | 5 | 7 | 69 | 71 | 9 | 11 | 73 | 75 |

ZWEIER-TEILFOLGEN-ALGORITHMEN

| a1 | a2 | a3 | a4 | a5 | a6 | a7 | a8 | a9 | a10 | a11 | a12 | a13 |
|----|----|----|----|----|----|----|----|----|-----|-----|-----|-----|
| 2 | 62 | 2 | -62 | 2 | 62 | 2 | -62 | 2 | 62 | 2 | -62 | 2 |
| 2 | 62 | 2 | -62 | 2 | 62 | 2 | -62 | 2 | 62 | 2 | -62 | 2 |

PERIODIZITÄT (P) = 4
ANZAHL VERSCH. PERIODEN = 1

FIG. 3C

DREIER-TEILFOLGEN:

| | c1 | c2 | c3 | c4 | c5 | c6 | c7 | c8 | c9 | c10 | c11 | c12 |
|----|----|----|----|----|----|----|----|----|----|-----|-----|-----|
| S1 | 0 | 3 | 66 | 5 | 68 | 71 | 10 | 73 | 12 | 15 | 78 | 17 |
| S2 | 1 | 64 | 67 | 6 | 69 | 8 | 11 | 74 | 13 | 76 | 79 | 18 |
| S3 | 2 | 65 | 4 | 7 | 70 | 9 | 72 | 75 | 14 | 77 | 16 | 19 |

DREIER-TEILFOLGEN-ALGORITHMEN

| a1 | a2 | a3 | a4 | a5 | a6 | a7 | a8 | a9 | a10 | a11 | a12 | a13 |
|----|----|----|----|----|----|----|----|----|-----|-----|-----|-----|
| 3 | 63 | -61 | 63 | 3 | -61 | 63 | -61 | 3 | 63 | -61 | 63 | 3 |
| 63 | 3 | -61 | 63 | -61 | 3 | 63 | -61 | 63 | 3 | -61 | 63 | -61 |
| 63 | -61 | 3 | 63 | -61 | 63 | 3 | -61 | 63 | -61 | 3 | 63 | -61 |

PERIODIZITÄT (P) = 8
ANZAHL VERSCH. PERIODEN = 1

FIG. 3D

VIERER-TEILFOLGEN:

| | c1 | c2 | c3 | c4 | c5 | c6 | c7 | c8 | c9 | c10 | c11 | c12 |
|----|----|----|----|----|----|----|----|----|----|-----|-----|-----|
| S1 | 0 | 64 | 4 | 68 | 8 | 72 | 12 | 76 | 16 | 80 | 20 | 84 |
| S2 | 1 | 65 | 5 | 69 | 9 | 73 | 13 | 77 | 17 | 81 | 21 | 85 |
| S3 | 2 | 66 | 6 | 70 | 10 | 74 | 14 | 78 | 18 | 82 | 22 | 86 |
| S4 | 3 | 67 | 7 | 71 | 11 | 75 | 15 | 79 | 19 | 83 | 23 | 87 |

VIERER-TEILFOLGEN-ALGORITHMEN

| a1 | a2 | a3 | a4 | a5 | a6 | a7 | a8 | a9 | a10 | a11 | a12 | a13 |
|----|----|----|----|----|----|----|----|----|-----|-----|-----|-----|
| 64 | -60 | 64 | -60 | 64 | -60 | 64 | -60 | 64 | -60 | 64 | -60 | 64 |
| 64 | -60 | 64 | -60 | 64 | -60 | 64 | -60 | 64 | -60 | 64 | -60 | 64 |
| 64 | -60 | 64 | -60 | 64 | -60 | 64 | -60 | 64 | -60 | 64 | -60 | 64 |
| 64 | -60 | 64 | -60 | 64 | -60 | 64 | -60 | 64 | -60 | 64 | -60 | 64 |

PERIODIZITÄT (P) = 2
ANZAHL VERSCH. PERIODEN = 1

FIG. 3E

## FÜNFER-TEILFOLGEN:

| | c1 | c2 | c3 | c4 | c5 | c6 | c7 | c8 | c9 | c10 | c11 | c12 |
|---|---|---|---|---|---|---|---|---|---|---|---|---|
| S1 | 0 | 65 | 6 | 71 | 72 | 13 | 78 | 19 | 20 | 85 | 26 | 91 |
| S2 | 1 | 66 | 7 | 8 | 73 | 14 | 79 | 80 | 21 | 86 | 27 | 28 |
| S3 | 2 | 67 | 68 | 9 | 74 | 15 | 16 | 81 | 22 | 87 | 88 | 29 |
| S4 | 3 | 4 | 69 | 10 | 75 | 76 | 17 | 82 | 23 | 24 | 89 | 30 |
| S5 | 64 | 5 | 70 | 11 | 12 | 77 | 18 | 83 | 84 | 25 | 90 | 31 |

## FÜNFER-TEILFOLGEN-ALGORITHMEN

| a1 | a2 | a3 | a4 | a5 | a6 | a7 | a8 | a9 | a10 | a11 | a12 | a13 |
|---|---|---|---|---|---|---|---|---|---|---|---|---|
| 65 | -59 | 65 | 1 | -59 | 65 | -59 | 1 | 65 | -59 | 65 | 1 | -59 |
| 65 | -59 | 1 | 65 | -59 | 65 | 1 | -59 | 65 | -59 | 1 | 65 | -59 |
| 65 | 1 | -59 | 65 | -59 | 1 | 65 | -59 | 65 | 1 | -59 | 65 | -59 |
| 1 | 65 | -59 | 65 | 1 | -59 | 65 | -59 | 1 | 65 | -59 | 65 | 1 |
| -59 | 65 | -59 | 1 | 65 | -59 | 65 | 1 | -59 | 65 | -59 | 1 | 65 |

PERIODIZITÄT (P) = 8
ANZAHL VERSCH. PERIODEN = 1

## FIG. 3F

## SECHSER-TEILFOLGEN:

| | c1 | c2 | c3 | c4 | c5 | c6 | c7 | c8 | c9 | c10 | c11 | c12 |
|---|---|---|---|---|---|---|---|---|---|---|---|---|
| S1 | 0 | 66 | 68 | 10 | 12 | 78 | 80 | 22 | 24 | 90 | 92 | 34 |
| S2 | 1 | 67 | 69 | 11 | 13 | 79 | 81 | 23 | 25 | 91 | 93 | 35 |
| S3 | 2 | 4 | 70 | 72 | 14 | 16 | 82 | 84 | 26 | 28 | 94 | 96 |
| S4 | 3 | 5 | 71 | 73 | 15 | 17 | 83 | 85 | 27 | 29 | 95 | 97 |
| S5 | 64 | 6 | 8 | 74 | 76 | 18 | 20 | 86 | 88 | 30 | 32 | 98 |
| S6 | 65 | 7 | 9 | 75 | 77 | 19 | 21 | 87 | 89 | 31 | 33 | 99 |

## SECHSER-TEILFOLGEN-ALGORITHMEN

| a1 | a2 | a3 | a4 | a5 | a6 | a7 | a8 | a9 | a10 | a11 | a12 | a13 |
|---|---|---|---|---|---|---|---|---|---|---|---|---|
| 66 | 2 | -58 | 2 | 66 | 2 | -58 | 2 | 66 | 2 | -58 | 2 | 66 |
| 66 | 2 | -58 | 2 | 66 | 2 | -58 | 2 | 66 | 2 | -58 | 2 | 66 |
| 2 | 66 | 2 | -58 | 2 | 66 | 2 | -58 | 2 | 66 | 2 | -58 | 2 |
| 2 | 66 | 2 | -58 | 2 | 66 | 2 | -58 | 2 | 66 | 2 | -58 | 2 |
| -58 | 2 | 66 | 2 | -58 | 2 | 66 | 2 | -58 | 2 | 66 | 2 | -58 |
| -58 | 2 | 66 | 2 | -58 | 2 | 66 | 2 | -58 | 2 | 66 | 2 | -58 |

PERIODIZITÄT (P) = 4
ANZAHL VERSCH. PERIODEN = 1

## FIG. 3G

## SIEBENER-TEILFOLGEN:

| | c1 | c2 | c3 | c4 | c5 | c6 | c7 | c8 | c9 | c10 | c11 | c12 |
|---|---|---|---|---|---|---|---|---|---|---|---|---|
| S1 | 0 | 67 | 70 | 73 | 76 | 19 | 22 | 25 | 28 | 95 | 98 | 101 |
| S2 | 1 | 4 | 71 | 74 | 77 | 80 | 23 | 26 | 29 | 32 | 99 | 102 |
| S3 | 2 | 5 | 8 | 75 | 78 | 81 | 84 | 27 | 30 | 33 | 36 | 103 |
| S4 | 3 | 6 | 9 | 12 | 79 | 82 | 85 | 88 | 31 | 34 | 37 | 40 |
| S5 | 64 | 7 | 10 | 13 | 16 | 83 | 86 | 89 | 92 | 35 | 38 | 41 |
| S6 | 65 | 68 | 11 | 14 | 17 | 20 | 87 | 90 | 93 | 96 | 39 | 42 |
| S7 | 66 | 69 | 72 | 15 | 18 | 21 | 24 | 91 | 94 | 97 | 100 | 43 |

## SIEBENER-TEILFOLGEN-ALGORITHMEN

| a1 | a2 | a3 | a4 | a5 | a6 | a7 | a8 | a9 | a10 | a11 | a12 | a13 |
|---|---|---|---|---|---|---|---|---|---|---|---|---|
| 67 | 3 | 3 | 3 | -57 | 3 | 3 | 3 | 67 | 3 | 3 | 3 | -57 |
| 3 | 67 | 3 | 3 | 3 | -57 | 3 | 3 | 3 | 67 | 3 | 3 | 3 |
| 3 | 3 | 67 | 3 | 3 | 3 | -57 | 3 | 3 | 3 | 67 | 3 | 3 |
| 3 | 3 | 3 | 67 | 3 | 3 | 3 | -57 | 3 | 3 | 3 | 67 | 3 |
| -57 | 3 | 3 | 3 | 67 | 3 | 3 | 3 | -57 | 3 | 3 | 3 | 67 |
| 3 | -57 | 3 | 3 | 3 | 67 | 3 | 3 | 3 | -57 | 3 | 3 | 3 |
| 3 | 3 | -57 | 3 | 3 | 3 | 67 | 3 | 3 | 3 | -57 | 3 | 3 |

PERIODIZITÄT (P) = 8
ANZAHL VERSCH. PERIODEN = 1

FIG. 3H

## ACHTER-TEILFOLGEN:

| | c1 | c2 | c3 | c4 | c5 | c6 | c7 | c8 | c9 | c10 | c11 | c12 |
|---|---|---|---|---|---|---|---|---|---|---|---|---|
| S1 | 0 | 4 | 8 | 12 | 16 | 20 | 24 | 28 | 32 | 36 | 40 | 44 |
| S2 | 1 | 5 | 9 | 13 | 17 | 21 | 25 | 29 | 33 | 37 | 41 | 45 |
| S3 | 2 | 6 | 10 | 14 | 18 | 22 | 26 | 30 | 34 | 38 | 42 | 46 |
| S4 | 3 | 7 | 11 | 15 | 19 | 23 | 27 | 31 | 35 | 39 | 43 | 47 |
| S5 | 64 | 68 | 72 | 76 | 80 | 84 | 88 | 92 | 96 | 100 | 104 | 108 |
| S6 | 65 | 69 | 73 | 77 | 81 | 85 | 89 | 93 | 97 | 101 | 105 | 109 |
| S7 | 66 | 70 | 74 | 78 | 82 | 86 | 90 | 94 | 98 | 102 | 106 | 110 |
| S8 | 67 | 71 | 75 | 79 | 83 | 87 | 91 | 95 | 99 | 103 | 107 | 111 |

## ACHTER-TEILFOLGEN-ALGORITHMEN

| a1 | a2 | a3 | a4 | a5 | a6 | a7 | a8 | a9 | a10 | a11 | a12 | a13 |
|---|---|---|---|---|---|---|---|---|---|---|---|---|
| 4 | 4 | 4 | 4 | 4 | 4 | 4 | 4 | 4 | 4 | 4 | 4 | 4 |
| 4 | 4 | 4 | 4 | 4 | 4 | 4 | 4 | 4 | 4 | 4 | 4 | 4 |
| 4 | 4 | 4 | 4 | 4 | 4 | 4 | 4 | 4 | 4 | 4 | 4 | 4 |
| 4 | 4 | 4 | 4 | 4 | 4 | 4 | 4 | 4 | 4 | 4 | 4 | 4 |
| 4 | 4 | 4 | 4 | 4 | 4 | 4 | 4 | 4 | 4 | 4 | 4 | 4 |
| 4 | 4 | 4 | 4 | 4 | 4 | 4 | 4 | 4 | 4 | 4 | 4 | 4 |
| 4 | 4 | 4 | 4 | 4 | 4 | 4 | 4 | 4 | 4 | 4 | 4 | 4 |
| 4 | 4 | 4 | 4 | 4 | 4 | 4 | 4 | 4 | 4 | 4 | 4 | 4 |

PERIODIZITÄT (P) = 1
ANZAHL VERSCH. PERIODEN = 1

FIG. 3I

NEUNER-TEILFOLGEN:

|    | c1 | c2 | c3 | c4 | c5 | c6 | c7 | c8 | c9 | c10 | c11 | c12 |
|----|----|----|----|----|----|----|----|----|----|-----|-----|-----|
| S1 | 0  | 5  | 10 | 15 | 80 | 85 | 90 | 95 | 36 | 41  | 46  | 51  |
| S2 | 1  | 6  | 11 | 76 | 81 | 86 | 91 | 32 | 37 | 42  | 47  | 112 |
| S3 | 2  | 7  | 72 | 77 | 82 | 87 | 28 | 33 | 38 | 43  | 108 | 113 |
| S4 | 3  | 68 | 73 | 78 | 83 | 24 | 29 | 34 | 39 | 104 | 109 | 114 |
| S5 | 64 | 69 | 74 | 79 | 20 | 25 | 30 | 35 | 100 | 105 | 110 | 115 |
| S6 | 65 | 70 | 75 | 16 | 21 | 26 | 31 | 96 | 101 | 106 | 111 | 52 |
| S7 | 66 | 71 | 12 | 17 | 22 | 27 | 92 | 97 | 102 | 107 | 48  | 53 |
| S8 | 67 | 8  | 13 | 18 | 23 | 88 | 93 | 98 | 103 | 44  | 49  | 54 |
| S9 | 4  | 9  | 14 | 19 | 84 | 89 | 94 | 99 | 40 | 45  | 50  | 55 |

NEUNER-TEILFOLGEN-ALGORITHMEN

|    | a1 | a2 | a3 | a4 | a5 | a6 | a7 | a8 | a9 | a10 | a11 | a12 |
|----|----|----|----|----|----|----|----|----|----|-----|-----|-----|
| S1 | 5  | 5  | 5  | 65 | 5  | 5  | 5  | -59 | 5 | 5   | 5   | 65  |
| S2 | 5  | 5  | 65 | 5  | 5  | 5  | -59 | 5 | 5  | 5   | 65  | 5   |
| S3 | 5  | 65 | 5  | 5  | 5  | -59 | 5 | 5  | 5  | 65  | 5   | 5   |
| S4 | 65 | 5  | 5  | 5  | -59 | 5 | 5  | 5  | 65 | 5   | 5   | 5   |
| S5 | 5  | 5  | 5  | -59 | 5 | 5  | 5  | 65 | 5  | 5   | 5   | -59 |
| S6 | 5  | 5  | -59 | 5 | 5  | 5  | 65 | 5  | 5  | 5   | -59 | 5   |
| S7 | 5  | -59 | 5 | 5  | 5  | 65 | 5  | 5  | 5  | -59 | 5   | 5   |
| S8 | -59 | 5 | 5  | 5  | 65 | 5  | 5  | 5  | -59 | 5  | 5   | 5   |
| S9 | 5  | 5  | 5  | 65 | 5  | 5  | 5  | -59 | 5 | 5   | 5   | 65  |

PERIODIZITÄT (P) = 8
ANZAHL VERSCH. PERIODEN = 1

FIG. 3J

ZEHNER-TEILFOLGEN:

|     | c1 | c2 | c3 | c4 | c5 | c6 | c7 | c8 | c9 | c10 | c11 | c12 |
|-----|----|----|----|----|----|----|----|----|----|-----|-----|-----|
| S1  | 0  | 6  | 72 | 78 | 20 | 26 | 92 | 98 | 40 | 46  | 112 | 118 |
| S2  | 1  | 7  | 73 | 79 | 21 | 27 | 93 | 99 | 41 | 47  | 113 | 119 |
| S3  | 2  | 68 | 74 | 16 | 22 | 88 | 94 | 36 | 42 | 108 | 114 | 56  |
| S4  | 3  | 69 | 75 | 17 | 23 | 89 | 95 | 37 | 43 | 109 | 115 | 57  |
| S5  | 64 | 70 | 12 | 18 | 84 | 90 | 32 | 38 | 104 | 110 | 52 | 58  |
| S6  | 65 | 71 | 13 | 19 | 85 | 91 | 33 | 39 | 105 | 111 | 53 | 59  |
| S7  | 66 | 8  | 14 | 80 | 86 | 28 | 34 | 100 | 106 | 48 | 54 | 120 |
| S8  | 67 | 9  | 15 | 81 | 87 | 29 | 35 | 101 | 107 | 49 | 55 | 121 |
| S9  | 4  | 10 | 76 | 82 | 24 | 30 | 96 | 102 | 44 | 50  | 116 | 122 |
| S10 | 5  | 11 | 77 | 83 | 25 | 31 | 97 | 103 | 45 | 51  | 117 | 123 |

ZEHNER-TEILFOLGEN-ALGORITHMEN

|     | a1 | a2 | a3 | a4 | a5 | a6 | a7 | a8 | a9 | a10 | a11 | a12 |
|-----|----|----|----|----|----|----|----|----|----|-----|-----|-----|
| S1  | 6  | 66 | 6  | -58 | 6 | 66 | 6  | -58 | 6 | 66  | 6   | -58 |
| S2  | 6  | 66 | 6  | -58 | 6 | 66 | 6  | -58 | 6 | 66  | 6   | -58 |
| S3  | 66 | 6  | -58 | 6 | 66 | 6  | -58 | 6 | 66 | 6   | -58 | 6   |
| S4  | 66 | 6  | -58 | 6 | 66 | 6  | -58 | 6 | 66 | 6   | -58 | 6   |
| S5  | 6  | -58 | 6 | 66 | 6  | -58 | 6 | 66 | 6  | -58 | 6   | 66  |
| S6  | 6  | -58 | 6 | 66 | 6  | -58 | 6 | 66 | 6  | -58 | 6   | 66  |
| S7  | -58 | 6 | 66 | 6  | -58 | 6 | 66 | 6  | -58 | 6  | 66  | 6   |
| S8  | -58 | 6 | 66 | 6  | -58 | 6 | 66 | 6  | -58 | 6  | 66  | 6   |
| S9  | 6  | 66 | 6  | -58 | 6 | 66 | 6  | -58 | 6 | 66  | 6   | -58 |
| S10 | 6  | 66 | 6  | -58 | 6 | 66 | 6  | -58 | 6 | 66  | 6   | -58 |

PERIODIZITÄT (P) = 4
ANZAHL VERSCH. PERIODEN = 1

FIG. 3K

| 0 | 16 | 32 | 48 | 64 | 80 | 96 | 112 | 128 | 144 | 160 | 176 | 192 | 208 | 224 |
|---|----|----|----|----|----|----|-----|-----|-----|-----|-----|-----|-----|-----|
| 1 | 17 | 33 | 49 | 65 | 81 | 97 | 113 | 129 | 145 | 161 | 177 | 193 | 209 | 225 |
| 2 | 18 | 34 | 50 | 66 | 82 | 98 | 114 | 130 | 146 | 162 | 178 | 194 | 210 | 226 |
| 3 | 19 | 35 | 51 | 67 | 83 | 99 | 115 | 131 | 147 | 163 | 179 | 195 | 211 | 227 |
| 4 | 20 | 36 | 52 | 68 | 84 | 100 | 116 | 132 | 148 | 164 | 180 | 196 | 212 | 228 |
| 5 | 21 | 37 | 53 | 69 | 85 | 101 | 117 | 133 | 149 | 165 | 181 | 197 | 213 | 229 |
| 6 | 22 | 38 | 54 | 70 | 86 | 102 | 118 | 134 | 150 | 166 | 182 | 198 | 214 | 230 |
| 7 | 23 | 39 | 55 | 71 | 87 | 103 | 119 | 135 | 151 | 167 | 183 | 199 | 215 | 231 |
| 8 | 24 | 40 | 56 | 72 | 88 | 104 | 120 | 136 | 152 | 168 | 184 | 200 | 216 | 232 |
| 9 | 25 | 41 | 57 | 73 | 89 | 105 | 121 | 137 | 153 | 169 | 185 | 201 | 217 | 233 |
| 10 | 26 | 42 | 58 | 74 | 90 | 106 | 122 | 138 | 154 | 170 | 186 | 202 | 218 | 234 |
| 11 | 27 | 43 | 59 | 75 | 91 | 107 | 123 | 139 | 155 | 171 | 187 | 203 | 219 | 235 |
| 12 | 28 | 44 | 60 | 76 | 92 | 108 | 124 | 140 | 156 | 172 | 188 | 204 | 220 | 236 |
| 13 | 29 | 45 | 61 | 77 | 93 | 109 | 125 | 141 | 157 | 173 | 189 | 205 | 221 | 237 |
| 14 | 30 | 46 | 62 | 78 | 94 | 110 | 126 | 142 | 158 | 174 | 190 | 206 | 222 | 238 |
| 15 | 31 | 47 | 63 | 79 | 95 | 111 | 127 | 143 | 159 | 175 | 191 | 207 | 223 | 239 |

FIG. 4A

AUSGANGS-SEQUENZ

17 ; 0 ; 16 ; 32 ; 33 ; 34 ; 18 ; 2 ; 1 ; 17 ; 33 ; 16 ; 32 ; 48 ; 49 ; 50 ; 34 ; 18 ; 17

-17 +16 +16 +1 +1 -16 -16 -1 +16 +15 -17 +16 +16 +1 +1 -16 -16 -1

ALGORITHMUS

PERIODIZITÄT (P) = 10
ANZAHL VERSCH. PERIODEN = 1

| AUSGANGS-SEQUENZ | | | | | | | | | | | |
|------|-----|-----|-----|-----|-----|-----|-----|-----|------|------|------|
| C1 | C2 | C3 | C4 | C5 | C6 | C7 | C8 | C9 | C10 | C11 | C12 |
| 17 | 0 | 16 | 32 | 33 | 34 | 18 | 2 | 1 | 17 | 33 | 16 |

| ALGORITHMUS | | | | | | | | | | | |
|------|-----|-----|-----|-----|-----|-----|-----|-----|------|------|------|
| A1 | A2 | A3 | A4 | A5 | A6 | A7 | A8 | A9 | A10 | A11 | A12 |
| -17 | 16 | 16 | 1 | 1 | -16 | -16 | -1 | 16 | 15 | -17 | 16 |

PERIODIZITÄT (P) = 10

FIG. 4B

ZWEIER-TEILFOLGEN:

| | c1 | c2 | c3 | c4 | c5 | c6 | c7 | c8 | c9 | c10 | c11 | c12 |
|----|----|----|----|----|----|----|----|----|----|----|----|----|
| S1 | 17 | 16 | 33 | 18 | 1 | 33 | 32 | 49 | 34 | 17 | 49 | 48 |
| S2 | 0 | 32 | 34 | 2 | 17 | 16 | 48 | 50 | 18 | 33 | 32 | 64 |

ZWEIER-TEILFOLGEN-ALGORITHMEN

| | a1 | a2 | a3 | a4 | a5 | a6 | a7 | a8 | a9 | a10 | a11 | a12 | a13 |
|----|----|----|----|----|----|----|----|----|----|----|----|----|----|
| | -1 | 17 | -15 | -17 | 32 | -1 | 17 | -15 | -17 | 32 | -1 | 17 | -15 |
| | 32 | 2 | -32 | 15 | -1 | 32 | 2 | -32 | 15 | -1 | 32 | 2 | -32 |

PERIODIZITÄT (P) = 5
ANZAHL VERSCH. PERIODEN = 2

**FIG. 4C**

DREIER-TEILFOLGEN:

| | c1 | c2 | c3 | c4 | c5 | c6 | c7 | c8 | c9 | c10 | c11 | c12 |
|----|----|----|----|----|----|----|----|----|----|----|----|----|
| S1 | 17 | 32 | 18 | 17 | 32 | 50 | 17 | 32 | 65 | 34 | 65 | 80 |
| S2 | 0 | 33 | 2 | 33 | 48 | 34 | 33 | 48 | 66 | 33 | 48 | 81 |
| S3 | 16 | 34 | 1 | 16 | 49 | 18 | 49 | 64 | 50 | 49 | 64 | 82 |

DREIER-TEILFOLGEN-ALGORITHMEN

| | a1 | a2 | a3 | a4 | a5 | a6 | a7 | a8 | a9 | a10 | a11 | a12 | a13 |
|----|----|----|----|----|----|----|----|----|----|----|----|----|----|
| | 15 | -14 | -1 | 15 | 18 | -33 | 15 | 33 | -31 | 31 | 15 | -14 | -1 |
| | 33 | -31 | 31 | 15 | -14 | -1 | 15 | 18 | -33 | 15 | 33 | -31 | 31 |
| | 18 | -33 | 15 | 33 | -31 | 31 | 15 | -14 | -1 | 15 | 18 | -33 | 15 |

PERIODIZITÄT (P) = 10
ANZAHL VERSCH. PERIODEN = 1

**FIG. 4D**

VIERER-TEILFOLGEN:

| | c1 | c2 | c3 | c4 | c5 | c6 | c7 | c8 | c9 | c10 | c11 | c12 |
|----|----|----|----|----|----|----|----|----|----|----|----|----|
| S1 | 17 | 33 | 1 | 32 | 34 | 49 | 65 | 33 | 64 | 66 | 81 | 97 |
| S2 | 0 | 34 | 17 | 48 | 18 | 32 | 66 | 49 | 80 | 50 | 64 | 98 |
| S3 | 16 | 18 | 33 | 49 | 17 | 48 | 50 | 65 | 81 | 49 | 80 | 82 |
| S4 | 32 | 2 | 16 | 50 | 33 | 64 | 34 | 48 | 82 | 65 | 96 | 66 |

VIERER-TEILFOLGEN-ALGORITHMEN

| | a1 | a2 | a3 | a4 | a5 | a6 | a7 | a8 | a9 | a10 | a11 | a12 | a13 |
|----|----|----|----|----|----|----|----|----|----|----|----|----|----|
| | 16 | -32 | 31 | 2 | 15 | 16 | -32 | 31 | 2 | 15 | 16 | -32 | 31 |
| | 34 | -17 | 31 | -30 | 14 | 34 | -17 | 31 | -30 | 14 | 34 | -17 | 31 |
| | 2 | 15 | 16 | -32 | 31 | 2 | 15 | 16 | -32 | 31 | 2 | 5 | 26 |
| | -30 | 14 | 34 | -17 | 31 | -30 | 14 | 34 | -17 | 31 | -30 | 14 | 34 |

PERIODIZITÄT (P) = 5
ANZAHL VERSCH. PERIODEN = 2

**FIG. 4E**

FÜNFER-TEILFOLGEN:

|    | c1 | c2 | c3 | c4 | c5 | c6 | c7 | c8 | c9 | c10 | c11 | c12 |
|----|----|----|----|----|----|----|----|----|----|-----|-----|-----|
| S1 | 17 | 34 | 33 | 50 | 49 | 66 | 65 | 82 | 81 | 98  | 97  | 114 |
| S2 | 0  | 18 | 16 | 34 | 32 | 50 | 48 | 66 | 64 | 82  | 80  | 98  |
| S3 | 16 | 2  | 32 | 18 | 48 | 34 | 64 | 50 | 80 | 66  | 96  | 82  |
| S4 | 32 | 1  | 48 | 17 | 64 | 33 | 80 | 49 | 96 | 65  | 112 | 81  |
| S5 | 33 | 17 | 49 | 33 | 65 | 49 | 81 | 65 | 97 | 81  | 113 | 97  |

FÜNFER-TEILFOLGEN-ALGORITHMEN

|    | a1  | a2 | a3  | a4 | a5  | a6 | a7  | a8 | a9  | a10 | a11 | a12 | a13 |
|----|-----|----|-----|----|-----|----|-----|----|-----|-----|-----|-----|-----|
| S1 | 17  | -1 | 17  | -1 | 17  | -1 | 17  | -1 | 17  | -1  | 17  | -1  | 17  |
| S2 | 18  | -2 | 18  | -2 | 18  | -2 | 18  | -2 | 18  | -2  | 18  |     |     |
| S3 | -14 | 30 | -14 | 30 | -14 | 30 | -14 | 30 | -14 | 30  | -14 |     |     |
| S4 | -31 | 47 | -31 | 47 | -31 | 47 | -31 | 47 | -31 | 47  | -31 |     |     |
| S5 | -16 | 32 | -16 | 32 | -16 | 32 | -16 | 32 | -16 | 32  | -16 |     |     |

PERIODIZITÄT (P) = 2
ANZAHL VERSCH. PERIODEN = 5

FIG. 4F

SECHSER-TEILFOLGEN:

|    | c1 | c2 | c3 | c4 | c5 | c6 | c7 | c8 | c9  | c10 | c11 | c12 |
|----|----|----|----|----|----|----|----|----|-----|-----|-----|-----|
| S1 | 17 | 18 | 32 | 17 | 65 | 65 | 66 | 80 | 65  | 113 | 113 | 114 |
| S2 | 0  | 2  | 48 | 33 | 66 | 48 | 50 | 96 | 81  | 114 | 96  | 98  |
| S3 | 16 | 1  | 49 | 49 | 50 | 64 | 49 | 97 | 97  | 98  | 112 | 97  |
| S4 | 32 | 17 | 50 | 32 | 34 | 80 | 65 | 98 | 80  | 82  | 128 | 113 |
| S5 | 33 | 33 | 34 | 48 | 33 | 81 | 81 | 82 | 96  | 81  | 129 | 129 |
| S6 | 34 | 16 | 18 | 64 | 49 | 82 | 64 | 66 | 112 | 97  | 130 | 112 |

SECHSER-TEILFOLGEN-ALGORITHMEN

|    | a1  | a2 | a3  | a4  | a5  | a6  | a7 | a8  | a9  | a10 | a11 | a12 | a13 |
|----|-----|----|-----|-----|-----|-----|----|-----|-----|-----|-----|-----|-----|
| S1 | 1   | 14 | -15 | 48  | 0   | 1   | 14 | -15 | 48  | 0   | 1   | 14  | -15 |
| S2 | 2   | 46 | -15 | 33  | -18 | 2   | 46 | -15 | 33  | -18 | 2   | 46  | -15 |
| S3 | -15 | 48 | 0   | 1   | 14  | -15 | 48 | 0   | 1   | 14  | -15 | 48  | 0   |
| S4 | -15 | 33 | -18 | 2   | 46  | -15 | 33 | -18 | 2   | 46  | -15 | 33  | -18 |
| S5 | 0   | 1  | 14  | -15 | 48  | 0   | 1  | 14  | -15 | 48  | 0   | 1   | 14  |
| S6 | -18 | 2  | 46  | -15 | 33  | -18 | 2  | 46  | -15 | 33  | -18 | 2   | 46  |

PERIODIZITÄT (P) = 5
ANZAHL VERSCH. PERIODEN = 2

FIG. 4G

SIEBENER-TEILFOLGEN:

| | c1 | c2 | c3 | c4 | c5 | c6 | c7 | c8 | c9 | c10 | c11 | c12 |
|---|---|---|---|---|---|---|---|---|---|---|---|---|
| S1 | 17 | 2 | 49 | 32 | 33 | 82 | 80 | 81 | 98 | 128 | 129 | 114 |
| S2 | 0 | 1 | 50 | 48 | 49 | 66 | 96 | 97 | 82 | 129 | 112 | 113 |
| S3 | 16 | 17 | 34 | 64 | 65 | 50 | 97 | 80 | 81 | 130 | 128 | 129 |
| S4 | 32 | 33 | 18 | 65 | 48 | 49 | 98 | 96 | 97 | 114 | 144 | 145 |
| S5 | 33 | 16 | 17 | 66 | 64 | 65 | 82 | 112 | 113 | 98 | 145 | 128 |
| S6 | 34 | 32 | 33 | 50 | 80 | 81 | 66 | 113 | 96 | 97 | 146 | 144 |
| S7 | 18 | 48 | 49 | 34 | 81 | 64 | 65 | 114 | 112 | 113 | 130 | 160 |

FIG. 4H

SIEBENER-TEILFOLGEN-ALGORITHMEN

| a1 | a2 | a3 | a4 | a5 | a6 | a7 | a8 | a9 | a10 | a11 | a12 | a13 |
|---|---|---|---|---|---|---|---|---|---|---|---|---|
| -15 | 47 | -17 | 1 | 49 | -2 | 1 | 17 | 30 | 1 | -15 | 47 | -17 |
| 1 | 49 | -2 | 1 | 17 | 30 | 1 | -15 | 47 | -17 | 1 | 49 | -2 |
| 1 | 17 | 30 | 1 | -15 | 47 | -17 | 1 | 49 | -2 | 1 | 17 | 30 |
| 1 | -15 | 47 | -17 | 1 | 49 | -2 | 1 | 17 | 30 | 1 | -15 | 47 |
| -17 | 1 | 49 | -2 | 1 | 17 | 30 | 1 | -15 | 47 | -17 | 1 | 49 |
| -2 | 1 | 17 | 30 | 1 | -15 | 47 | -17 | 1 | 49 | -2 | 1 | 17 |
| 30 | 1 | -15 | 47 | -17 | 1 | 49 | -2 | 1 | 17 | 30 | 1 | -15 |

PERIODIZITÄT (P) = 10
ANZAHL VERSCH. PERIODEN = 1 [1]

ACHTER-TEILFOLGEN:

| | c1 | c2 | c3 | c4 | c5 | c6 | c7 | c8 | c9 | c10 | c11 | c12 |
|---|---|---|---|---|---|---|---|---|---|---|---|---|
| S1 | 17 | 1 | 34 | 65 | 64 | 81 | 65 | 98 | 129 | 128 | 145 | 129 |
| S2 | 0 | 17 | 18 | 66 | 80 | 64 | 81 | 82 | 130 | 144 | 128 | 145 |
| S3 | 16 | 33 | 17 | 50 | 81 | 80 | 97 | 81 | 114 | 145 | 144 | 161 |
| S4 | 32 | 16 | 33 | 34 | 82 | 96 | 80 | 97 | 98 | 146 | 160 | 144 |
| S5 | 33 | 32 | 49 | 33 | 66 | 97 | 96 | 113 | 97 | 130 | 161 | 160 |
| S6 | 34 | 48 | 32 | 49 | 50 | 98 | 112 | 96 | 113 | 114 | 162 | 176 |
| S7 | 18 | 49 | 48 | 65 | 49 | 82 | 113 | 112 | 129 | 113 | 146 | 177 |
| S8 | 2 | 50 | 64 | 48 | 65 | 66 | 114 | 128 | 112 | 119 | 130 | 178 |

FIG. 4I

ACHTER-TEILFOLGEN-ALGORITHMEN

| a1 | a2 | a3 | a4 | a5 | a6 | a7 | a8 | a9 | a10 | a11 | a12 | a13 |
|---|---|---|---|---|---|---|---|---|---|---|---|---|
| -16 | 33 | 31 | -1 | 17 | -16 | 33 | 31 | -1 | 17 | -16 | 33 | 31 |
| 17 | 1 | 48 | 14 | -16 | 17 | 1 | 48 | 14 | -16 | 17 | 1 | 48 |
| 17 | -16 | 33 | 31 | -1 | 17 | -16 | 33 | 31 | -1 | 17 | -16 | 33 |
| -16 | 17 | 1 | 48 | 14 | -16 | 17 | 1 | 48 | 14 | -16 | 17 | 1 |
| -1 | 17 | -16 | 33 | 31 | -1 | 17 | -16 | 33 | 31 | -1 | 17 | -16 |
| 14 | -16 | 17 | 1 | 48 | 14 | -16 | 17 | 1 | 48 | 14 | -16 | 17 |
| 31 | -1 | 17 | -16 | 33 | 31 | -1 | 17 | -16 | 33 | 31 | -1 | 17 |
| 48 | 14 | -16 | 17 | 1 | 48 | 14 | -16 | 7 | 11 | 48 | 14 | -16 |

PERIODIZITÄT (P) = 5
ANZAHL VERSCH. PERIODEN = 2

## NEUNER-TEILFOLGEN:

| | c1 | c2 | c3 | c4 | c5 | c6 | c7 | c8 | c9 | c10 | c11 | c12 |
|---|---|---|---|---|---|---|---|---|---|---|---|---|
| S1 | 17 | 17 | 17 | 34 | 66 | 98 | 113 | 128 | 128 | 128 | 161 | 161 |
| S2 | 0 | 33 | 33 | 33 | 50 | 82 | 114 | 129 | 144 | 144 | 144 | 177 |
| S3 | 16 | 16 | 49 | 49 | 49 | 66 | 98 | 130 | 145 | 160 | 160 | 160 |
| S4 | 32 | 32 | 32 | 65 | 65 | 65 | 82 | 114 | 146 | 161 | 176 | 176 |
| S5 | 33 | 48 | 48 | 48 | 81 | 81 | 81 | 98 | 130 | 162 | 177 | 192 |
| S6 | 34 | 49 | 64 | 64 | 64 | 97 | 97 | 97 | 114 | 146 | 178 | 193 |
| S7 | 18 | 50 | 65 | 80 | 80 | 80 | 113 | 113 | 113 | 130 | 162 | 194 |
| S8 | 2 | 34 | 66 | 81 | 96 | 96 | 96 | 129 | 129 | 129 | 146 | 178 |
| S9 | 1 | 18 | 50 | 82 | 97 | 112 | 112 | 112 | 145 | 145 | 145 | 162 |

## NEUNER-TEILFOLGEN-ALGORITHMEN

| | a1 | a2 | a3 | a4 | a5 | a6 | a7 | a8 | a9 | a10 | a11 | a12 | a13 |
|---|---|---|---|---|---|---|---|---|---|---|---|---|---|
| S1 | 0 | 0 | 17 | 32 | 32 | 15 | 15 | 0 | 0 | 33 | 0 | 0 | 17 |
| S2 | 33 | 0 | 0 | 17 | 32 | 32 | 15 | 15 | 0 | 0 | 33 | 0 | 0 |
| S3 | 0 | 33 | 0 | 0 | 17 | 32 | 32 | 15 | 15 | 0 | 0 | 33 | 0 |
| S4 | 0 | 0 | 33 | 0 | 0 | 17 | 32 | 32 | 15 | 15 | 0 | 0 | 33 |
| S5 | 15 | 0 | 0 | 33 | 0 | 0 | 17 | 32 | 32 | 15 | 15 | 0 | 0 |
| S6 | 15 | 15 | 0 | 0 | 33 | 0 | 0 | 17 | 32 | 32 | 15 | 15 | 0 |
| S7 | 32 | 15 | 15 | 0 | 0 | 33 | 0 | 0 | 17 | 32 | 32 | 15 | 15 |
| S8 | 32 | 32 | 15 | 15 | 0 | 0 | 33 | 0 | 0 | 17 | 32 | 32 | 15 |
| S9 | 17 | 32 | 32 | 15 | 15 | 0 | 0 | 33 | 0 | 0 | 17 | 32 | 32 |

PERIODIZITÄT (P) = 10
ANZAHL VERSCH. PERIODEN = 1

FIG. 4J

## ZEHNER-TEILFOLGEN:

| | c1 | c2 | c3 | c4 | c5 | c6 | c7 | c8 | c9 | c10 | c11 | c12 |
|---|---|---|---|---|---|---|---|---|---|---|---|---|
| S1 | 17 | 33 | 49 | 65 | 81 | 97 | 113 | 129 | 145 | 161 | 177 | 193 |
| S2 | 0 | 16 | 32 | 48 | 64 | 80 | 96 | 112 | 128 | 144 | 160 | 176 |
| S3 | 16 | 32 | 48 | 64 | 80 | 96 | 112 | 128 | 144 | 160 | 176 | 192 |
| S4 | 32 | 48 | 64 | 80 | 96 | 112 | 128 | 144 | 160 | 176 | 192 | 208 |
| S5 | 33 | 49 | 65 | 81 | 97 | 113 | 129 | 145 | 161 | 177 | 193 | 209 |
| S6 | 34 | 50 | 66 | 82 | 98 | 114 | 130 | 146 | 162 | 178 | 194 | 210 |
| S7 | 18 | 34 | 50 | 66 | 82 | 98 | 114 | 130 | 146 | 162 | 178 | 194 |
| S8 | 2 | 18 | 34 | 50 | 66 | 82 | 98 | 114 | 130 | 146 | 162 | 178 |
| S9 | 1 | 17 | 33 | 49 | 65 | 81 | 97 | 113 | 129 | 145 | 161 | 177 |
| S10 | 17 | 33 | 49 | 65 | 81 | 97 | 113 | 129 | 145 | 161 | 177 | 193 |

## ZEHNER-TEILFOLGEN-ALGORITHMEN

| | a1 | a2 | a3 | a4 | a5 | a6 | a7 | a8 | a9 | a10 | a11 | a12 | |
|---|---|---|---|---|---|---|---|---|---|---|---|---|---|
| S1 | 16 | 16 | 16 | 16 | 16 | 16 | 16 | 16 | 16 | 16 | 16 | 16 | 16 |
| S2 | 16 | 16 | 16 | 16 | 16 | 16 | 16 | 16 | 16 | 16 | 16 | 16 | 16 |
| S3 | 16 | 16 | 16 | 16 | 16 | 16 | 16 | 16 | 16 | 16 | 16 | 16 | 16 |
| S4 | 16 | 16 | 16 | 16 | 16 | 16 | 16 | 16 | 16 | 16 | 16 | 16 | 16 |
| S5 | 16 | 16 | 16 | 16 | 16 | 16 | 16 | 16 | 16 | 16 | 16 | 16 | 16 |
| S6 | 16 | 16 | 16 | 16 | 16 | 16 | 16 | 16 | 16 | 16 | 16 | 16 | 16 |
| S7 | 16 | 16 | 16 | 16 | 16 | 16 | 16 | 16 | 16 | 16 | 16 | 16 | 16 |
| S8 | 16 | 16 | 16 | 16 | 16 | 16 | 16 | 16 | 16 | 16 | 16 | 16 | 16 |
| S9 | 16 | 16 | 16 | 16 | 16 | 16 | 16 | 16 | 16 | 16 | 16 | 16 | 16 |
| S10 | 16 | 16 | 16 | 16 | 16 | 16 | 16 | 16 | 16 | 16 | 16 | 16 | 16 |

PERIODIZITÄT (P) = 1
ANZAHL VERSCH. PERIODEN = 1

FIG. 4K

AUSGANGS-SEQUENZ

| C1 | C2 | C3 | C4 | C5 | C6 | C7 | C8 | C9 | C10 | C11 | C12 |
|----|----|----|----|----|----|----|----|----|-----|-----|-----|
| 17 | 0 | 16 | 32 | 33 | 34 | 18 | 2 | 1 | 17 | 33 | 16 |

ALGORITHMUS

| A1 | A2 | A3 | A4 | A5 | A6 | A7 | A8 | A9 | A10 | A11 | A12 |
|----|----|----|----|----|----|----|----|----|-----|-----|-----|
| -17 | 16 | 16 | 1 | 1 | -16 | -16 | -1 | 16 | 16 | -17 | 16 | 16 |

PERIODIZITÄT (P) = 10

DREIER-TEILFOLGEN:

| | c1 | c2 | c3 | c4 | c5 | c6 | c7 | c8 | c9 | c10 | c11 | c12 |
|----|----|----|----|----|----|----|----|----|----|-----|-----|-----|
| S1 | 17 | 32 | 18 | 17 | 32 | 50 | 17 | 32 | 65 | 34 | 65 | 80 |
| S2 | 0 | 33 | 2 | 33 | 48 | 34 | 33 | 48 | 66 | 33 | 48 | 81 |
| S3 | 16 | 34 | 1 | 16 | 49 | 18 | 49 | 64 | 50 | 49 | 64 | 82 |

DREIER-TEILFOLGEN-ALGORITHMEN

| | a1 | a2 | a3 | a4 | a5 | a6 | a7 | a8 | a9 | a10 | a11 | a12 | a13 |
|----|----|----|----|----|----|----|----|----|----|-----|-----|-----|-----|
| S1 | 15 | -14 | -1 | 15 | 18 | -33 | 15 | 33 | -31 | 31 | 15 | -14 | -1 |
| S2 | 33 | -31 | 31 | 15 | -14 | -1 | 15 | 18 | -33 | 15 | 33 | -31 | 31 |
| S3 | 18 | -33 | 15 | 33 | -31 | 31 | 15 | -14 | -1 | 15 | 18 | -33 | 15 |

PERIODIZITÄT (P) = 10
ANZAHL VERSCH. PERIODEN = 1

FIG. 5A

FIG. 5B

RESULTIERENDES INTERLEAVE-PROGRAMM

PROGRAMM-
SCHRITTE

**01** --> "LADE ALUS" MIT DEN INITIALWERTEN; ALU-AUSGANG-INITIALWERT;
SICHERE ALU-AUSGANG IN ALU-REG.;
"GEHE" ZUM PROGRAMMSCHRITT 2;

**02** --> "ADDIERE 15" ZUM "GESICHERTEN" ALU-WERT; ALU-AUSGANG-ERGEBNIS;
SICHERE ALU-AUSGANG IN ALU-REG.;
"GEHE" ZUM PROGRAMMSCHRITT 3;

**03** --> "SUBTRAHIERE 14" VOM "GESICHERTEN" ALU-WERT; ALU-AUSGANG-ERGEBNIS;
SICHERE ALU-AUSGANG IN ALU-REG.;
"GEHE" ZUM PROGRAMMSCHRITT 4;

**04** --> "SUBTRAHIERE 1" VOM "GESICHERTEN" ALU-WERT; ALU-AUSGANG-ERGEBNIS;
SICHERE ALU-AUSGANG IN ALU-REG.;
"GEHE" ZUM PROGRAMMSCHRITT 5;

**05** --> "ADDIERE 15" ZUM "GESICHERTEN" ALU-WERT; ALU-AUSGANG-ERGEBNIS;
SICHERE ALU-AUSGANG IN ALU-REG.;
"GEHE" ZUM PROGRAMMSCHRITT 6;

**06** --> "ADDIERE 18" ZUM "GESICHERTEN" ALU-WERT; ALU-AUSGANG-ERGEBNIS;
SICHERE ALU-AUSGANG IN ALU-REG.;
"GEHE" ZUM PROGRAMMSCHRITT 7;

**07** --> "SUBTRAHIERE 33" VOM "GESICHERTEN" ALU-WERT; ALU-AUSGANG-ERGEBNIS;
SICHERE ALU-AUSGANG IN ALU-REG.;
"GEHE" ZUM PROGRAMMSCHRITT 8;

**08** --> "ADDIERE 15" ZUM "GESICHERTEN" ALU-WERT; ALU-AUSGANG-ERGEBNIS;
SICHERE ALU-AUSGANG IN ALU-REG.;
"GEHE" ZUM PROGRAMMSCHRITT 9;

**09** --> "ADDIERE 33" ZUM "GESICHERTEN" ALU-WERT; ALU-AUSGANG-ERGEBNIS;
SICHERE ALU-AUSGANG IN ALU-REG.;
"GEHE" ZUM PROGRAMMSCHRITT 10;

**10** --> "SUBTRAHIERE 31" VOM "GESICHERTEN" ALU-WERT; ALU-AUSGANG-ERGEBNIS;
SICHERE ALU-AUSGANG IN ALU-REG.;
"GEHE" ZUM PROGRAMMSCHRITT 11;

**11** --> "ADDIERE 31" ZUM "GESICHERTEN" ALU-WERT; ALU-AUSGANG-ERGEBNIS;
SICHERE ALU-AUSGANG IN ALU-REG.;
"GEHE" ZUM PROGRAMMSCHRITT 2; FÜHRE PROGRAMM-SCHLEIFE 2 - 11
WIE VORGEGEBEN MEHRFACH AUS

## FIG. 5C

AUSGANGS-SEQUENZ:

| C1 | C2 | C3 | C4 | C5 | C6 | C7 | C8 | C9 | C10 | C11 | C12 |
|----|----|----|----|----|----|----|----|----|-----|-----|-----|
| 17 | 0 | 16 | 32 | 33 | 34 | 18 | 2 | 1 | 17 | 33 | 16 |

ALGORITHMUS

| A1 | A2 | A3 | A4 | A5 | A6 | A7 | A8 | A9 | A10 | A11 | A12 |
|----|----|----|----|----|----|----|----|----|-----|-----|-----|
| -17 | 16 | 16 | 1 | 1 | -16 | -16 | -1 | 16 | 16 | -17 | 16 | 16 |

PERIODIZITÄT (P) = 10

ZEHNER-TEILFOLGEN:

| | c1 | c2 | c3 | c4 | c5 | c6 | c7 | c8 | c9 | c10 | c11 | c12 |
|-----|----|----|----|----|----|----|----|----|----|-----|-----|-----|
| S1 | 17 | 33 | 49 | 65 | 81 | 97 | 113 | 129 | 145 | 161 | 177 | 193 |
| S2 | 0 | 16 | 32 | 48 | 64 | 80 | 96 | 112 | 128 | 144 | 160 | 176 |
| S3 | 16 | 32 | 48 | 64 | 80 | 96 | 112 | 128 | 144 | 160 | 176 | 192 |
| S4 | 32 | 48 | 64 | 80 | 96 | 112 | 128 | 144 | 160 | 176 | 192 | 208 |
| S5 | 33 | 49 | 65 | 81 | 97 | 113 | 129 | 145 | 161 | 177 | 193 | 209 |
| S6 | 34 | 50 | 66 | 82 | 98 | 114 | 130 | 146 | 162 | 178 | 194 | 210 |
| S7 | 18 | 34 | 50 | 66 | 82 | 98 | 114 | 130 | 146 | 162 | 178 | 194 |
| S8 | 2 | 18 | 34 | 50 | 66 | 82 | 98 | 114 | 130 | 146 | 162 | 178 |
| S9 | 1 | 17 | 33 | 49 | 65 | 81 | 97 | 113 | 129 | 145 | 161 | 177 |
| S10 | 17 | 33 | 49 | 65 | 81 | 97 | 113 | 129 | 145 | 161 | 177 | 193 |

ZEHNER-TEILFOLGEN-ALGORITHMEN

| | a1 | a2 | a3 | a4 | a5 | a6 | a7 | a8 | a9 | a10 | a11 | a12 |
|---|----|----|----|----|----|----|----|----|----|-----|-----|-----|
| | 16 | 16 | 16 | 16 | 16 | 16 | 16 | 16 | 16 | 16 | 16 | 16 | 16 |
| | 16 | 16 | 16 | 16 | 16 | 16 | 16 | 16 | 16 | 16 | 16 | 16 | 16 |
| | 16 | 16 | 16 | 16 | 16 | 16 | 16 | 16 | 16 | 16 | 16 | 16 | 16 |
| | 16 | 16 | 16 | 16 | 16 | 16 | 16 | 16 | 16 | 16 | 16 | 16 | 16 |
| | 16 | 16 | 16 | 16 | 16 | 16 | 16 | 16 | 16 | 16 | 16 | 16 | 16 |
| | 16 | 16 | 16 | 16 | 16 | 16 | 16 | 16 | 16 | 16 | 16 | 16 | 16 |
| | 16 | 16 | 16 | 16 | 16 | 16 | 16 | 16 | 16 | 16 | 16 | 16 | 16 |
| | 16 | 16 | 16 | 16 | 16 | 16 | 16 | 16 | 16 | 16 | 16 | 16 | 16 |
| | 16 | 16 | 16 | 16 | 16 | 16 | 16 | 16 | 16 | 16 | 16 | 16 | 16 |
| | 16 | 16 | 16 | 16 | 16 | 16 | 16 | 16 | 16 | 16 | 16 | 16 | 16 |

PERIODIZITÄT (P) = 10
ANZAHL VERSCH. PERIODEN = 1

FIG. 6A

PROGRAMM-
SCHRITTE

01 --> "LADE ALUS" MIT DEN INITIALWERTEN; ALU-AUSGANG=INITIALWERT;
SICHERE ALU-AUSGANG IN ALU-REG.;
"GEHE" ZUM PROGRAMMSCHRITT 2;

02 --> "ADDIERE 16" ZUM "GESICHERTEN" ALU-WERT; ALU-AUSGANG=ERGEBNIS;
SICHERE ALU-AUSGANG IN ALU-REG.;
"GEHE" ZUM PROGRAMMSCHRITT 1; FÜHRE PROGRAMM-SCHLEIFE 02
WIE VORGEGEBEN MEHRFACH AUS

FIG. 6C

FIG. 6B

AUSGANGS-SEQUENZ    C1;   C2;   C3;   C4;   C5;   C6;   C7;   C8;   C9

                     2;    4;   1;   3;   6;   1,5;  4,5;  9;   2,25; ..      PERIODIZITÄT (P) = 3

ALGORITHMUS          $\cdot$2;  :4;  $\cdot$3;  $\cdot$2;  :4;  $\cdot$3;  $\cdot$2;  :4;

                  A1;  A2;  A3;  A4;  A5;  A6;  A7;  A8;

$$C2 = C1 \cdot 2$$
$$C3 = C2 : 4$$
$$C4 = C3 \cdot 3$$
$$C5 = C4 \cdot 2$$
$$C6 = C5 : 4$$
$$C7 = C6 \cdot 3$$

etc.

DREIER-TEILFOLGEN           DREIER-TEILFOLGEN-ALGORITHMEN

|    | c1 | c2 | c3 | etc. |     | a1 | a2 | a3 | etc. |
|----|----|----|----|------|-----|----|----|----|------|
| S1 | 2  | 3  | 4,5 |     | | $\cdot$1,5 | $\cdot$1,5 | $\cdot$1,5 | |
| S2 | 4  | 6  | 9  |     | | $\cdot$1,5 | $\cdot$1,5 | $\cdot$1,5 | |
| S3 | 1  | 1,5 | 2,25 |  | | $\cdot$1,5 | $\cdot$1,5 | $\cdot$1,5 | |

$$c_n = c_{n-1} \cdot (2 : 4 \cdot 3) = \cdot 1,5 \qquad n = 2, 3, 4, 5, \ldots$$

FIG. 7

EP 0 591 562 A1

EP 0 591 562 A1

AUSGANGS-SEQUENZ    C1        C2        C3      C4        C5        C6

             1,000      3,313    2,978    1,091     3,386     3,466

ALGORITHMUS          A1;       A2;     A3;      A4;      A5;

$$(C1+\pi)\cdot 0,8; \quad (C2^2-8); \quad \ln(C3); \quad (C4+\pi)\cdot 0,8; \quad C5^2-8;$$

PERIODIZITÄT (P) = 3

$$C2 = (C1+\pi) \cdot 0,8$$

$$C3 = (C2^2 - 8)$$

$$C4 = \ln(C3)$$

$$C5 = (C4 + \pi) \cdot 0,8$$

$$C6 = (C5^2 - 8)$$

etc.

DREIER-TEILFOLGEN            DREIER-TEILFOLGEN-ALGORITHMEN

     c1     c2     etc.

S1   1,000;   1,091;        $c_n = \ln[\{(c_{n-1} + \pi) \cdot 0,8\}^2 - 8]$    $n = 2, 3, 4, 5, \ldots$

S2   3,313;   3,386;        $c_n = [\ln(c_{n-1}^2 - 8) + \pi] \cdot 0,8$    $n = 2, 3, 4, 5, \ldots$

S3   2,978;   3,466;        $c_n = \{(\ln c_{n-1} + \pi) \cdot 0,8\}^2 - 8$    $n = 2, 3, 4, 5, \ldots$

## FIG. 8

FIG. 9

FIG. 10

AUSGANGS-SEQUENZ

7 — 8 — 12 — 10 — 11 — 15 — 13 — 14 — 18

ALGORITHMUS

+1 — +4 — -2 — +1 — +4 — -2 — +1 — +4 — usw.

AUSGANGS-SEQUENZ

C1 C2 C3 C4 C5 C6 C7 C8 C9 ...
7  8  12 10 11 15 13 14 18

ALGORITHMUS

A1 A2 A3 A4 A5 A6 A7 ...
+1 +4 -2 +1 +4 -2 +1

$$\underbrace{\phantom{+1 +4 -2}}$$

PERIODIZITÄT (P) = 3

TEILFOLGEN

$S1 = s_{11} \quad s_{12} \quad s_{13}\cdots$
$\phantom{S1 = }7 \quad\quad 10 \quad\quad 13$

$S2 = s_{21} \quad s_{22} \quad s_{23}\cdots$
$\phantom{S2 = }8 \quad\quad 11 \quad\quad 14$

$S3 = s_{31} \quad s_{32} \quad s_{33}\cdots$
$\phantom{S3 = }12 \quad\quad 15 \quad\quad 18$

TEILFOLGEN-ALGORITHMEN

$as_{11} \quad as_{12} \quad as_{13}\cdots$
$3 \quad\quad 3 \quad\quad 3$

$as_{21} \quad as_{22} \quad as_{23}\cdots$
$3 \quad\quad 3 \quad\quad 3$

$as_{31} \quad as_{32} \quad as_{33}\cdots$
$3 \quad\quad 3 \quad\quad 3$

ZEITGEBER-SCHALTUNG — 94

ANFANGS-WERTE DER UNTERFOLGEN

PROGRAMM-SPEICHER (+3) — 93

$s_{11} = 7$

PROZESSOR 1 — 90

S1
7;10;13;...

$s_{21} = 8$

PROZESSOR 2 — 91

S2
8;11;14;...

$s_{31} = 12$

PROZESSOR 3 — 92

S3
12;15;18;...

MULTI-PLEXER — 95

AUSGANGSSEQUENZ
7;8;12;10;11;...

FIG. 11

**Europäisches Patentamt**

# EUROPÄISCHER RECHERCHENBERICHT

Nummer der Anmeldung

EP    92 11 6755

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | PROCEEDINGS OF THE INTERNATIONAL TEST CONFERENCE, 28. Oktober – 1. November 1991, Seiten 1061-1068, IEEE, New York, US; M. Kanzaki et al:'Programming for parallel pattern generators' * Seite 1061, rechte Spalte, Zeile 15 – Seite 1066, linke Spalte, Zeile 3; Abbildungen 1,2,4 * | 1,3,6,9, 10 | G06F11/26 |
| A | EP-A-0 255 118 (HITACHI LTD.) * Spalte 6, Zeile 40 – Spalte 12, Zeile 13; Abbildungen 1,6,7,12 * | 1,3,6,9 10 | |
| A | US-A-4 389 723 (A. NIGORIKAWA ET AL) * Insgesamt* | 1,3,6,9 10 | |

| RECHERCHIERTE SACHGEBIETE (Int. Cl.5) |
|---|
| G06F G11C |

Der vorliegende Recherchenbericht wurde für alle Patentansprüche erstellt

| Recherchenort | Abschlußdatum der Recherche | Prüfer |
|---|---|---|
| DEN HAAG | 27 MAI 1993 | GORZEWSKI M. |